# EUROPEAN PATENT SPECIFICATION

(11) **EP 2 359 369 B1**
(45) Date of publication and mention of the grant of the patent: **21.01.2015**
(21) Application number: 09832790.1
(22) Date of filing: 17.12.2009
(51) Int. Cl.: G11C 7/10, G11C 16/06, G11C 7/20, G11C 8/08, G11C 8/10, G11C 16/10, G11C 16/08, G11C 11/412

(54) **SEMICONDUCTOR DEVICE WITH MAIN MEMORY UNIT AND AUXILIARY MEMORY UNIT REQUIRING PRESET OPERATION**
HALBLEITERBAUELEMENT MIT HAUPTSPEICHEREINHEIT UND HILFSSPEICHEREINHEIT MIT VORKONFIGURATIONSERFORDERNIS
DISPOSITIF À SEMI-CONDUCTEUR À UNITÉ DE MÉMOIRE PRINCIPALE ET UNITÉ DE MÉMOIRE AUXILIAIRE NÉCESSITANT UNE OPÉRATION PRÉDÉFINIE

(30) Priority: 18.12.2008 US 337841; 05.08.2009 US 213990 P; 22.09.2009 US 564492
(43) Date of publication of application: 24.08.2011
(73) Proprietor: Conversant Intellectual Property Management Inc., Ottawa, ON K2K 0G7 (CA)
(72) Inventor: PYEON, Hong-Beom, Kanata Ontario K2M 2E1 (CA)
(74) Representative: Swindell & Pearson Limited
(86) International application number: PCT/CA2009/001860
(87) International publication number: WO 2010/069076

(56) References cited:
- US-A- 5 703 810
- US-A- 5 802 555
- US-A- 5 953 538
- US-B1- 7 599 975

## Description

### BACKGROUND

A flash memory device consists of memory cells and a page buffer in a core memory block, along with peripheral circuitry for exchanging data with a controller. Since the introduction of flash memory devices on the consumer market, they have gained widespread popularity and acceptance, while their original asynchronous interface to the controller has remained unchanged for the most part.

Recently, certain improvements in flash memory technology have been developed, but require an interface design that is incompatible with conventional flash memory devices. To allow conventional flash memory devices to nevertheless benefit from the improved technology, use of a bridge chip has been contemplated. A bridge chip would provide a bidirectional interface between an improved controller and conventional flash memory devices.

It will be appreciated that the design of a bridge chip poses various challenges, at least some of these being associated with the need to temporarily store data to be transferred to a conventional flash memory device.

It will also be recognized that semiconductor memory is used in a variety of applications. One of the most useful and widely employed types of semiconductor memory is SRAM, or static random access memory. As long as power can be continuously supplied to the cells of an SRAM array, this type of semiconductor memory allows fast access for both reading and writing individual memory cells.

In some applications, SRAM cells in a secondary array are used as a status indicator (e.g., cell validity) for corresponding memory cells in a primary array. For example, a given SRAM cell can be set to "1" when the corresponding memory cell in the primary array is deemed "valid"; prior to this event, the given SRAM cell will be expected to carry the value "0", thereby indicating that the corresponding primary cell is invalid. The use of a secondary SRAM array thus allows an external entity to rapidly access information about the validity of the cells in the primary array without having to access the primary array. This can be useful when the primary array is manufactured using a type of memory that may not allow individual cells to be as flexibly or as quickly accessed as in SRAM.

However, because SRAM cells acquire an unpredictable value upon power-up, an Initialization ("preset") operation is required in order to guarantee that the given SRAM cell will indeed carry the value "0" before being written to with a "1", or vice versa. Applying this initialization operation to all SRAM cells in an array can lead to a cumbersome and lengthy preset phase.

It will be appreciated that a preset phase is required in many applications involving the use of SRAM. Improvements in the area of presetting the cells of a semiconductor memory array are therefore welcome.

US 5,703,810 discloses a latch/mask mechanism that is located between the sense amplifiers of a DRAM and the data bus. The latch/mask mechanism decouples the data bus from the sense amplifiers and permits time saving functionality during read and write operations. During a write operation, the latch can receive only those byte(s) or a row of bytes to be written. Corresponding mask bits are set to indicate those bytes to be written. Logic in the device transfers only those bytes In the row to be written to the sense amplifiers for writing to memory, leaving the data of remaining bytes in memory intact Read operations are rendered more efficient by enabling logic, coupled to column select logic, to automatically transfer from the latch byte selected by the column select logic and the adjacent byte. This time saving feature is particularly useful for computer graphics applications which utilize linear Interpolation processes.

### SUMMARY

The present invention Is as set out in the independent claims.

According to a first aspect of embodiments of the invention, there is provided a semiconductor device for transferring input data to a non-volatile memory device. The semiconductor device comprises a virtual page buffer including a plurality of data elements. The semiconductor device also comprises a mask buffer Including a plurality of data elements, each of the data elements of the mask buffer corresponding to a respective one of the data elements of the virtual page buffer. The semiconductor device also comprises control logic circuitry for (i) setting each of the data elements of the mask buffer to a first logic state upon receipt of a trigger; (ii) causing input data to be written to selected ones of the data elements of the virtual page buffer; and (iii) causing those data elements of the mask buffer corresponding to the selected ones of the data elements of the virtual page buffer to be set to a second logic state different from the first logic state. The semiconductor device also comprises mask logic circuitry configured to provide masked output data by combining, for each of the data elements of the virtual page buffer, data read therefrom together with the logic state of the corresponding one of the data elements of the mask buffer. The semiconductor device also comprises an output interface configured to release the masked output data towards the non-volatile memory device.

According to a second aspect of embodiments of the invention, there is provided a method for transferring input data to a non-volatile memory device. The method comprises maintaining a virtual page buffer including a plurality of data elements; maintaining a mask buffer Including a plurality of data elements, each of the data elements of the mask buffer corresponding to a respective one of the data elements of the virtual page buffer; setting each of the data elements of the mask buffer to a first logic state upon receipt of a trigger; writing data to selected ones of the data elements of the virtual page buffer and setting those data elements of the mask buffer corresponding to the selected ones of the data elements of the virtual page buffer to a second logic state different from the first logic state; providing masked output data by combining, for each of the data elements of the virtual page buffer, data read therefrom together with the logic state of the corresponding one of the data elements of the mask buffer; and releasing the masked output data towards the non-volatile memory device.

According to a third aspect of embodiments of the invention, there is provided a computer-readable storage medium storing instructions which, when processed, are used to provide a semiconductor device configured to maintain a virtual page buffer including a plurality of data elements; maintain a mask buffer including a plurality of data elements, each of the data elements of the mask buffer corresponding to a respective one of the data elements of the virtual page buffer; set each of the data elements of the mask buffer to a first logic state upon receipt of a trigger; write data to selected ones of the data elements of the virtual page buffer and setting those data elements of the mask buffer corresponding to the selected ones of the data elements of the virtual page buffer to a second logic state different from the first logic state; provide masked output data by combining, for each of the data elements of the virtual page buffer, data read therefrom together with the logic state of the corresponding one of the data elements of the mask buffer; and release the masked output data towards the non-volatile memory device.

According to an aspect of the disclosure, there is provided a memory system which comprises a semiconductor device defined In at least one non-volatile memory device. The semiconductor device comprises a virtual page buffer including a plurality of data elements. The semiconductor device also comprises a mask buffer including a plurality of data elements, each of the data elements of the mask buffer corresponding to a respective one of the data elements of the virtual page buffer. The semiconductor device also comprises control logic circuitry for (i) setting each of the data elements of the mask buffer to a first logic state upon receipt of a trigger; (ii) causing input data to be written to selected ones of the data elements of the virtual page buffer; and (iii) causing those data elements of the mask buffer corresponding to the selected ones of the data elements of the virtual page buffer to be set to a second logic state different from the first logic state. The semiconductor device also comprises mask logic circuitry configured to provide masked output data by combining, for each of the data elements of the virtual page buffer, data read therefrom together with the logic state of the corresponding one of the data elements of the mask buffer. The semiconductor device also comprises an output interface configured to release the masked output data towards the at least one non-volatile memory device.

According to a further aspect of the disclosure, there is provided a semiconductor memory circuit, comprising: a memory array, the memory array including a plurality of wordlines each connected to a respective row of cells and a plurality of bitlines each connected to a respective column of cells. The semiconductor memory circuit also comprises at least one row decoder for selecting a group of wordlines within the plurality of wordlines; and a plurality of driver circuits for driving the plurality of bitlines respectively and setting the cells connected to the group of wordlines to a predetermined logic state.

According to a yet further aspect of the disclosure, there is provided a method for presetting at least part of a memory array, the memory array comprising a plurality of wordlines each connected to a respective row of cells. The method comprises selecting a group of wordlines within the plurality of wordlines; and simultaneously setting memory cells connected to the group of wordlines to a predetermined logic state.

According to a yet further aspect of the disclosure, there is provided a circuit for use with a memory array that comprises a plurality of wordlines each connected to a respective row of cells within a plurality of rows of cells. The circuit comprises a first input for receiving a row signal indicative of selection of a single one of the rows, hereinafter an individually selected row; a second input for receiving a preset control signal indicative of selection of a group of rows, hereinafter jointly selected rows; circuitry for combining the row signal and the preset control signal to produce, for each of the rows, a respective wordline selection signal, the wordline selection signal for each of the rows being indicative of selection of that row when it is at least one of (i) the individually selected row and (ii) one of the jointly selected rows, and being indicative of non-selection of that row when It Is both not the individually selected row and not one of the jointly selected rows; and an output for releasing the wordline selection signal for each of the rows to the memory array via a wordline driver.

According to a yet further aspect of the disclosure, there is provided a semiconductor device, comprising: a main memory unit Including a plurality of main cells; an auxiliary memory unit including a plurality of auxiliary cells arranged into rows and columns, each of the auxiliary cells corresponding to a respective set of the main cells; a plurality of wordlines each connected to a respective row of the auxiliary cells; a plurality of bitlines each connected to a respective column of the auxiliary cells; row decoder circuitry for selecting, in a first mode of operation, an individual wordline among the plurality of wordlines and, in a second mode of operation, a group of wordlines within the plurality of wordiines; bitline control circuitry for driving the bitlines to enable writing of auxiliary cells connected to a wordline that has been selected; control logic circuitry for (i) controlling the bitline control circuitry while the row decoder circuitry operates in the second mode of operation so as to set each of the auxiliary cells to a first logic state; (ii) causing input data to be written to selected ones of the main cells; and (iii) controlling the bitline control circuitry while the row decoder circuitry operates In the first mode of operation so as to set those auxiliary cells corresponding to the selected ones of the main cells to a second logic state different from the first logic state.

According to a yet further aspect of the disclosure, there Is provided a method for execution by a semiconductor device, comprising: selecting a group of rows of auxiliary cells forming part of an auxiliary memory unit, the auxiliary cells being arranged into rows and columns; driving a plurality of bitlines each connected to a respective column of the auxiliary cells, so as to set each of the auxiliary cells to a first logic state; writing input data to selected ones of a plurality of main cells, wherein each of the auxiliary cells corresponds to a respective set of the main cells; selecting a particular row of auxiliary cells that includes at least one auxiliary cell whose corresponding set of main cells includes at least one of the selected cells; driving the bitlines so as to set the at least one auxiliary cell to a second logic state different from the first logic state.

According to a yet further aspect of the disclosure, there is provided a computer-readable storage medium storing instructions which, when processed by a computer, are used to generate control logic circuitry configured to: select a group of rows of auxiliary cells forming part of an auxiliary memory unit, the auxiliary cells being arranged into rows and columns; drive a plurality of bitlines each connected to a respective column of the auxiliary cells, so as to set each of the auxiliary cells to a first logic state; cause input data to be written to selected ones of a plurality of main cells, wherein each of the auxiliary cells corresponds to a respective set of the main cells; select a particular row of auxiliary cells that includes at least one auxiliary cell whose corresponding set of main cells includes at least one of the selected cells; drive the bitlines so as to set the at least one auxiliary cell to a second logic state different from the first logic state.

According to a yet further aspect of the disclosure, there is provided a semiconductor device, comprising: a main memory unit including a plurality of main cells; an auxiliary memory unit including a plurality of sub-units, each sub-unit comprising a plurality of auxiliary cells arranged into rows and columns, each of the auxiliary cells corresponding to a respective set of the main cells; a plurality of wordlines each connected to a respective row of the auxiliary cells; a plurality of bitlines each connected to a respective column of the auxiliary cells and spanning the plurality of sub-units; row decoder circuitry for selecting, in a first mode of operation, an individual wordline among the plurality of wordlines of a particular one of the sub-units and, in a second mode of operation, a group of wordlines including at least one wordline from each of at least two of the sub-units; bitline control circuitry for driving the bitlines to enable writing of auxiliary cells connected to a wordline that has been selected; control logic circuitry for (i) controlling the bitline control circuitry while the row decoder circuitry operates in the second mode of operation so as to set each of the auxiliary cells in each of the sub-units to a first logic state; (ii) causing input data to be written to selected ones of the main cells; and (iii) controlling the bitline control circuitry while the row decoder circuitry operates in the first mode of operation so as to set those auxiliary cells corresponding to the selected ones of the main cells to a second logic state different from the first logic state.

According to a yet further aspect of the disclosure, there is provided a method for execution by a semiconductor device, comprising: selecting a group of rows of auxiliary cells including at least one row from each of at least two sub-units, the auxiliary cells in each of the sub-units being arranged into rows and columns; driving a plurality of bitlines each connected to a respective column of the auxiliary cells and spanning the plurality of sub-units, so as to set each of the auxiliary cells to a first logic state; writing input data to selected ones of a plurality of main cells, wherein each of the auxiliary cells corresponds to a respective set of the main cells; selecting a particular row of a particular one of the sub-units, the particular row Including at least one auxiliary cell whose corresponding set of main cells includes at least one of the selected cells; driving the bitlines so as to set the at least one auxiliary cell to a second logic state different from the first logic state.

According to a yet further aspect of the disclosure, there is provided a computer-readable storage medium storing instructions which, when processed by a computer, are used to generate control logic circuitry configured to: select a group of rows of auxiliary cells including at least one row from each of at least two sub-units, the auxiliary cells In each of the sub-units being arranged into rows and columns; drive a plurality of bitlines each connected to a respective column of the auxiliary cells and spanning the plurality of sub-units, so as to set each of the auxiliary cells to a first logic state; cause input data to be written to selected ones of a plurality of main cells, wherein each of the auxiliary cells corresponds to a respective set of the main cells; select a particular row of a particular one of the sub-units, the particular row including at least one auxiliary cell whose corresponding set of main cells Includes at least one of the selected cells; drive the bitlines so as to set the at least one auxiliary cell to a second logic state different from the first logic state.

According to a yet further aspect of the disclosure, there is provided a semiconductor device, comprising: a main memory unit including a plurality of main cells arranged into an array of N1 rows and M1 columns; an auxiliary memory unit including a plurality of auxiliary cells arranged Into N2 rows and M2 columns, each of the auxiliary cells corresponding to a respective set of Z main cells, N2 being less than N1 and M2 being greater than M1/Z; a plurality of wordlines each connected to a respective row of the auxiliary cells; a plurality of bitlines each connected to a respective column of the auxiliary cells; row decoder circuitry for selecting an individual wordline among the plurality of wordlines; bitline control circuitry for driving the plurality of bitlines to enable writing of auxiliary cells connected to the selected wordline; control logic circuitry for (i) controlling the bitline control circuitry so as to set each of the auxiliary cells to a first logic state; (ii) causing input data to be written to selected ones of the main cells; and (iii) controlling the bitline control circuitry so as to set those auxiliary cells corresponding to the selected ones of the main cells to a second logic state different from the first logic state.

According to a yet further aspect of the disclosure, there is provided a method for execution by a semiconductor device, comprising: writing input data to selected ones of a plurality of main cells forming part of a main memory unit, the main cells of the main memory unit being arranged into N1 rows and M1 columns; prior to said writing, driving a plurality of bitlines each connected to a respective column of auxiliary cells forming part of an auxiliary memory unit, so as to set each of the auxiliary cells to a first logic state, each of the auxiliary cells corresponding to a respective set of Z main cells, the auxiliary cells of the auxiliary memory unit being arranged into N2 rows and M2 columns, N2 being less than N1 and M2 being greater than M1/Z; selecting a particular row of auxiliary cells that includes at least one auxiliary cell whose corresponding set of main cells includes at least one of the selected cells; driving the bitlines so as to set the at least one auxiliary cell to a second logic state different from the first logic state.

According to a yet further aspect of the disclosure, there is provided a computer-readable storage medium storing instructions which, when processed by a computer, are used to generate control logic circuitry configured to: cause input data to be written to selected ones of a plurality of main cells forming part of a main memory unit, the main cells of the main memory unit being arranged into N1 rows and M1 columns; prior to the input data being written to the selected ones of the plurality of main cells, drive a plurality of bitlines each connected to a respective column of auxiliary cells forming part of an auxiliary memory unit, so as to set each of the auxiliary cells to a first logic state, each of the auxiliary cells corresponding to a respective set of Z main cells, the auxiliary cells of the auxiliary memory unit being arranged into N2 rows and M2 columns, N2 being less than N1 and M2 being greater than M1/Z; select a particular row of auxiliary cells that includes at least one auxiliary cell whose corresponding set of main cells includes at least one of the selected cells; drive the bitlines so as to set the at least one auxiliary cell to a second logic state different from the first logic state.

According to a yet further aspect of the disclosure, there is provided a semiconductor device, comprising: a plurality of single-ported memory cells; a plurality of dual-ported memory cells arranged into rows and columns, each of the dual-ported memory cells corresponding to a respective set of single-ported memory cells; first wordlines and second wordlines connected to the rows of the dual-ported memory cells such that each row of the dual-ported memory cells is connected to a corresponding one of the first wordlines and a corresponding one of the second wordlines; first biltines and second biltines connected to the columns of the dual-ported memory cells such that each column of the dual-ported memory cells is connected to a corresponding set of the first bitlines and a corresponding set of the second bitlines; row decoder circuitry for jointly selecting at least one of the first wordlines and at least one of the second wordlines; bitline control circuitry for driving the first bitlines to enable writing of dual-ported memory cells connected to a first wordline that has been selected and for driving the second bitlines to enable writing of dual-ported memory cells connected to a second wordline that has been selected; control logic circuitry for (i) controlling the bitline control circuitry so as to set each of the dual-ported memory cells to a first logic state; (ii) causing input data to be written to selected ones of the single-ported memory cells and (iii) controlling the bitline control circuitry so as to set those dual-ported memory cells corresponding to the selected ones of the single-ported memory cells to a second logic state different from the first logic state.

According to a yet further aspect of the disclosure, there is provided a method for execution by a semiconductor device, comprising: setting each of a plurality of dual-ported memory cells to a first logic state; writing Input data to selected ones of a plurality of single-ported memory cells, wherein each of the dual-ported memory cells corresponds to a respective set of single-ported memory cells; setting those dual-ported memory cells corresponding to the selected ones of the single-ported memory cells to a second logic state different from the first logic state.

According to a yet further aspect of the disclosure, there is provided a computer-readable storage medium storing instructions which, when processed by a computer, are used to generate control logic circuitry configured to: set each of a plurality of dual-ported memory cells to a first logic state; cause input data to be written to selected ones of a plurality of single-ported memory cells, wherein each of the dual-ported memory cells corresponds to a respective set of single-ported memory cells; set those dual-ported memory cells corresponding to the selected ones of the single-ported memory cells to a second logic state different from the first logic state.

Additional aspects of the disclosure are defined by the following clauses:
Clause 1: A semiconductor device for transferring input data to a non-volatile memory device, the semiconductor device comprising:
   - a virtual page buffer including a plurality of data elements;
   - a mask buffer including a plurality of data elements, each of the data elements of the mask buffer corresponding to a respective one of the data elements of the virtual page buffer;
   - control logic circuitry for (i) setting each of the data elements of the mask buffer to a first logic state upon receipt of a trigger; (ii) causing Input data to be written to selected ones of the data elements of the virtual page buffer; and (iii) causing those data elements of the mask buffer corresponding to the selected ones of the data elements of the virtual page buffer to be set to a second logic state different from the first logic state;
   - mask logic circuitry configured to provide masked output data by combining, for each of the data elements of the virtual page buffer, data read therefrom together with the logic state of the corresponding one of the data elements of the mask buffer; and
   - an output Interface configured to release the masked output data towards the non-volatile memory device.
Clause 2: The semiconductor device defined in clause 1, further comprising power monitoring circuitry configured to issue a signal when power is established or re-established to the semiconductor device, said signal resulting in said trigger.
Clause 3: The semiconductor device defined in clause 1, wherein the output interface is further configured to release the masked output data as part of a PAGE PROGRAM command released towards the non-volatile memory device.
Clause 4: The semiconductor device defined in clause 3, wherein release of the PAGE PROGRAM command towards the non-volatile memory device comprises issuance of an initial command cycle, at least one address cycle, at least one data cycle and a confirmatory command cycle.
Clause 5: The semiconductor device defined in clause 4, wherein the output interface is further configured to issue a signal upon issuance of the confirmatory command cycle, said signal resulting in said trigger.
Clause 6: The semiconductor device defined in clause 1, wherein a particular data element of the virtual page buffer is addressable by a particular address, wherein the control logic circuitry is capable of supplying an address signal encoding said particular address and a read signal, and wherein the virtual page buffer is responsive to receipt of the address signal and the read signal to cause contents of the particular data element of the virtual page buffer to be read and provided to the mask logic circuitry.
Clause 7: The semiconductor device defined in clause 6, wherein the mask buffer is responsive to receipt of the address signal and the read signal to cause the logic state of the data element of the mask buffer corresponding to the particular data element of the virtual page buffer to be read and provided to the mask logic circuitry.
Clause 8: The semiconductor device defined in clause 6, further comprising a selector, wherein the mask buffer is responsive to receipt of the read signal and a portion of the address signal to cause a particular data element of the mask buffer to be read and provided to an input of the selector.
Clause 9: The semiconductor device defined in clause 8, wherein the selector has an output and is configured to admit towards its output a portion of the signal at its input, the portion being specified by a remainder of the address signal such that the signal at the output of the selector is indicative of the logic state of the data element of the mask buffer corresponding to the particular data element of the virtual page buffer.
Clause 10: The semiconductor device defined in clause 1, wherein the selected ones of the data elements of the virtual page buffer are addressable by particular addresses, wherein the control logic circuitry is capable of supplying an address signal encoding said particular addresses and a write signal, wherein the virtual page buffer is responsive to receipt of the address signal and the write signal to cause the input data to be written to the selected ones of the data elements of the virtual page buffer.
Clause 11: The semiconductor device defined in clause 10, wherein the mask buffer is responsive to receipt of the address signal and the write signal to cause the logic state of the data elements of the mask buffer corresponding to the particular data elements of the virtual page buffer to be set to the second logic state.
Clause 12: The semiconductor device defined in clause 1, wherein individual ones of the selected ones of the data elements of the virtual page buffer are identifiable by respective addresses carried by a set of address lines.
Clause 13: The semiconductor device defined in clause 12, wherein the data elements of the virtual page buffer are arranged into a set of planes and the data elements of the mask buffer are arranged into a corresponding set of planes, wherein when the address lines identify a particular one of the selected ones of the data elements of the virtual page buffer, at least one of the address lines identifies the plane to which belongs the particular one of the selected ones of the data elements of the virtual page buffer.
Clause 14: The semiconductor device defined in clause 1, wherein the virtual page buffer and the mask buffer occupy respective portions of a common integrated memory structure.
Clause 15: The semiconductor device defined in clause 14, wherein the common integrated memory structure comprises static random access memory (SRAM) created using an SRAM compiler.
Clause 16: The semiconductor device defined in clause 1, wherein the input data is received from a memory controller.
Clause 17: The semiconductor device defined in clause 1, wherein the data elements of the virtual page buffer each include a first number of bits and wherein the data elements of the mask buffer each include a second number of bits, wherein the first number of bits is the same as the second number of bits.
Clause 18: The semiconductor device defined in clause 1, wherein the data elements of the virtual page buffer each include a first number of bits and wherein the data elements of the mask buffer each include a second number of bits, wherein the first number of bits is different from the second number of bits.
Clause 19: The semiconductor device defined in clause 18, wherein the first number of bits is greater than the second number of bits.
Clause 20: The semiconductor device defined in clause 1, wherein data read from each of the data elements of the virtual page buffer is represented by a plurality of bits, wherein the mask logic circuitry comprises a combiner for carrying out the combining, wherein the combiner includes a bank of two-input logic OR modules, each of the two-input logic OR modules being supplied with (i) the logic state of the corresponding one of the data elements of the mask buffer and (ii) a respective one of said bits.
Clause 21: A memory system, comprising:
   - a semiconductor device; and
   - at least one non-volatile memory device;
   - wherein the semiconductor device comprises:
   - a virtual page buffer including a plurality of data elements;
   - a mask buffer including a plurality of data elements, each of the data elements of the mask buffer corresponding to a respective one of the data elements of the virtual page buffer;
   - control logic circuitry for (i) setting each of the data elements of the mask buffer to a first logic state upon receipt of a trigger; (ii) causing input data to be written to selected ones of the data elements of the virtual page buffer; and (iii) causing those data elements of the mask buffer corresponding to the selected ones of the data elements of the virtual page buffer to be set to a second logic state different from the first logic state;
   - mask logic circuitry configured to provide masked output data by combining, for each of the data elements of the virtual page buffer, data read therefrom together with the logic state of the corresponding one of the data elements of the mask buffer; and
   - an output interface configured to release the masked output data towards the at least one non-volatile memory device.
Clause 22: The memory system defined in clause 21, wherein the non-volatile memory device comprises:
   - a page buffer, the page buffer including a plurality of data elements, each of the data elements of the page buffer corresponding to a respective one of the data elements of the virtual page buffer;
   - control logic circuitry for causing the masked output data received from the semiconductor device to be written sequentially to the data elements of the page buffer.
Clause 23: The memory system defined in clause 22, wherein the non-volatile memory device further comprises a memory core arranged into pages of data elements.
Clause 24: The memory system defined in clause 21, wherein the input data is received from a memory controller and is accompanied by address information specifying a group of data elements within the designated page of the memory core, wherein the group of data elements leaves at least one intra-group gap of data elements not to be written to.
Clause 25: The memory system defined in clause 21, wherein the first logic state is a program inhibit state.
Clause 26: The memory system defined in clause 21, wherein the first logic state is a logic 1 state and wherein the second logic state is a logic 0 state.
Clause 27: A method for transferring input data to a non-volatile memory device, comprising:
   - maintaining a virtual page buffer including a plurality of data elements;
   - maintaining a mask buffer including a plurality of data elements, each of the data elements of the mask buffer corresponding to a respective one of the data elements of the virtual page buffer;
   - setting each of the data elements of the mask buffer to a first logic state upon receipt of a trigger;
   - writing data to selected ones of the data elements of the virtual page buffer and setting those data elements of the mask buffer corresponding to the selected ones of the data elements of the virtual page buffer to a second logic state different from the first logic state;
   - providing masked output data by combining, for each of the data elements of the virtual page buffer, data read therefrom together with the logic state of the corresponding one of the data elements of the mask buffer; and
   - releasing the masked output data towards the non-volatile memory device.
Clause 28: The method defined in clause 27, said method is implemented by a semiconductor device, the method further comprising providing the trigger when power is established or re-established to the semiconductor device.
Clause 29: The method defined in clause 27, wherein said providing the trigger is performed in response to said releasing the masked output data towards the non-volatile memory device.
Clause 30: The method defined in clause 27, wherein the data elements of the virtual page buffer each include a first number of bits and wherein the data elements of the mask buffer each include a second number of bits, wherein the first number of bits is the same as the second number of bits.
Clause 31: The method defined in clause 27, wherein the data elements of the virtual page buffer each include a first number of bits and wherein the data elements of the mask buffer each include a second number of bits, wherein the first number of bits is different from the second number of bits.
Clause 32: The method defined in clause 31, wherein the first number of bits is greater than the second number of bits.
Clause 33: A computer-readable storage medium storing instructions which, when processed, are used to provide a semiconductor device configured to:
   - maintain a virtual page buffer including a plurality of data elements;
   - maintain a mask buffer including a plurality of data elements, each of the data elements of the mask buffer corresponding to a respective one of the data elements of the virtual page buffer;
   - set each of the data elements of the mask buffer to a first logic state upon receipt of a trigger;
   - write data to selected ones of the data elements of the virtual page buffer and setting those data elements of the mask buffer corresponding to the selected ones of the data elements of the virtual page buffer to a second logic state different from the first logic state;
   - provide masked output data by combining, for each of the data elements of the virtual page buffer, data read therefrom together with the logic state of the corresponding one of the data elements of the mask buffer; and
   - release the masked output data towards the non-volatile memory device.
Clause 34: A semiconductor memory circuit, comprising:
   - a memory array including:
   - a plurality of wordlines each connected to a respective row of cells; and
   - a plurality of bitlines each connected to a respective column of cells;
   - at least one row decoder for selecting a group of wordlines within the plurality of wordlines;
   - a plurality of driver circuits for driving the plurality of bitlines respectively and setting the cells connected to the group of wordlines to a predetermined logic state.
Clause 35: The semiconductor memory circuit defined in clause 34, wherein selecting the group of wordlines occurs when a preset control signal is asserted.
Clause 36: The semiconductor memory circuit defined in clause 35, wherein when the preset control signal is not asserted, the at least one row decoder is configured to select an individual one of the wordlines identified by a row signal.
Clause 37: The semiconductor memory circuit defined in clause 36, further comprising a controller configured for providing the row signal as part of an address signal.
Clause 38: The semiconductor memory circuit defined in clause 35, further comprising a controller configured for asserting the preset control signal.
Clause 39: The semiconductor memory circuit defined in clause 38, wherein the controller is further configured for activating the driver circuits after asserting the preset control signal.
Clause 40: The semiconductor memory circuit defined in claim 39, wherein the driver circuits are activated simultaneously.
Clause 41: The semiconductor memory circuit defined in clause 39, wherein the driver circuits are activated sequentially.
Clause 42: The semiconductor memory circuit defined in clause 34, wherein the group of wordlines is a first group of wordlines and wherein the at least one row decoder is further configured for selecting a second group of wordlines within the plurality of wordlines.
Clause 43: The semiconductor memory circuit defined in clause 42, wherein the first and second groups of wordlines are mutually exclusive.
Clause 44: The semiconductor memory circuit defined in clause 42, wherein selecting the first group of wordlines occurs when a first preset control signal is asserted and wherein selecting the second group of wordlines occurs when a second preset control signal is asserted.
Clause 45: The semiconductor memory circuit defined in clause 44, wherein the at least one row decoder comprises a single row decoder, wherein when the first preset control signal and the second preset control signal are both not asserted, the single row decoder is configured to select an individual one of the wordlines identified by a row signal.
Clause 46: The semiconductor memory circuit defined in clause 44, wherein the at least one row decoder comprises a first row decoder and a second row decoder, wherein when the first preset control signal and the second preset control signal are both not asserted, the first row decoder is configured to select an individual one of the wordlines in the first group of wordlines identified by a first row signal and the second row decoder is configured to select an individual one of the wordlines in the second group of wordlines identified by a second row signal.
Clause 47: The semiconductor memory circuit defined in clause 44, further comprising a controller configured for asserting the first preset control signal and the second control signal.
Clause 48: The semiconductor memory circuit defined in clause 47, wherein the controller is further configured for asserting the first preset control signal and the second control signal simultaneously.
Clause 49: The semiconductor memory circuit defined in clause 47, wherein the controller is further configured for asserting the first preset control signal and the second control signal sequentially.
Clause 50: The semiconductor memory circuit defined in clause 42, wherein the at least one row decoder comprises circuitry for controlling selection of the first group of wordlines and selection of the second group of wordlines in response to assertion of a preset control signal.
Clause 51: The semiconductor memory circuit defined in clause 50, wherein when the preset control signal is not asserted, the at least one row decoder is configured to select an individual one of the wordlines identified by a row signal.
Clause 52: The semiconductor memory circuit defined in clause 34, further comprising a plurality of wordline driver circuits, each for driving a respective one of the wordlines when selected.
Clause 53: The semiconductor memory circuit defined in clause 34, wherein the wordlines in the group of wordlines are contiguous.
Clause 54: The semiconductor memory circuit defined in clause 34, wherein the group of wordlines includes all of the rows of the memory array.
Clause 55: The semiconductor memory circuit defined in clause 34, wherein the group of wordlines includes fewer than all of the rows of the memory array.
Clause 56: A method for presetting at least part of a memory array, the memory array comprising a plurality of wordlines each connected to a respective row of cells, the method comprising:
   - selecting a group of wordlines within the plurality of wordlines;
   - simultaneously setting memory cells connected to the group of wordlines to a predetermined logic state.
Clause 57: The method defined in clause 56, wherein said simultaneously setting memory cells connected to the group of wordlines to a predetermined logic state comprises simultaneously setting all the memory cells connected to the group of wordlines to the predetermined logic state.
Clause 58: The method defined in clause 56, wherein said simultaneously setting memory cells connected to the group of wordlines to a predetermined logic state comprises simultaneously setting at least one first memory cell connected to each wordline within said group of wordlines to the predetermined logic state followed by simultaneously setting at least one second memory cell connected to each wordline within said group of wordlines to the predetermined logic state.
Clause 59: The method defined in clause 56, wherein the group of wordlines comprises a first group of wordlines, the method further comprising:
   - selecting a second group of wordlines within the plurality of wordlines;
   - simultaneously setting memory cells connected to the second group of wordlines to a predetermined logic state.
Clause 60: A circuit for use with a memory array that comprises a plurality of wordlines each connected to a respective row of cells within a plurality of rows of cells, the circuit comprising:
   - a first input for receiving a row signal indicative of selection of a single one of the rows, hereinafter an individually selected row;
   - a second input for receiving a preset control signal indicative of selection of a group of rows, hereinafter jointly selected rows;
   - circuitry for combining the row signal and the preset control signal to produce, for each of the rows, a respective wordline selection signal, the wordline selection signal for each of the rows being indicative of selection of that row when it is at least one of (i) the individually selected row and (ii) one of the jointly selected rows, and being indicative of non-selection of that row when it is both not the individually selected row and not one of the jointly selected rows;
   - an output for releasing the wordline selection signal for each of the rows to the memory array via a wordline driver.
Clause 61: A semiconductor device, comprising:
   - a main memory unit including a plurality of main cells;
   - an auxiliary memory unit including a plurality of auxiliary cells arranged into rows and columns, each of the auxiliary cells corresponding to a respective set of the main cells;
   - a plurality of wordlines each connected to a respective row of the auxiliary cells;
   - a plurality of bitlines each connected to a respective column of the auxiliary cells;
   - row decoder circuitry for selecting, in a first mode of operation, an individual wordline among the plurality of wordlines and, in a second mode of operation, a group of wordlines within the plurality of wordlines;
   - bitline control circuitry for driving the bitlines to enable writing of auxiliary cells connected to a wordline that has been selected;
   - control logic circuitry for (i) controlling the bitline control circuitry while the row decoder circuitry operates in the second mode of operation so as to set each of the auxiliary cells to a first logic state; (ii) causing input data to be written to selected ones of the main cells; and (iii) controlling the bitline control circuitry while the row decoder circuitry operates in the first mode of operation so as to set those auxiliary cells corresponding to the selected ones of the main cells to a second logic state different from the first logic state.
Clause 62: The semiconductor device defined in clause 61, wherein the main cells and the auxiliary cells are static random access memory (SRAM) cells.
Clause 63: The semiconductor device defined in clause 62, wherein the SRAM cells are single-port SRAM cells.
Clause 64: The semiconductor device defined in clause 61, wherein the plurality of bitlines comprises, for each column of the auxiliary cells, a respective pair of bitlines connected thereto.
Clause 65: The semiconductor device defined in clause 61, wherein the first logic state is a logic state indicative of data in the main memory unit having a first status.
Clause 66: The semiconductor device defined in clause 65, wherein the second logic state is a logic state indicative of data in the main memory unit having a second status.
Clause 67: The semiconductor device defined in clause 66, wherein the first logic state is logic zero and the second logic state is logic one.
Clause 68: The semiconductor device defined in clause 61, wherein the control logic circuitry is configured to place the row decoder circuitry in the second mode of operation upon receipt of a command from an external entity.
Clause 69: The semiconductor device defined in clause 68, wherein the external entity comprises an off-chip controller and wherein the command comprises a preset command.
Clause 70: The semiconductor device defined in clause 68, wherein to place the row decoder circuitry in the second mode of operation, the control logic circuitry is configured to command the row decoder circuitry to select the group of wordlines.
Clause 71: The semiconductor device defined in clause 70, wherein the group of wordlines includes all of the wordlines.
Clause 72: The semiconductor device defined in clause 71, wherein the group of wordlines is selectable from among a plurality of wordline combinations, each wordline combination including less than all of the wordlines.
Clause 73: The semiconductor device defined in clause 61, wherein the control logic circuitry is configured to cause the input data to be written to the selected ones of the main cells upon receipt of a command from an external entity.
Clause 74: The semiconductor device defined in clause 73, wherein the external entity comprises an off-chip controller and wherein the command comprises a write command identifying a start address from which the selected ones of the main cells can be determined.
Clause 75: The semiconductor device defined in clause 73, wherein the control logic circuitry is configured to place the row decoder circuitry in the first mode of operation upon completion of writing of the input data.
Clause 76: The semiconductor device defined in clause 75, wherein to place the row decoder circuitry in the first mode of operation, the control logic circuitry is configured to command the row decoder circuitry to select an individual wordline whose connected-to row contains at least one main cell that was written to.
Clause 77: The semiconductor device defined in clause 61, wherein controlling the bitline control circuitry while the row decoder circuitry operates in the second mode of operation comprises (i) selecting a column of the auxiliary cells; (ii) setting to the first logic state each auxiliary cell in the selected column and that is connected to a wordline that has been selected; and (iii) repeating the selecting and the setting for each of the other columns of the auxiliary cells.
Clause 78: The semiconductor device defined in clause 61, wherein controlling the bitline control circuitry while the row decoder circuitry operates in the second mode of operation comprises (i) selecting a plurality of the columns of the auxiliary cells; (ii) simultaneously setting to the first logic state those auxiliary cells in the selected columns that are connected to a wordline that has been selected; and (iii) repeating the selecting and the simultaneously setting for multiple other pluralities of the columns of the auxiliary cells.
Clause 79: The semiconductor device defined in clause 61, wherein controlling the bitline control circuitry while the row decoder circuitry operates in the second mode of operation comprises simultaneously setting to the first logic state all auxiliary cells connected to a wordline that has been selected.
Clause 80: The semiconductor device defined in clause 61, wherein each of the auxiliary cells corresponds to a respective set of exactly one of the main cells.
Clause 81: The semiconductor device defined in clause 61, wherein each of the auxiliary cells corresponds to a respective set of at least two of the main cells.
Clause 82: The semiconductor device defined in clause 61, wherein the bitlines are first bitlines, wherein each of the wordlines connected to a given row of the auxiliary cells is also connected to a respective row of the main cells that includes the set or sets of main cells corresponding to the auxiliary cells in the given row of the auxiliary cells, wherein the main cells are arranged into rows and columns, and wherein the semiconductor device further includes:
   - a plurality of second bitlines each connected to a respective column of the main cells;
   - wherein the bitline control circuitry is further for driving the second bitlines to enable writing of auxiliary cells connected to a wordline that has been selected;
   - wherein the control logic circuitry causes the input data to be written to the selected ones of the main cells by controlling the bitline control circuitry while the row decoder circuitry is the first mode of operation.
Clause 83: The semiconductor device defined in clause 82, wherein the control logic circuitry is configured to place the row decoder circuitry in the first mode of operation upon receipt of a command from an external entity.
Clause 84: The semiconductor device defined in clause 83, wherein the external entity comprises an off-chip controller and wherein the command comprises a write command identifying a start address from which the selected ones of the main cells can be determined.
Clause 85: The semiconductor device defined in clause 83, wherein to place the row decoder circuitry in the first mode of operation, the control logic circuitry is configured to command the row decoder circuitry to select an individual wordline whose connected-to row contains at least one main cell to be written to.
Clause 86: The semiconductor device defined in clause 84, wherein to place the row decoder circuitry in the first mode of operation, the control logic circuitry is configured to command the row decoder circuitry to select an individual wordline whose connected-to row includes the start address.
Clause 87: The semiconductor device defined in clause 61, wherein the wordlines are first wordlines, wherein the bitlines are first bitlines, wherein the bitline control circuitry is first bitline control circuitry, wherein the row decoder circuitry is first row decoder circuitry, wherein the main cells are arranged into rows and columns, and wherein the semiconductor device further comprises:
   - a plurality of second wordlines each connected to a respective row of the main cells, the second wordlines being different from the first wordlines;
   - second row decoder circuitry for selecting an individual second wordline among the plurality of second wordlines;
   - a plurality of second bitlines each connected to a respective column of the main cells;
   - second bitline control circuitry for driving the second bitlines to enable writing of main cells connected to a second wordline that has been selected;
   - wherein the control logic circuitry causes the input data to be written to the selected ones of the main cells by controlling the second bitline control circuitry and the second row decoder circuitry.
Clause 88: The semiconductor device defined in clause 87, wherein the control logic circuitry is configured to command the second row decoder circuitry to select an individual second wordline whose connected-to row contains at least one main cell to be written to.
Clause 89: The semiconductor device defined in clause 88, wherein the control logic circuitry is configured to command the second row decoder upon receipt of a command from an external entity.
Clause 90: The semiconductor device defined in clause 89, wherein the external entity comprises an off-chip controller and wherein the command comprises a write command identifying a start address from which the selected ones of the main cells can be determined.
Clause 91: A method for execution by a semiconductor device, comprising:
   - selecting a group of rows of auxiliary cells forming part of an auxiliary memory unit, the auxiliary cells being arranged into rows and columns;
   - driving a plurality of bitlines each connected to a respective column of the auxiliary cells, so as to set each of the auxiliary cells to a first logic state;
   - writing input data to selected ones of a plurality of main cells, wherein each of the auxiliary cells corresponds to a respective set of the main cells;
   - selecting a particular row of auxiliary cells that includes at least one auxiliary cell whose corresponding set of main cells includes at least one of the selected cells;
   - driving the bitlines so as to set the at least one auxiliary cell to a second logic state different from the first logic state.
Clause 92: A computer-readable storage medium storing instructions which, when processed by a computer, are used to generate control logic circuitry configured to:
   - select a group of rows of auxiliary cells forming part of an auxiliary memory unit, the auxiliary cells being arranged into rows and columns;
   - drive a plurality of bitlines each connected to a respective column of the auxiliary cells, so as to set each of the auxiliary cells to a first logic state;
   - cause input data to be written to selected ones of a plurality of main cells, wherein each of the auxiliary cells corresponds to a respective set of the main cells;
   - select a particular row of auxiliary cells that includes at least one auxiliary cell whose corresponding set of main cells includes at least one of the selected cells;
   - drive the bitlines so as to set the at least one auxiliary cell to a second logic state different from the first logic state.
Clause 93: A semiconductor device, comprising:
   - a main memory unit including a plurality of main cells;
   - an auxiliary memory unit including a plurality of sub-units, each sub-unit comprising a plurality of auxiliary cells arranged into rows and columns, each of the auxiliary cells corresponding to a respective set of the main cells;
   - a plurality of wordlines each connected to a respective row of the auxiliary cells;
   - a plurality of bitlines each connected to a respective column of the auxiliary cells and spanning the plurality of sub-units;
   - row decoder circuitry for selecting, in a first mode of operation, an individual wordline among the plurality of wordlines of a particular one of the sub-units and, in a second mode of operation, a group of wordlines including at least one wordline from each of at least two of the sub-units;
   - bitline control circuitry for driving the bitlines to enable writing of auxiliary cells connected to a wordline that has been selected;
   - control logic circuitry for (i) controlling the bitline control circuitry while the row decoder circuitry operates in the second mode of operation so as to set each of the auxiliary cells in each of the sub-units to a first logic state; (ii) causing input data to be written to selected ones of the main cells; and (iii) controlling the bitline control circuitry while the row decoder circuitry operates in the first mode of operation so as to set those auxiliary cells corresponding to the selected ones of the main cells to a second logic state different from the first logic state.
Clause 94: The semiconductor device defined in clause 93, wherein the main cells and the auxiliary cells are static random access memory (SRAM) cells.
Clause 95: The semiconductor device defined in clause 94, wherein the SRAM cells are single-port SRAM cells.
Clause 96: The semiconductor device defined in clause 93, wherein the plurality of bitlines comprises, for each column of the auxiliary cells, a respective pair of bitlines connected thereto.
Clause 97: The semiconductor device defined in clause 93, wherein the first logic state is a logic state indicative of data in the main memory unit having a first status.
Clause 98: The semiconductor device defined in clause 97, wherein the second logic state is a logic state indicative of data in the main memory unit having a second status.
Clause 99: The semiconductor device defined in clause 98, wherein the first logic state is logic zero and the second logic state is logic one.
Clause 100: The semiconductor device defined in clause 93, wherein the row decoder circuitry comprises a plurality of row decoders, each respectively corresponding to one of the sub-units.
Clause 101: The semiconductor device defined in clause 100, wherein each of the row decoders individually selects at least one wordline identified by the control logic circuitry.
Clause 102: The semiconductor device defined in clause 101, wherein the control logic circuitry is configured to identify at least one wordline to be selected by each of the row decoders so that the row decoder circuitry is capable of selecting, in the second mode of operation, a group of wordlines including at least one wordline from each of at least two of the sub-units.
Clause 103: The semiconductor device defined in clause 102, wherein the group of wordlines includes at least one wordline from each of the sub-units.
Clause 104: The semiconductor device defined in clause 102, wherein the group of wordlines includes all of the wordlines from all of the sub-units.
Clause 105: The semiconductor device defined in clause 93, wherein the control logic circuitry is configured to cause the input data to be written to the selected ones of the main cells upon receipt of a command from an external entity.
Clause 106: The semiconductor device defined in clause 105, wherein the external entity comprises an off-chip controller and wherein the command comprises a write command identifying a start address from which the selected ones of the main cells can be determined.
Clause 107: The semiconductor device defined in clause 105, wherein the control logic circuitry is configured to place the row decoder circuitry in the first mode of operation upon completion of writing of the input data.
Clause 108: The semiconductor device defined in clause 107, wherein to place the row decoder circuitry in the first mode of operation, the control logic circuitry is configured to command the row decoder circuitry to select an individual wordline whose connected-to row contains at least one main cell that was written to.
Clause 109: The semiconductor device defined in clause 93, wherein controlling the bitline control circuitry while the row decoder circuitry operates in the second mode of operation comprises (i) selecting a column of the auxiliary cells; (ii) setting to the first logic state each auxiliary cell in the selected column and that is connected to a wordline that has been selected; and (iii) repeating the selecting and the setting for each of the other columns of the auxiliary cells.
Clause 110: The semiconductor device defined in clause 93, wherein controlling the bitline control circuitry while the row decoder circuitry operates in the second mode of operation comprises (i) selecting a plurality of the columns of the auxiliary cells; (ii) simultaneously setting to the first logic state those auxiliary cells in the selected columns that are connected to a wordline that has been selected; and (iii) repeating the selecting and the simultaneously setting for multiple other pluralities of the columns of the auxiliary cells.
Clause 111: The semiconductor device defined in clause 93, wherein controlling the bitline control circuitry so as to set each of the auxiliary cells to the first logic state comprises simultaneously setting to the first logic state all auxiliary cells connected to a wordline that has been selected.
Clause 112: The semiconductor device defined in clause 93, wherein each of the auxiliary cells corresponds to a respective set of exactly one of the main cells.
Clause 113: The semiconductor device defined in clause 93, wherein each of the auxiliary cells corresponds to a respective set of at least two of the main cells.
Clause 114: A method for execution by a semiconductor device, comprising:
   - selecting a group of rows of auxiliary cells including at least one row from each of at least two sub-units, the auxiliary cells in each of the sub-units being arranged into rows and columns;
   - driving a plurality of bitlines each connected to a respective column of the auxiliary cells and spanning the plurality of sub-units, so as to set each of the auxiliary cells to a first logic state;
   - writing input data to selected ones of a plurality of main cells, wherein each of the auxiliary cells corresponds to a respective set of the main cells;
   - selecting a particular row of a particular one of the sub-units, the particular row including at least one auxiliary cell whose corresponding set of main cells includes at least one of the selected cells;
   - driving the bitlines so as to set the at least one auxiliary cell to a second logic state different from the first logic state.
Clause 115: A computer-readable storage medium storing instructions which, when processed by a computer, are used to generate control logic circuitry configured to:
   - select a group of rows of auxiliary cells including at least one row from each of at least two sub-units, the auxiliary cells in each of the sub-units being arranged into rows and columns;
   - drive a plurality of bitlines each connected to a respective column of the auxiliary cells and spanning the plurality of sub-units, so as to set each of the auxiliary cells to a first logic state;
   - cause input data to be written to selected ones of a plurality of main cells, wherein each of the auxiliary cells corresponds to a respective set of the main cells;
   - select a particular row of a particular one of the sub-units, the particular row including at least one auxiliary cell whose corresponding set of main cells includes at least one of the selected cells;
   - drive the bitlines so as to set the at least one auxiliary cell to a second logic state different from the first logic state.
Clause 116: A semiconductor device, comprising:
   - a main memory unit including a plurality of main cells arranged into an array of N1 rows and M1 columns;
   - an auxiliary memory unit including a plurality of auxiliary cells arranged into N2 rows and M2 columns, each of the auxiliary cells corresponding to a respective set of Z main cells, N2 being less than N1 and M2 being greater than M1/Z;
   - a plurality of wordlines each connected to a respective row of the auxiliary cells;
   - a plurality of bitlines each connected to a respective column of the auxiliary cells;
   - row decoder circuitry for selecting an individual wordline among the plurality of wordlines;
   - bitline control circuitry for driving the plurality of bitlines to enable writing of auxiliary cells connected to the selected wordline;
   - control logic circuitry for (i) controlling the bitline control circuitry so as to set each of the auxiliary cells to a first logic state; (ii) causing input data to be written to selected ones of the main cells; and (iii) controlling the bitline control circuitry so as to set those auxiliary cells corresponding to the selected ones of the main cells to a second logic state different from the first logic state.
Clause 117: The semiconductor device defined in clause 116, wherein the main cells and the auxiliary cells are static random access memory (SRAM) cells.
Clause 118: The semiconductor device defined in clause 117, wherein the SRAM cells are single-port SRAM cells.
Clause 119: The semiconductor device defined in clause 116, wherein the plurality of bitlines comprises, for each column of the auxiliary cells, a respective pair of bitlines connected thereto.
Clause 120: The semiconductor device defined in clause 116, wherein the first logic state is a logic state indicative of data in the main memory unit having a first status.
Clause 121: The semiconductor device defined in clause 120, wherein the second logic state is a logic state indicative of data in the main memory unit having a second status.
Clause 122: The semiconductor device defined in clause 121, wherein the first logic state is logic zero and the second logic state is logic one.
Clause 123: The semiconductor device defined in clause 116, wherein the control logic circuitry is configured to set each of the auxiliary cells to the first logic state upon receipt of a command from an external entity.
Clause 124: The semiconductor device defined in clause 123, wherein the external entity comprises an off-chip controller and wherein the command comprises a preset command.
Clause 125: The semiconductor device defined in clause 116, wherein the control logic circuitry is configured to cause the input data to be written to the selected ones of the main cells upon receipt of a command from an external entity.
Clause 126: The semiconductor device defined in clause 125, wherein the external entity comprises an off-chip controller and wherein the command comprises a write command identifying a start address from which the selected ones of the main cells can be determined.
Clause 127: The semiconductor device defined in clause 116, wherein controlling the bitline control circuitry so as to set each of the auxiliary cells to the first logic state comprises (i) selecting a column of the auxiliary cells; (ii) setting to the first logic state each auxiliary cell in the selected column and that is connected to a wordline that has been selected; and (iii) repeating the selecting and the setting for each of the other columns of the auxiliary cells.
Clause 128: The semiconductor device defined in clause 116, wherein controlling the bitline control circuitry so as to set each of the auxiliary cells to the first logic state comprises (i) selecting a plurality of the columns of the auxiliary cells; (ii) simultaneously setting to the first logic state those auxiliary cells in the selected columns that are connected to a wordline that has been selected; and (iii) repeating the selecting and the simultaneously setting for multiple other pluralities of the columns of the auxiliary cells.
Clause 129: The semiconductor device defined in clause 116, wherein controlling the bitline control circuitry so as to set each of the auxiliary cells to the first logic state comprises simultaneously setting to the first logic state all auxiliary cells connected to a wordline that has been selected.
Clause 130: The semiconductor device defined in clause 116, wherein Z is equal to one.
Clause 131: The semiconductor device defined in clause 116, wherein Z is greater than one.
Clause 132: The semiconductor device defined in clause 116, wherein N1 is at least as great as twice N2.
Clause 133: The semiconductor device defined in clause 116, wherein M2 is at least as great as M1/4.
Clause 134: A method for execution by a semiconductor device, comprising:
   - writing input data to selected ones of a plurality of main cells forming part of a main memory unit, the main cells of the main memory unit being arranged into N1 rows and M1 columns;
   - prior to said writing, driving a plurality of bitlines each connected to a respective column of auxiliary cells forming part of an auxiliary memory unit, so as to set each of the auxiliary cells to a first logic state, each of the auxiliary cells corresponding to a respective set of Z main cells, the auxiliary cells of the auxiliary memory unit being arranged into N2 rows and M2 columns, N2 being less than N1 and M2 being greater than M1/Z;
   - selecting a particular row of auxiliary cells that includes at least one auxiliary cell whose corresponding set of main cells includes at least one of the selected cells;
   - driving the bitlines so as to set the at least one auxiliary cell to a second logic state different from the first logic state.
Clause 135: A computer-readable storage medium storing instructions which, when processed by a computer, are used to generate control logic circuitry configured to:
   - cause input data to be written to selected ones of a plurality of main cells forming part of a main memory unit, the main cells of the main memory unit being arranged into N1 rows and M1 columns;
   - prior to the input data being written to the selected ones of the plurality of main cells, drive a plurality of bitlines each connected to a respective column of auxiliary cells forming part of an auxiliary memory unit, so as to set each of the auxiliary cells to a first logic state, each of the auxiliary cells corresponding to a respective set of Z main cells, the auxiliary cells of the auxiliary memory unit being arranged into N2 rows and M2 columns, N2 being less than N1 and M2 being greater than M1/Z;
   - select a particular row of auxiliary cells that includes at least one auxiliary cell whose corresponding set of main cells includes at least one of the selected cells;
   - drive the bitlines so as to set the at least one auxiliary cell to a second logic state different from the first logic state.
Clause 136: A semiconductor device, comprising: a plurality of single-ported memory cells;
   - a plurality of dual-ported memory cells arranged into rows and columns, each of the dual-ported memory cells corresponding to a respective set of single-ported memory cells;
   - first wordlines and second wordlines connected to the rows of the dual-ported memory cells such that each row of the dual-ported memory cells is connected to a corresponding one of the first wordlines and a corresponding one of the second wordlines;
   - first bitlines and second bitlines connected to the columns of the dual-ported memory cells such that each column of the dual-ported memory cells is connected to a corresponding set of the first bitlines and a corresponding set of the second bitlines;
   - row decoder circuitry for jointly selecting at least one of the first wordlines and at least one of the second wordlines;
   - bitline control circuitry for driving the first bitlines to enable writing of dual-ported memory cells connected to a first wordline that has been selected and for driving the second bitlines to enable writing of dual-ported memory cells connected to a second wordline that has been selected;
   - control logic circuitry for (i) controlling the bitline control circuitry so as to set each of the dual-ported memory cells to a first logic state; (ii) causing input data to be written to selected ones of the single-ported memory cells and (iii) controlling the bitline control circuitry so as to set those dual-ported memory cells corresponding to the selected ones of the single-ported memory cells to a second logic state different from the first logic state.
Clause 137: The semiconductor device defined in clause 136, wherein the single-ported memory cells and the dual-ported memory cells are static random access memory (SRAM) cells.
Clause 138: The semiconductor device defined in clause 136, wherein the corresponding set of the first bitlines connected to each column includes a pair of the first bitlines.
Clause 139: The semiconductor device defined in clause 138, wherein the corresponding set of the second bitlines connected to each column includes a pair of the second bitlines.
Clause 140: The semiconductor device defined in clause 136, wherein the first logic state is a logic state indicative of data in the single-ported memory cells having a first status.
Clause 141: The semiconductor device defined in clause 140, wherein the second logic state is a logic state indicative of data in the single-ported memory cells having a second status.
Clause 142: The semiconductor device defined in clause 141, wherein the first logic state is logic zero and the second logic state is logic one.
Clause 143: The semiconductor device defined in clause 136, wherein the single-ported memory cells occupy a first memory unit and the dual-ported memory cells occupy a second memory unit.
Clause 144: The semiconductor device defined in clause 136, wherein the control logic circuitry is configured to control the bitline control circuitry so as to set each of the dual-ported memory cells to the first logic state upon receipt of a command from an external entity.
Clause 145: The semiconductor device defined in clause 144, wherein the external entity comprises an off-chip controller and wherein the command comprises a preset command.
Clause 146: The semiconductor device defined in clause 136, wherein the control logic circuitry is configured to cause the input data to be written to the selected ones of the single-ported memory cells upon receipt of a command from an external entity.
Clause 147: The semiconductor device defined in clause 146, wherein the external entity comprises an off-chip controller and wherein the command comprises a write command identifying a start address from which the selected ones of the single-ported memory cells can be determined.
Clause 148: The semiconductor device defined in clause 146, wherein the control logic circuitry is configured to control the bitline control circuitry so as to set those dual-ported memory cells corresponding to the selected ones of the single-ported memory cells to the second logic state upon completion of writing of the input data.
Clause 149: The semiconductor device defined in clause 136, wherein controlling the bitline control circuitry so as to set each of the dual-ported memory cells to the first logic state comprises (i) selecting a column of the dual-ported memory cells; (ii) setting to the first logic state each dual-ported cell in the selected column and that is connected to a first wordline or a second wordline that has been selected; and (iii) repeating the selecting and the setting for each of the other columns of the dual-ported memory cells.
Clause 150: The semiconductor device defined in clause 136, wherein controlling the bitline control circuitry so as to set each of the dual-ported memory cells to the first logic state comprises (i) selecting a plurality of the columns of the dual-ported memory cells; (ii) simultaneously setting to the first logic state those dual-ported cells in the selected columns that are connected to a first wordline or a second wordline that has been selected; and (iii) repeating the selecting and the simultaneously setting for multiple other pluralities of the columns of the dual-ported memory cells.
Clause 151: The semiconductor device defined in clause 136, wherein controlling the bitline control circuitry so as to set each of the dual-ported memory cells to the first logic state comprises simultaneously setting to the first logic state all dual-ported memory cells connected to a first wordline or a second wordline that has been selected.
Clause 152: The semiconductor device defined in clause 136, wherein each of the dual-ported memory cells corresponds to a respective set of exactly one of the single-ported memory cells.
Clause 153: The semiconductor device defined in clause 136, wherein each of the dual-ported memory cells corresponds to a respective set of at least two of the single-ported memory cells.
Clause 154: A method for execution by a semiconductor device, comprising:
   - setting each of a plurality of dual-ported memory cells to a first logic state;
   - writing input data to selected ones of a plurality of single-ported memory cells, wherein each of the dual-ported memory cells corresponds to a respective set of single-ported memory cells;
   - setting those dual-ported memory cells corresponding to the selected ones of the single-ported memory cells to a second logic state different from the first logic state.
Clause 155: A computer-readable storage medium storing instructions which, when processed by a computer, are used to generate control logic circuitry configured to:
   - set each of a plurality of dual-ported memory cells to a first logic state;
   - cause input data to be written to selected ones of a plurality of single-ported memory cells, wherein each of the dual-ported memory cells corresponds to a respective set of single-ported memory cells;
   - set those dual-ported memory cells corresponding to the selected ones of the single-ported memory cells to a second logic state different from the first logic state.

These and other aspects and features of the present invention will now become apparent to those of ordinary skill in the art upon review of the following description of specific embodiments of the invention in conjunction with the accompanying drawings.

### BRIEF DESCRIPTION OF THE DRAWINGS

In the accompanying drawings:
Fig. 1A is a block diagram of a memory system in accordance with a possible embodiment, including a bridge device disposed between a memory controller and a plurality of non-volatile memory devices;
Fig. 1B conceptually illustrates a feature of the bridge device, which is to convert customized commands from the memory controller into generic commands for the non-volatile memory devices;
Fig. 2 is a block diagram of the bridge device in accordance with a possible embodiment, including a plurality of managed memory modules;
Fig. 3A is a block diagram of one of the managed memory modules in accordance with a possible embodiment, including a mask logic block;
Fig. 3B is a block diagram of one of the managed memory modules in accordance with another possible embodiment;
Fig. 4 is a block diagram of the mask logic block in accordance with a possible embodiment;
Figs. 5-10 are block diagrams illustrating the partial contents of various memory structures throughout various processing stages of an example command to write data to a specific one of the non-volatile memory devices, such command having been issued by the memory controller;
- Fig. 11 is a transistor level block diagram illustrating a possible internal structure of a memory cell that can be used to make up part of the virtual page buffer and the mask buffer;
Fig. 12 is a block diagram of a semiconductor memory circuit in accordance with a non-limiting embodiment of the present invention, the semiconductor memory circuit including at least one row decoder;
Figs. 13A-13D are block diagrams of the semiconductor memory circuit of Fig. 12, showing more detail of the at least one row decoder, in accordance with various specific non-limiting embodiments of the present invention; and
Fig. 14 is a block diagram of the semiconductor memory circuit of Fig. 12 embedded in a system.
Fig. 15 is a block diagram of a semiconductor device including a main memory unit and an auxiliary memory unit, in accordance with a specific non-limiting embodiment of the present invention;
Fig. 16 is a circuit diagram of a single-port SRAM memory cell;
Figs. 17-20 are block diagrams of semiconductor devices each including a main memory unit and an auxiliary memory unit, in accordance with other specific non-limiting embodiments of the present invention;
Figs. 21A-21E are block diagrams of the semiconductor devices of Figs. 15 and 17-20 embedded in a system.

It is to be expressly understood that the description and drawings are only for the purpose of illustration of certain embodiments of the invention and are an aid for understanding. They are not intended to be a definition of the limits of the invention.

### DETAILED DESCRIPTION

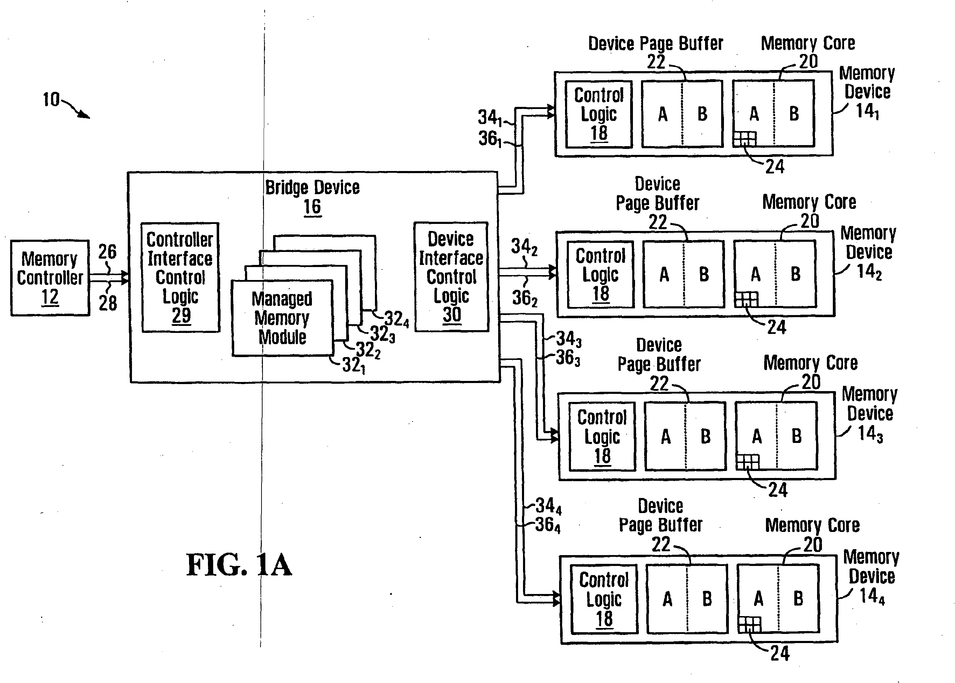

With reference to Fig. 1A, there is shown a memory system 10 in accordance with a non-limiting embodiment of the present invention. The memory system 10 comprises a memory controller 12, a plurality of non-volatile memory devices 14₁-14₄ and a semiconductor device. In the particular example, the semiconductor device is a bridge device 16 disposed between the memory controller 12 and the non-volatile memory devices 14₁-14₄. It should be appreciated that although there are four (4) non-volatile memory devices 14₁-14₄ shown in Fig. 1A, this is for illustrative purposes only, and the memory system 10 is not limited to a particular number of non-volatile memory devices. In fact, even just a single non-volatile memory device can be present in some embodiments.

### Non-Volatile Memory Devices 14₁-14₄

In some cases, the non-volatile memory devices 14₁-14₄ can be conventionally available NAND Flash devices as purveyed by numerous suppliers in the marketplace today. For example, the non-volatile memory devices 14₁-14₄ can be NAND flash, NOR flash, NROM, etc., to name a few non-limiting possibilities. In other cases, some or all of the non-volatile memory devices 14₁-14₄ may be non-standard devices that are not made commercially available. It should also be appreciated that not all of the non-volatile memory devices 14₁-14₄ need to be of the same type or made by the same manufacturer.

Each of the non-volatile memory devices 14₁-14₄ includes a device control logic block 18, a memory core 20 and a device page buffer 22. The memory core 20 includes an arrangement of data elements 24 that can be written to and read from under control of device control logic block 18. Device control logic block 18 receives generic commands and "write data" from, as well as provides "read data" to, an external entity. As used herein, a "logic block" (as in, for example, the expression "device control logic block 18") includes circuitry and/or software to perform a desired logic function. In the figures, however, the word "block" is omitted so as not to clutter the drawings.

In a non-limiting embodiment, the data elements 24 in the memory core 20 may be organized as a plurality of "planes", each plane including a plurality of "blocks", each block including a plurality of "pages" each page including a plurality of "words". For example, in the illustrated embodiment, the memory core 20 has two (= 2¹) planes (A and B), each plane including 32.768 (= 2¹⁵) blocks of thirty-two (= 2⁵) pages per block, with each page containing 2.048 (= 2¹¹) eight-bit words, for a total of 4 gigabytes (= 2³² eight-bit words) of memory per non-volatile memory device. Additional words can be added for error correction and other purposes, which can bring the total to 2.112 words per plane, per page in some devices. However, it should be appreciated that other dimensionalities and configurations can be used, including a configuration whereby only a single plane is used.

The device page buffer 22 comprises an arrangement of data elements. The device page buffer 22 is used to temporarily store one page's worth of data received from the external entity before it is written to a specified page in the memory core 20, or alternatively to temporarily store one page's worth of data extracted from the memory core 20 before it is returned to the external entity in the final stages of processing a generic command to read data. Thus, in the present example, the device page buffer 22 holds 2.112 words in each of the two planes (A and B). In other embodiments, the device page buffer 22 may have a different size and may hold more than one page's worth of data.

Generic commands that may be processed by one or several of the non-volatile memory devices 14₁-14₄ have a generic command structure that begins with a first command cycle. Address cycles, data cycles, and a second command cycle are all possibilities, depending on the actual command itself. A selection of possible generic commands that can be encoded by various combinations of bits conveyed by the first command cycle, as well as possible definitions of such generic commands, are provided in Table I below:

**TABLE I : Definition of selected generic commands for use with non-volatile memory devices 14₁-14₄**

| Command | Command Cycle 1 | Number of Address Cycles | Data Cycles Required | Command Cycle 2 |
|---|---|---|---|---|
| PAGE PROGRAM | 80h | 5 | Yes | 10h |
| PAGE PROGRAM CACHE MODE | 80h | 5 | Yes | 15h |
| PAGE PROGRAM FOR INTERNAL DATA MOVE | 85h | 5 | Optional | 10h |
| RANDOM DATA INPUT | 85h | 2 | Yes | |
| BLOCK ERASE | 60h | 3 | No | D0h |

It should be understood that various manufacturers may have different specific values for the first (and second, where applicable) command cycle related to a particular generic command. It should also be understood that various manufacturers may support different versions of the above generic commands, and may have a greater or smaller total number of generic commands. However, one aspect that is common to those non-volatile memory devices of interest here concerns the PAGE PROGRAM generic command, which in all its equivalent versions is assumed to include at least an initial command cycle (to signal onset of the PAGE PROGRAM generic command), one or more address cycles (to identify the specified page, as well as the starting point - within the specified page - of data to be written to the memory core 20), one or more data cycles (to allow inputting of the actual data to be written to the memory core 20) and a confirmatory command cycle (to trigger transfer of the contents of the device page buffer 22 into the memory core 20).

### Memory Controller 12

The memory controller 12 can be a customized memory controller that is designed to perform memory operations (e.g., reading and writing) on specially adapted non-volatile memory devices, through the use of customized commands obeying a customized command structure.

By way of example, the specially adapted non-volatile memory devices can be clock-synchronous NAND flash devices, serially interconnected in a chain, as shown and described in, for example, United States Patent Application Serial No. 12/179,835 entitled "Multiple Independent Serial Link Memory", published as United States Patent Application Publication 2008/0279003 on November 13, 2008, hereby incorporated by reference herein.

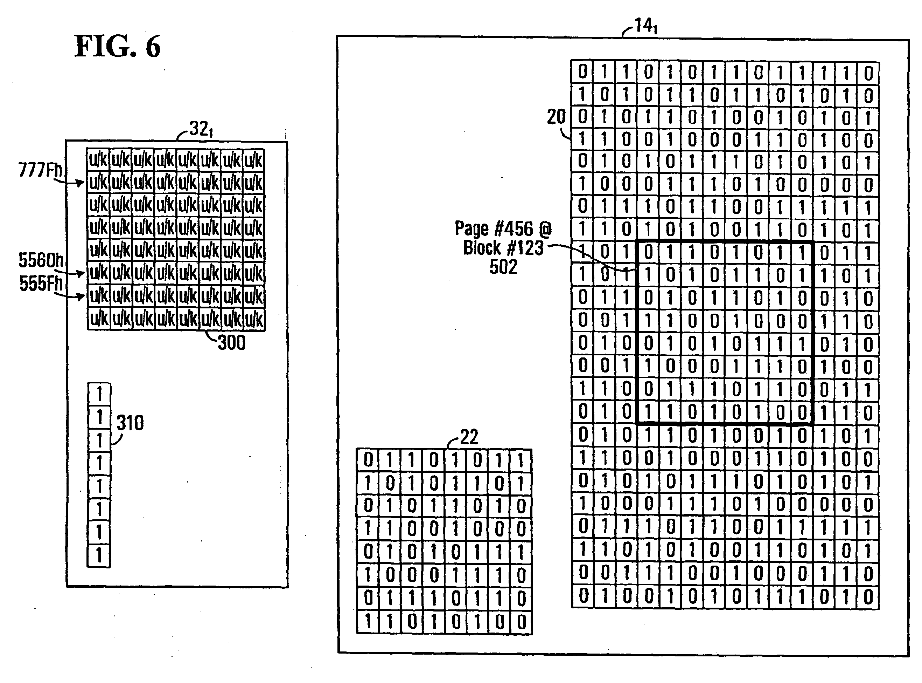

By way of example, the memory controller 12 can take the form of a flash controller, as shown in Fig. 6A of International PCT Application No. PCT/CA2007/001428, published on February 28, 2008 under publication number WO/2008/022434, hereby incorporated by reference herein.

The memory controller 12 issues various customized commands (intended for individual clock-synchronous NAND flash devices interconnected in a chain) by regulating the behavior of signals along a set of control lines 26 and a set of downstream data lines 28. It is contemplated to also provide a set of upstream data lines, but this feature is not described here since the focus is on data writing operations.

The customized commands issued by the memory controller 12 may be structured somewhat differently from those listed in Table I, particularly when the clock-synchronized NAND flash devices are connected in a chain. An example of the customized command structure obeyed by the customized commands issued by the memory controller 12 is shown in Table II below:

**TABLE II: Customized command structure**

| Device Address | OP Code | RA | CA | DATA |
|---|---|---|---|---|
| 1 byte | 1 byte | 3 bytes | 2 bytes | 1-2112 bytes |

In Table II above, the "Device Address" field is used to specify a designated NAND flash device in the chain of NAND flash devices, while the "OP Code" field is an operation code uniquely indicative of a customized command. The remaining fields are optional and may include, depending on the customized command, the RA (row address field), the CA (column address field) and the DATA (field). Tables 1, 2 and 3 of the aforementioned International PCT Application PCT/CA2007/001428 show in greater detail a possibility for the customized command structure, in a non-limiting example embodiment.

In the specific case of a command for programming a portion of a specific page of data in the memory of a specific device, a pair of customized commands may be issued. The first command is a BURST DATA LOAD START customized command, which begins with the Device Address field identifying the specific device, followed by the "OP Code" filed that identifies the BURST DATA LOAD START command, followed by the CA field that specifies a starting address within the specific page. This is followed by the data to be written to the specific page (via a page buffer on the specific device), starting at the starting address.

The next customized command issued in the context of programming a portion of the specific page is a PAGE PROGRAM customized command, which begins with the Device Address field identifying the specific device and the "OP Code" field identifying the PAGE PROGRAM customized command. This is followed by the RA field that specifies a page address which is to be programmed with the data written in the page buffer of the specific device.

It should be appreciated that several instances of yet another customized command, namely the BURST DATA LOAD customized command, may occur one after the other between issuing the BURST DATA LOAD START customized command and issuing the PAGE PROGRAM customized command. The difference between the BURST DATA LOAD customized command and the BURST DATA LOAD START customized command is that the latter causes the page buffer of the specific device to be initialized whereas the former does not. This allows disjointed sections of the specific buffer to be written to, without having to write the entire page for each section.

Although the memory controller 12 described above is designed to function with a series interconnection of non-volatile memory devices that are specially adapted for communication with each other and with the memory controller 12, the memory controller 12 can nevertheless be made to function with an arrangement of conventional non-volatile memory devices such as the non-volatile memory devices 14₁-14₄ shown in Fig. 1A. Specifically, this can be achieved by way of the bridge device 16, which is disposed between the memory controller 12 and the non-volatile memory devices 14₁-14₄.

### Bridge Device 16

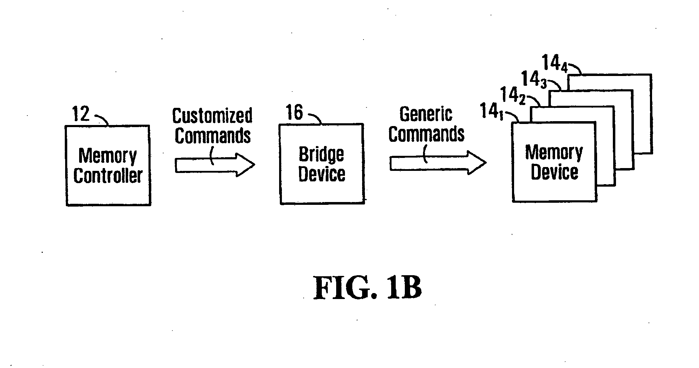

The bridge device 16 includes controller interface control logic block 29, device interface control logic block 30 and, for each of the non-volatile memory devices 14₁-14₄, a corresponding managed memory module 32₁-32₄. With reference to Fig. 1B, a main function of the bridge device 16 is to convert customized commands received from the memory controller 12 into generic commands destined for the non-volatile memory devices 14₁-14₄.

Device interface control logic block 30 represents the aforementioned "external entity" to which is connected device control logic block 18 of each of the non-volatile memory devices 14₁-14₄. More specifically, device interface control logic block 30 is connected to device control logic block 18 of each of the non-volatile memory devices 14₁-14₄ by a respective set of control lines 34₁-34₄ and a respective set of downstream data lines 36₁-36₄. The sets of control lines 34₁-34₄ and the sets of downstream data lines 36₁-36₄ are used to convey commands and write data to the non-volatile memory devices 14₁-14₄, respectively. A set of upstream data lines would also be provided for conveying read data from the non-volatile memory devices 14₁-14₄, but this feature is not described here since the focus is on data writing operations.

Controller interface control logic block 29 is connected to the memory controller 12 by the set of control lines 26 and the set of downstream data lines 28. It should thus be noted that although the memory controller 12 may issue customized commands that are destined, from its point of view, for a target non-volatile memory device compatible with the memory controller 12 (e.g., a clock-synchronized NAND flash device), in actuality these customized commands are intercepted by controller interface control logic block 29 of the bridge device 16 along the set of control lines 26 and the set of downstream data lines 28.

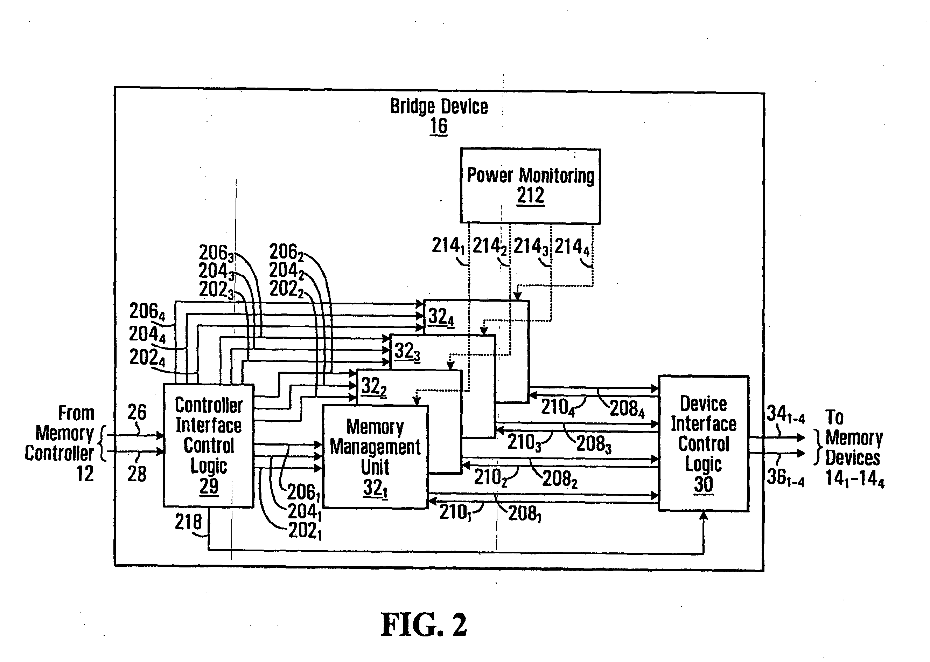

Reference is now made to Fig. 2, which provides further detail regarding the internal structure of the bridge device 16. It should be understood in what follows that signal lines carrying signals in addition to those and described shown may be provided in order to control and/or facilitate operation of the various components of the bridge device 16; however, they can be omitted for simplicity since their role is peripheral and their implementation will be readily understood by those of skill in the art.

Controller interface control logic block 29 derives various addresses, data and read/write signals that will be supplied to individual ones of the managed memory modules 32₁-32₄ based on the customized commands received from the memory controller 12 along the set of control lines 26 and the set of downstream data lines 28. Specifically, controller interface control logic block 29 provides managed memory module 32₁ with an address signal carried by a set of address lines 204₁, an input data signal carried by a set of input data lines 202₁ and a read/write signal carried by a respective read/write line 206₁. Similarly, controller interface control logic block 29 provides managed memory module 32₂ with an address signal carried by a set of address lines 204₂, an input data signal carried by a set of input data lines 202₂ and a read/write signal carried by a respective read/write line 206₂. Similarly, controller interface control logic block 29 provides managed memory module 32₃ with an address signal carried by a set of address lines 204₃, an input data signal carried by a set of input data lines 202₃ and a read/write signal carried by a respective read/write line 206₃. Finally, controller interface control logic block 29 provides managed memory module 32₄ with an address signal carried by a set of address lines 204₄, an input data signal carried by a set of input data lines 202₄ and a read/write signal carried by a respective read/write line 206₄.

Each of the managed memory modules 32₁-32₄ provides device interface control logic block 30 with respective output data signals SO₁-SO₄ carried by respective sets of output data lines 208₁-208₄. In addition, controller interface control logic block 29 provides device interface control logic block 30 with a control signal S_{C} carried by a link 218. The control signal S_{C}, which is formulated by controller interface control logic block 29 based on the customized commands received from the memory controller 12, indicates to device interface control logic block 30 when it is time to transfer the output data signal received from a particular one of the managed memory modules 32₁-32₄ towards the corresponding one of the non-volatile memory devices 14₁-14₄.

In addition, device interface control logic block 30 provides each of the managed memory modules 32₁-32₄ with a respective first reset signal along a respective one of a plurality of reset lines 210₁-210₄. In a non-limiting embodiment, device interface control logic block 30 is configured to assert the first reset signal on a given one of the reset lines 210₁-210₄ after the confirmatory command cycle of the PAGE PROGRAM generic command has been sent by device interface control logic block 30 to the corresponding non-volatile memory device. (A possible sequence of events leading to transmittal of the PAGE PROGRAM generic command by device interface control logic block 30 will be described in further detail later on.)

Power monitoring circuitry 212 provides each of the managed memory modules 32₁-32₄ with a respective second reset signal carried by a respective one of a plurality of reset lines 214₁-214₄. In some embodiments, the various second reset signals carried by the reset lines 214₁-214₄ may in fact be the same electrical signal. The power monitoring unit 212 is configured to assert the second reset signal carried by the reset lines 214₁-214₄ whenever it detects that power has been established (or re-established) to the bridge device 16. In an alternative embodiment, the power monitoring circuitry 212 can be incorporated into the controller interface control logic block 29, whereby assertion of the second reset signal is carried out based on detection of a combination of logic values present on certain incoming signals (such as, for example, reset, chip enable and/or chip select, to name a few non-limiting possibilities), which combination occurs in the unique event that power has been established (or re-established) to the bridge device 16.

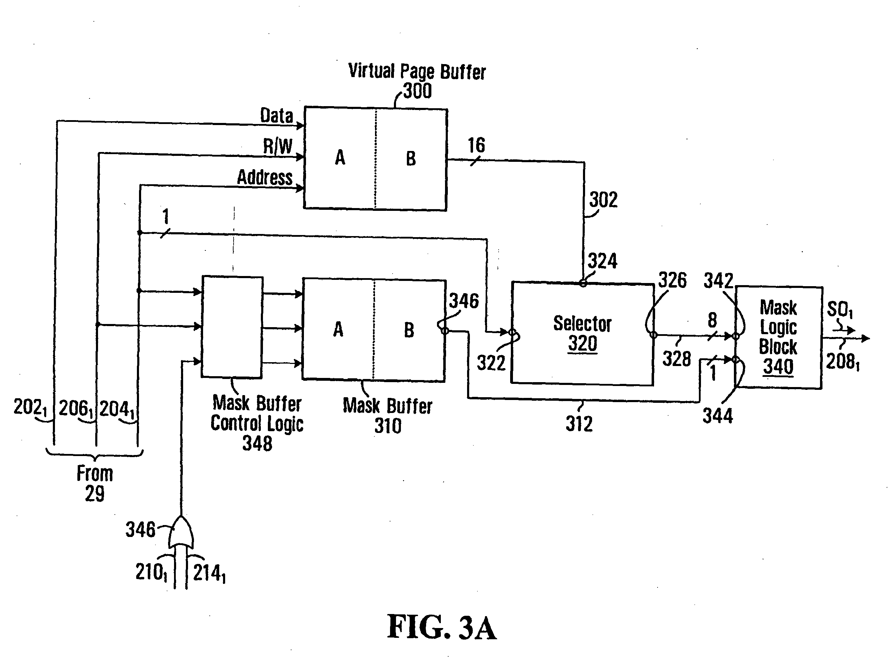

Reference is now made to Fig. 3A, which provides further detail regarding the structure of a particular one of the managed memory modules 32₁-32₄, in this case managed memory module 32₁. It should be appreciated that a similar description would apply to the other managed memory modules 32₂, 32₃, 32₄. As illustrated, managed memory module 32₁ comprises a virtual page buffer 300 and a mask buffer 310.

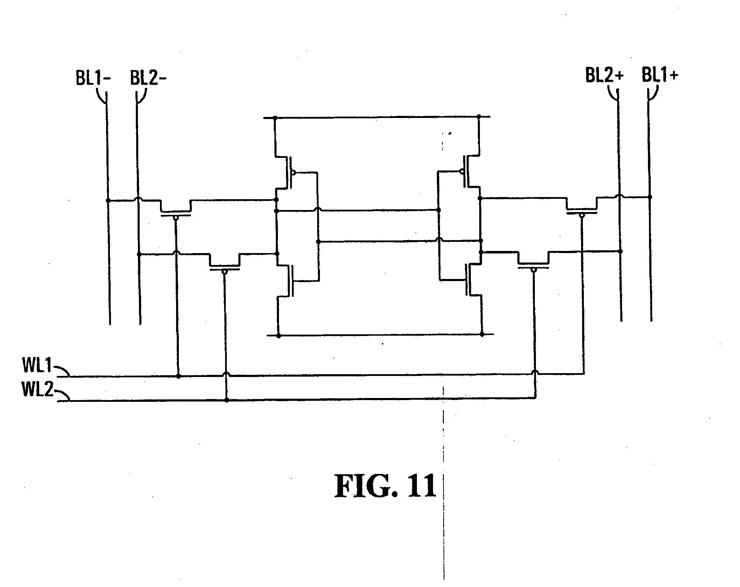

In a specific non-limiting embodiment, the virtual page buffer 300 and the mask buffer 310 are composed of static random access memory (SRAM), although this is not a requirement of the present invention. A suitable SRAM cell structure that may be used in certain non-limiting embodiments is a dual-port structure of the type shown in Fig. 11. Other memory technologies may be used for either or both of the virtual page buffer 300 and the mask buffer 310, including, without limitation, dynamic random access memory (DRAM).

The virtual page buffer 300 comprises an arrangement of data elements (e.g., SRAM cells) mirroring the data elements in the device page buffer 22 of the corresponding non-volatile memory device, in this case non-volatile memory device 14₁. The virtual page buffer 300 temporarily stores data that will eventually be transferred to the device page buffer 22 in non-volatile memory device 14₁. The virtual page buffer 300 is populated over time based on the address, data and read/write signals received from controller interface control logic block 29 along the set of address lines 204₁, the set of input data lines 202₁ and read/write line 206₁.

Specifically, during a write operation (i.e., when the read/write signal carried by read/write line 206₁ encodes a "WRITE MODE"), the address signal carried by the set of address lines 204₁ specifies a location within the virtual page buffer 300 where the input data signal carried by the set of input data lines 202₁ is to be written. On the other hand, data transfer out of the virtual page buffer 300 occurs during a read operation. Specifically, when the read/write signal carried by read/write line 206₁ encodes a "READ MODE", the address signal carried by the set of address lines 204₁ specifies an address within the virtual page buffer 300 whose contents are to be extracted. These contents are placed onto a set of data lines 302.

It should be appreciated that in the present non-limiting embodiment, two planes (A and B) are provided and thus the virtual page buffer 300 may be conceptually divided into two sections, one associated with plane A and the other associated with plane B. In the present non-limiting example, the data elements in each plane are eight bits (one byte) in length. The plane associated with particular data to be written to the virtual page buffer 300 can be encoded in a bit occupying a pre-determined bit position in the address of the particular data. Similarly, the plane associated with particular data to be extracted from the virtual page buffer 300 is encoded in a bit occupying a predetermined bit position in the address of the particular data.

In order to cause the data associated with a selected plane to be passed to device interface control logic block 30 along the set of output data lines 208₁, there is provided a selector 320. In this case, where eight-bit (8-bit) words and two (2) planes are employed, the selector 320 has an input 324 with a width of sixteen (16) data bits, an output 326 with a width of eight (8) data bits and a one-bit (1-bit) control input 322. The control input 322 is provided so as to allow selection, at the output 326, of either the first group of eight (8) bits or the second group of eight (8) bits of the sixteen-bit (16-bit) signal at the input 324. The control input 322 is fed with the signal carried by one of the address lines 204₁, namely the one encoding a bit that occupies the aforementioned pre-determined bit position. The output 326 of the selector 320 is connected along a set of data lines 328 to a first input 342 of mask logic block 340.

A second input 344 of mask logic block 340 leads from an output of the mask buffer 310, which is now described. More specifically, the mask buffer 310 comprises an arrangement of data elements (e.g., SRAM cells) that are in correspondence with the data elements in the virtual page buffer 300. Thus, each data element in the mask buffer 310 has a corresponding data element in the virtual page buffer 300. However, the data elements in the mask buffer 310 need not encode the same values as the data elements in the virtual page buffer 300. In the illustrated embodiment, the data elements in the virtual page buffer 300 are each eight bits in length, while the data elements in the mask buffer 310 are each only a single bit in length. Of course, as will be apparent to those of skill in the art, other ratios between the size (in bits) of the data elements in the virtual page buffer 300 and the size (in bits) of the data elements in the mask buffer 310 are possible including, without limitation, 1:1, 4:1, 16:1 and others.

The first reset signal (received along reset line 210₁) and the second reset signal (received along reset line 214₁) are combined by a two-input logic OR module 346 whose output is provided to mask buffer control logic block 348. The output of the logic OR module 346 serves as a trigger to clear the mask buffer 310. To be precise, clearing of the mask buffer 310 is to be triggered if power has been established (or re-established) to the bridge device 16 or if the confirmatory command cycle of the PAGE PROGRAM generic command has been sent by device interface control logic block 30 to non-volatile memory device 14₁. In the case of NAND Flash memory, only logic 0 can be programmed into a memory cell of the non-volatile memory devices 14₁-14₄, while logic 1 signifies "program inhibit". In such circumstances, mask buffer control logic block 348 clears the mask buffer 310 by forcibly setting all the data elements in the mask buffer 310 to logic 1.

In accordance with an embodiment of the present invention, after the mask buffer 310 is cleared and all of its data elements are set to a given logic state (in this case, logic 1), a given data element in the mask buffer 310 is encoded with the opposite logic state (in this case, logic 0) when the corresponding data element in the virtual page buffer 300 is being (or has been) written to. Therefore, during (or shortly after) a write operation (i.e., when the read/write signal carried by read/write line 206₁ encodes the "WRITE MODE"), mask buffer control logic block 348 causes logic 0 to be written to those data elements within the mask buffer 310 whose addresses are encoded by the address signal carried by the set of address lines 204₁.

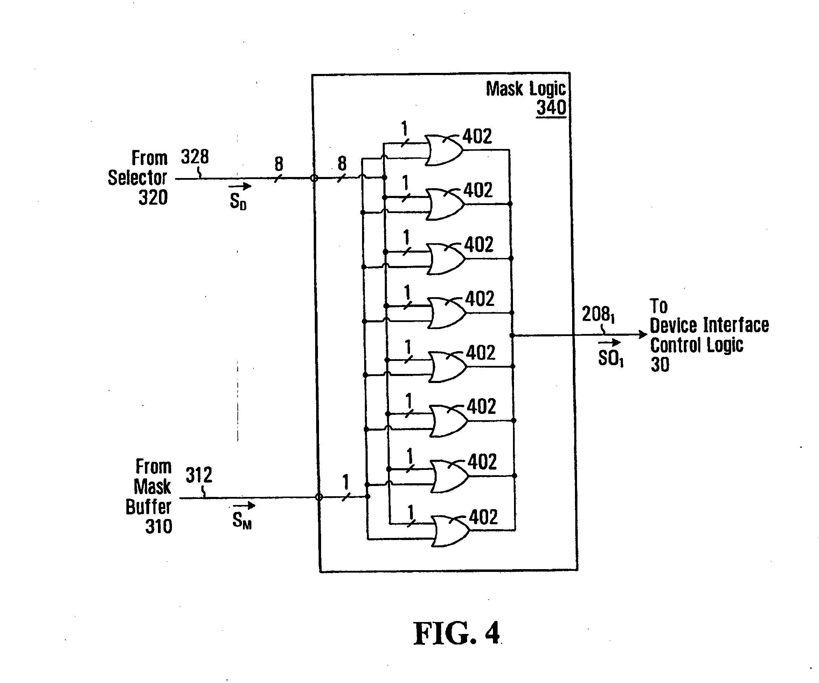

Data transfer out of the mask buffer 310 occurs during a read operation, in tandem with data transfer out of the virtual page buffer 300 described above. Specifically, when the read/write signal carried by read/write line 206₁ encodes the "READ MODE", the set of address lines 204₁ specifies a location within the mask buffer 310 whose contents are to be extracted. The contents of that address (which, it is recalled, will be either logic 0 or logic 1) are placed onto a mask data line 312 via the output of the mask buffer 310. The mask data line 312 leads to the second input 344 of the mask logic block 340, which is now described in greater detail with reference to Fig. 4.

Specifically, mask logic block 340 receives a mask signal S_{M} carried by the mask data line 312 and a data signal S_{D} carried by the set of data lines 328. Mask logic block 340 includes a bank of two-input logic OR modules 402, where the number of logic OR modules 402 depends on the width (in bits) of the data signal S_{D}. In this case, there are eight (8) logic OR modules 402 but it should be appreciated that this is not a limitation of the present invention. Also, the reference to logic OR modules 402 is merely to illustrate the functionality of mask logic block 340. It is to be understood that various ways of implementing such functionality will become apparent to those of skill in the art.

The output of the logic OR modules 402 is the output data signal SO₁ provided to device interface control logic block 30 along the set of output data lines 208₁. It should be appreciated that the output data signal SO₁ will be set to all logic 1 when the mask signal S_{M} was set to logic 1, whereas it will reflect the data signal S_{D} when the mask signal S_{M} was set to logic 0. It is recalled, of course, that the mask signal S_{M} will be set to logic 0 only if the data element in the virtual page buffer 300 at the memory location encoded by the address signal carried by the set of address lines 204₁ has been written to since the last time that the mask buffer 310 was cleared.

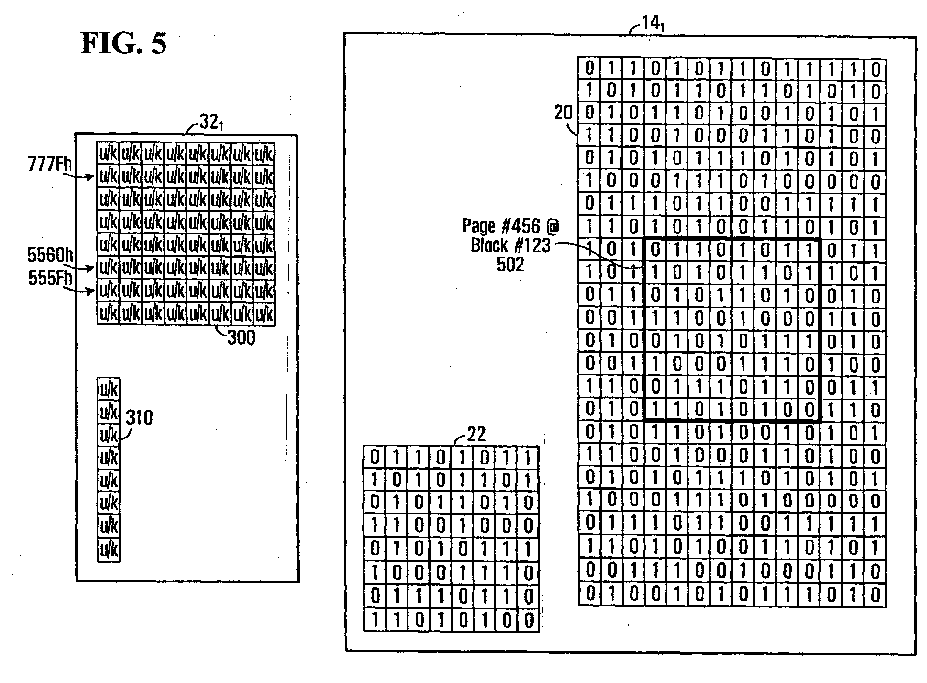

An example of operation is now provided by way of illustration only. In this example, operation of the bridge device 16 and managed memory module 32₁ is followed along a temporal series of stages denoted A through E. Accordingly, reference will be made to Figs. 5 through 10, each of which shows, by way of example only, possible contents of the device page buffer 22, the virtual page buffer 300, the mask buffer 310 and a portion of a given device page 502 during various ones of these stages. For example purposes, the device page 502 can be considered to be page #456 at block #123 in the memory core 20 of non-volatile memory device 14₁. Also, the dimensions of the device page buffer 22, the virtual page buffer 300, the mask buffer 310 and the device page 502 have been selected to facilitate illustration but are by no means limiting.

### Stage A

Let it be assumed that power is established (or re-established) to the bridge device 16, but this scenario is not yet detected by the power monitoring unit 212. The power monitoring unit 212 has thus not yet issued the second reset signal on reset line 214₁. Fig. 5 shows the contents of the virtual page buffer 300 and the mask buffer 310 at this point in time. It is noted that the state of the individual data elements in the virtual page buffer 300 and the mask buffer 310 is unknown (denoted "u/k"). This is due to the fundamental structure of SRAM cells, whereby the logic state (0 or 1) acquired by a given memory cell after power-up will be random, as it depends to a certain extent on (unpredictable) transient node voltage fluctuations during power-up. Fig. 5 also shows the contents of the device page buffer 22, whose data elements can have a particular distribution of ones and zeros that may be known or unknown at the current time. In addition, Fig. 5 shows the contents of the device page 502, which may be known to, or relied upon by, a user or system at the current time.

### Stage B

The power monitoring unit 212 issues the second reset signal on reset line 214₁. The second reset signal may also be issued on reset lines 214₂, 214₃ and 214₄, although this is not important for the purposes of the present example. The second reset signal reaches the mask buffer control logic block 348 via the logic OR module 346. In response, the mask buffer control logic block 348 clears the mask buffer 310 which, as mentioned above, results in all the data elements in the mask buffer 310 being set to logic 1. Fig. 6 shows the contents of the virtual page buffer 300, the mask buffer 310, the device page buffer 22 and the device page 502 shortly after clearing of the mask buffer 310. It is noted that the contents of the virtual page buffer 300, the device page buffer 22 and the device page 502 have remained unchanged from the situation in Fig. 5.

### Stage C

Let it now be assumed that the memory controller 12 issues a first customized command, containing the following information:
Device Address = 14₁
OP Code = BURST DATA LOAD START
RA/CA = Block #123, Page #456, Starting Word 555Fh
DATA = 00101101, 10101001

It is noted that for illustrative purposes the Device Address has been selected to identify non-volatile memory device 14₁, while the block and page values have been selected so as to identify the exact same device page 502 referred to above with reference to Figs. 5 and 6. The first customized command is received at the bridge device 16 along the set of control lines 26 and the set of downstream data lines 28. The first customized command is processed by controller interface control logic block 29, which recognizes that the first customized command requires access to managed memory module 32₁, based on the Device Address encoded within the first customized command. Accordingly, the value 555Fh is encoded into the address signal, which is sent to managed memory module 32i along the set of address lines 204₁. It is assumed that the address signal also encodes the appropriate plane (e.g., A or B), if applicable. In addition, the value 00101101 is encoded into the input data signal, which is sent to managed memory module 32₁ along the set of input data lines 202₁. Also, based on the OP Code encoded within the first customized command, controller interface control logic block 29 encodes the "write mode" into the read/write signal, which is sent to managed memory module 32₁ along read/write line 206₁.

Next, while continuing to encode the read/write signal with the "write mode", the address is incremented to the value 5560h, which is encoded into the address signal sent to managed memory module 32₁ along the set of address lines 204₁ In addition, the value 10101001 is encoded into the input data signal, which is sent to managed memory module 32₁ along the set of input data lines 202₁.

Meanwhile, the block and page values (in this case, Block #123, Page #456) will be stored by controller interface control logic block 29 for future use, such as in the event that the memory controller 12 issues a subsequent BURST DATA LOAD customized command to write additional data to the current page, or issues a PAGE PROGRAM customized command.

Further to the above, the virtual page buffer 300 is written to at memory location 555Fh with the value 0101101 and is written to at memory location 5560h with the value 10101001. Additionally, the mask buffer control logic block 348 sets the corresponding data elements of the mask buffer 310 to logic 0.

Let it now be assumed that the memory controller 12 then issues a second customized command, containing the following information:
Device Address = 14₁
OP Code = BURST DATA LOAD
CA = Starting Word 777Fh (RA is not used)
DATA = 11010000

The second customized command is again received at the bridge device 16 along the set of control lines 26 and the set of downstream data lines 28. The second customized command is processed by controller interface control logic block 29, which recognizes, based on the Device Address encoded within the second customized command, that the second customized command requires access to the same managed memory module 32₁ as did the BURST DATA LOAD START customized command. Here, it is noticed that the block and page are omitted from the CA information, which implies that data is to be written to the same page as the one that was just written to as a result of the first customized command. Accordingly, the value 777Fh is encoded into the address signal, which is sent to managed memory module 32₁ along the set of address lines 204₁. Again, it is assumed that the address signal also encodes the appropriate plane (e.g., A or B), if applicable. In addition, the value 11010000 is encoded into the input data signal, which is sent to managed memory module 32₁ along the set of input data lines 202₁. Also, based on the OP Code encoded within the second customized command, controller interface control logic block 29 again encodes the "write mode" into the read/write signal, which is sent to managed memory module 32₁ along read/write line 206₁.

Further to the above, the virtual page buffer 300 is written to, at memory location 777Fh, with the value 11010000. Additionally, the mask buffer control logic block 348 sets the corresponding data element of the mask buffer 310 to logic 0.

It should be noted that non-volatile memory device 14₁, although seemingly the target recipient of the first and second customized commands (based on the Device Address), has remained idle while the first and second customized commands were intercepted and processed by the bridge device 16.

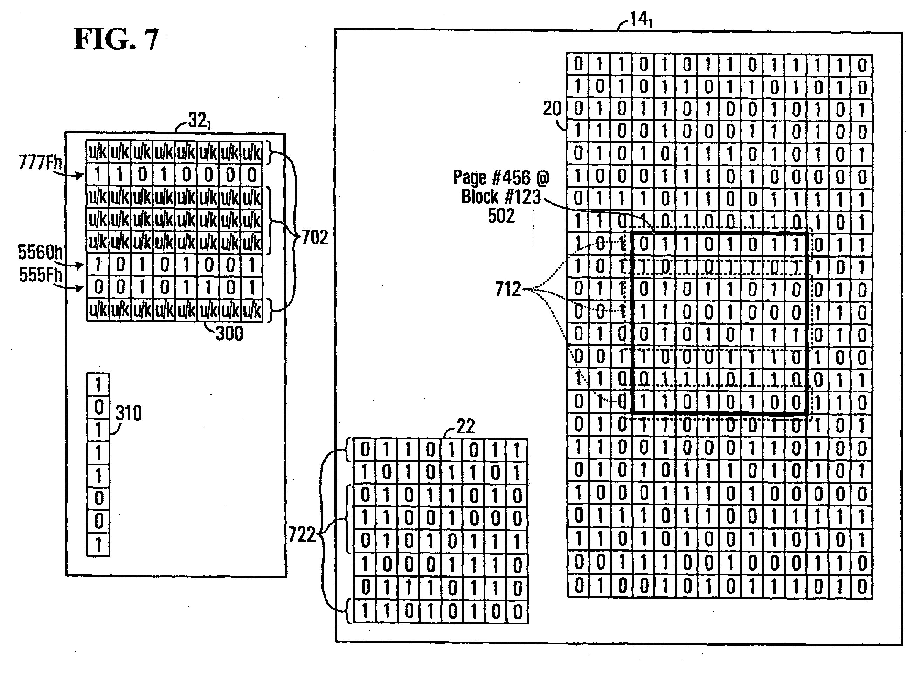

Fig. 7 shows the contents of the virtual page buffer 300, the mask buffer 310, the device page buffer 22 and the device page 502 shortly after processing of the second customized command has resulted in an effect on the virtual page buffer 300. It is seen that a certain number of data elements 702 in the virtual page buffer 300 still have unknown values, including data elements between memory locations 5560h and 777Fh. However, the corresponding data elements 712 in the device page 502 have values that are not necessarily unknown and therefore should not be gratuitously altered. For this reason, and as will be shown below, the corresponding data elements 722 in the device page buffer 22 will have to be set to logic 1, thereby to inhibit a programming operation from taking place on the data elements 712 in the device page 502.

### Stage D

Now consider that the memory controller 12 issues a third customized command, containing the following information:
Device Address = 14₁
OP Code = PAGE PROGRAM

The third customized command is received at the bridge device 16 along the set of control lines 26 and the set of downstream data lines 28. The third customized command is processed by controller interface control logic block 29, which recognizes, based on the Device Address encoded within the third customized command, that the third customized command requires access to the same managed memory module 32₁ as did the first and second customized commands. Based on the different OP Code, however, controller interface control logic block 29 recognizes that it is time for data to be transferred from the virtual page buffer 300 to the device page buffer 22 in non-volatile memory device 14₁.

To this end, controller interface control logic block 29 encodes an initial value 0000h into the address signal sent to managed memory module 32₁ along the set of address lines 204₁. In addition, controller interface control logic block 29 encodes the "read mode" into the read/write signal, which is sent to managed memory module 32₁ along read/write line 206₁. In response, the virtual page buffer 300 will place the contents of its data element located at address 0000h onto the set of data lines 302. In addition, the mask buffer 310 will place the contents of the corresponding data element located at address 0000h onto the mask data line 312 via the output of the mask buffer 310. As described earlier, the mask data line 312 and the set of data lines 302 lead to mask logic block 340 (via the selector 320 in the case of the set of data lines 302), which provides output data signal SO₁ to device interface control logic block 30 along the set of output data lines 208₁. After a brief period of time required to complete the read operation, controller interface control logic block 29 encodes the next value 0001 h into the address signal sent to managed memory module 32₁ along the set of address lines 204₁, and so on, until all memory locations in the virtual page buffer 300 (and the mask buffer 310) have been read from.

Meanwhile, controller interface control logic block 29 sends the control signal S_{C} to device interface control logic block 30 along the link 218. The control signal S_{C} provides the necessary control information to allow device interface control logic block 30 to issue a generic command that will be understood by non-volatile memory device 14₁ and that will result in data being written to non-volatile memory device 14₁. Accordingly, the control signal S_{C} may specify the required operation and its associated parameters. In this non-limiting example, the required operation is issuance of the PAGE PROGRAM generic command and its associated parameters are the identity of Page #456 within Block #123 of non-volatile memory device 14₁. In a multi-plane embodiment, the appropriate plane may also be specified.

In response to receipt of the control signal Sc from controller interface control logic block 29, device interface control logic block 30 conveys the PAGE PROGRAM generic command and write data (which corresponds to output data signal SO₁ received from managed memory module 32₁ along the set of output data lines 208₁) to non-volatile memory device 14₁ using the set of control lines 34₁ and the set of downstream data lines 36₁. In this way, the entire contents of the virtual page buffer 300 will be transferred to the device page buffer 22 in non-volatile memory device 14₁.

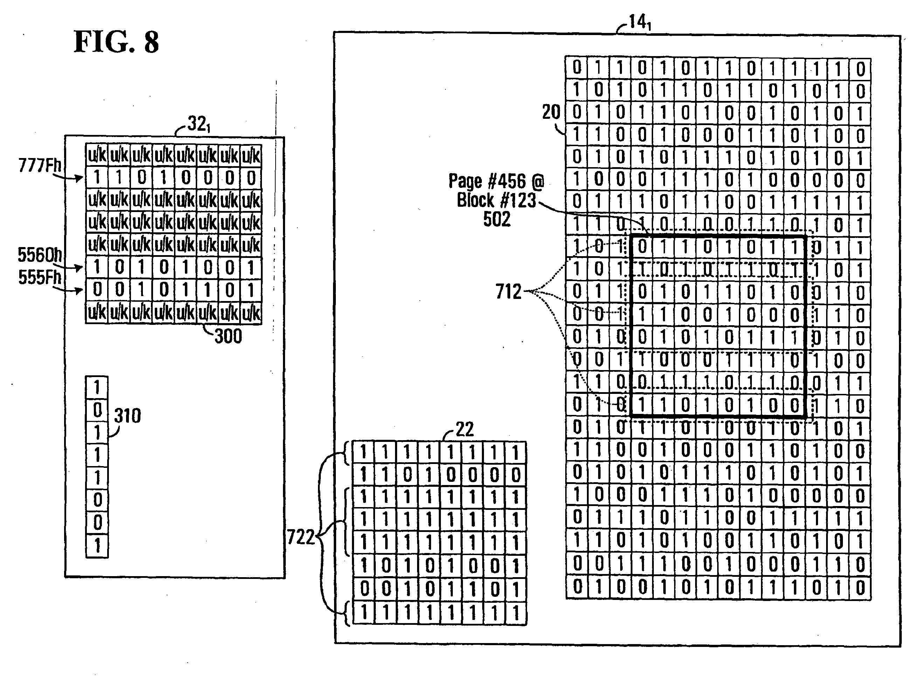

It is recalled that the PAGE PROGRAM generic command includes an initial command cycle, subsequent address and data cycles, and a confirmatory command cycle. Fig. 8 shows the contents of the virtual page buffer 300, the mask buffer 310, the device page buffer 22 and the device page 502, once the device page buffer 22 has been written to as a result of the initial command cycle and the subsequent address and data cycles, but before the contents of the page buffer 22 has been transferred to the device page 502. There is of course no change in the contents of the virtual page buffer 300 or the mask buffer 310. However, it is seen that the data elements 722 in the device page buffer 22 have been set to logic 1, while the other data elements in the device page buffer 22 match the corresponding data elements in the virtual page buffer 300. This will have the effect of preserving the current value of the data elements 712 (in the device page 502) when the device page buffer 22 is transferred to the memory core 20.

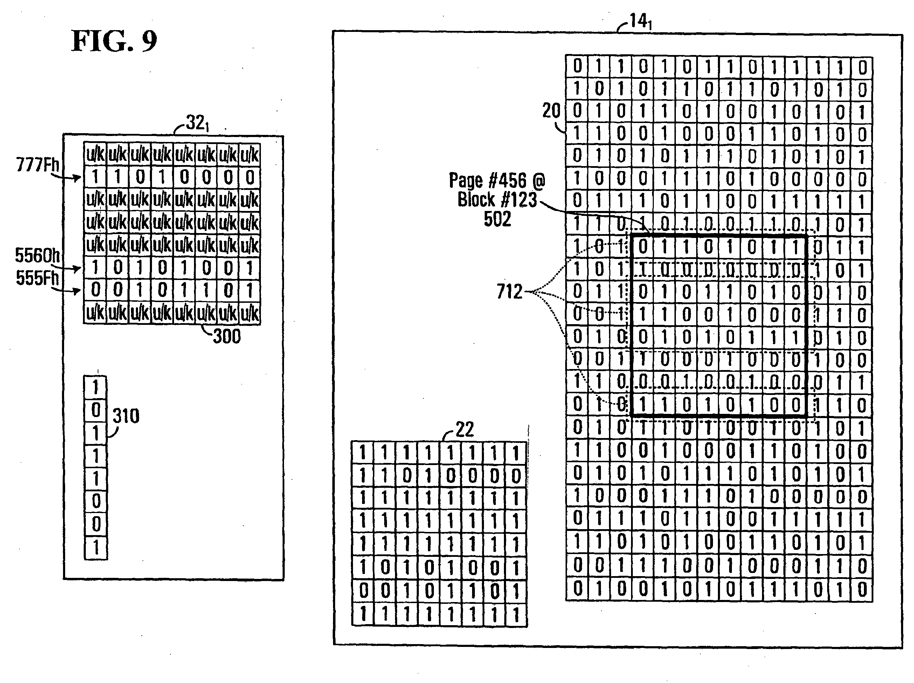

Indeed, this is seen in Fig. 9, which shows the contents of the virtual page buffer 300, the mask buffer 310, the device page buffer 22 and the device page 502, once non-volatile memory device 14₁ has fully processed the confirmatory command cycle in the PAGE PROGRAM generic command. It is seen that the only data elements in the device page 502 whose values have changed from logic 1 to logic 0 are those whose corresponding data elements in the device page buffer 22 had the value of logic 0.

### Stage E

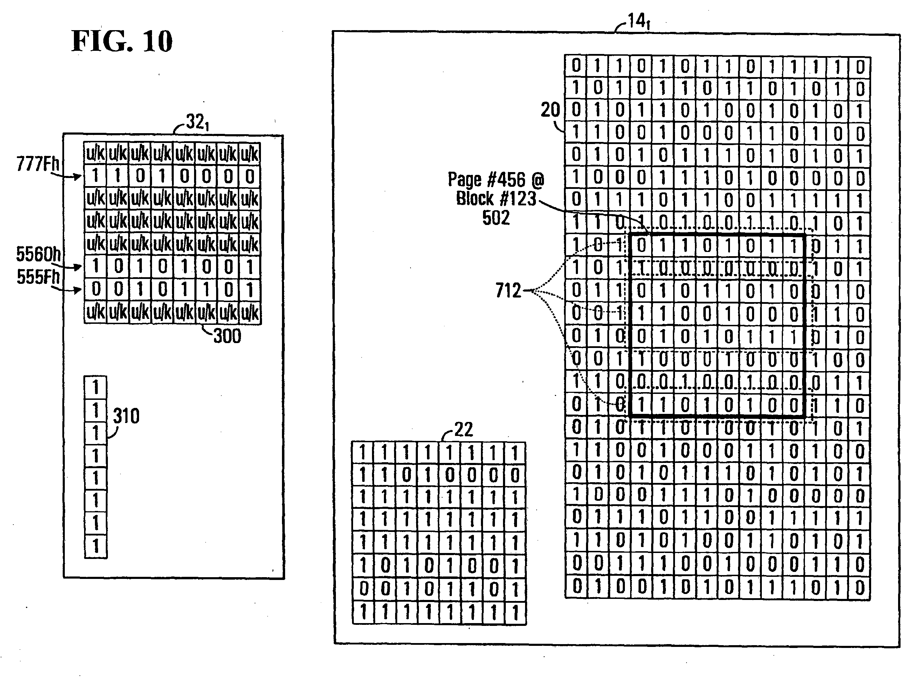

Having conveyed the confirmatory command cycle of the PAGE PROGRAM generic command, device interface control logic block 30 issues the first reset signal on reset line 210₁ (Meanwhile, device control logic block 18 of non-volatile memory device 14₁ may be processing the confirmatory command cycle of the PAGE PROGRAM generic command.) The second reset signal reaches the mask buffer control logic block 348 via the logic OR module 346. In response, the mask buffer control logic block 348 clears the mask buffer 310 which, as mentioned above, results in all the data elements in the mask buffer 310 being set to logic 1. Fig. 10 shows the contents of the virtual page buffer 300 and the mask buffer 310 shortly after clearing of the mask buffer 310. It is noted that the contents of the virtual page buffer 300, the device page buffer 22 and the device page 502 has remained unchanged.

In view of the foregoing, it should be apparent that when a bridge device is used to temporarily store a virtual page buffer for a device page buffer, and when the bridge device functions so as to transfer the entire virtual page buffer to the device page buffer regardless of the number of words to be actually written to a target page (thereby leaving certain data elements in the virtual page buffer unused), certain embodiments of the system described herein can avoid unintended alteration of data in the target page that would otherwise arise due to certain ones of the unused data elements in the virtual page buffer having randomly acquired, at certain times such as after power up, a logic state that is contrary to a program inhibit state.

Those skilled in the art will appreciate that numerous variants are within the scope of the invention. For example, although there may be a difference in size between the data elements in the virtual page buffer 300 and the data elements in the mask buffer 310, the mask buffer 310 may nevertheless be configured to have the same input/output specifications. A commercially available SRAM compiler (such as the Artisan^{®} SRAM compiler, available from ARM Ltd., Cambridge, United Kingdom, to name but one specific non-limiting example), can be programmed to generate two SRAM memory blocks that are identical except for their size.

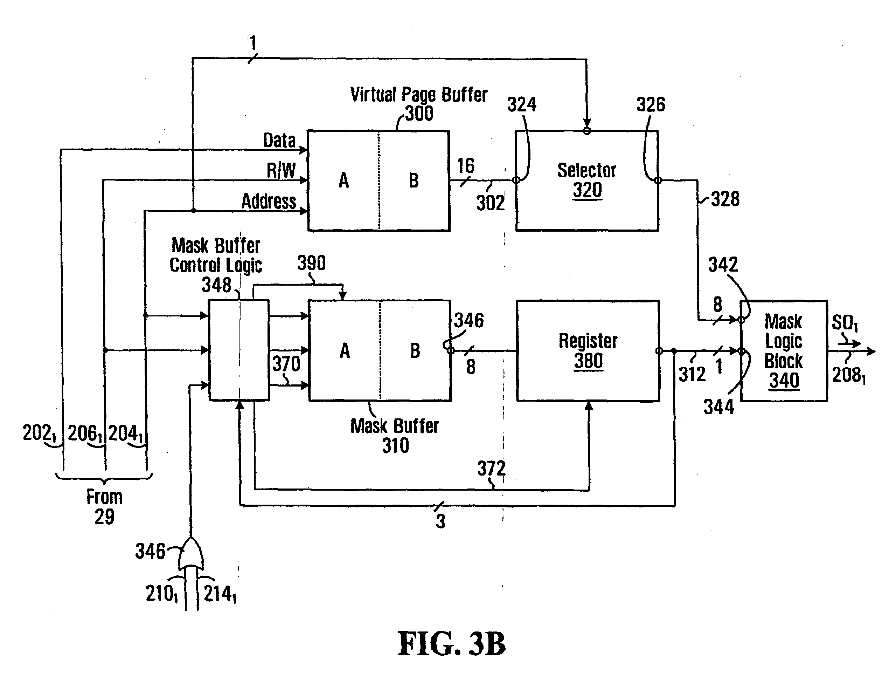

Fig. 3B is illustrative of the case where the mask buffer 310 and the virtual page buffer 300 are constructed as separate memory blocks that are identical but for their size, whereby the virtual page buffer 300 is eight (8) times larger than the mask buffer 310. In this particular example, the data elements in the virtual page buffer 300 and the mask buffer 310 can be written to and read from only in whole-byte increments (for the purposes of the present example, only a single plane is assumed to exist). Thus, while the address encoded by the set of address lines 204₁ defines a target byte of the virtual page buffer 300, this very same address encodes a target position within a target byte of the mask buffer 310. Accordingly, for the purposes of accessing the mask buffer 310, the address lines are split into two components, namely a first address component 370 (which includes all but three of the address lines 204₁ and which specifies the target byte of the mask buffer 310), and a second address component 372 (which includes the remaining three address lines and which specifies the target position within the target byte).

During a read operation involving the target position within the target byte, the first address component 370 is provided to the mask buffer 310. Mask buffer control logic block 348 also sets the read/write line (not shown) to "READ MODE". In response, the target byte is extracted from the mask buffer 310, and is fed to a bit-addressable register 380 that is controlled by the second address component 372. The size of the register 380 corresponds to the size of the data that can be extracted from the mask buffer 310, in this case one byte. Based on the information encoded in the second address component 372, the register 380 then outputs the target bit along the mask data line 312 in the form of the previously described mask signal S_{M}.

On the other hand, a two-step process is performed during a write operation involving the target position within the target byte, first involving a read operation then a write operation. Specifically, the first address component 370 is provided to the mask buffer 310, while mask buffer control logic block 348 sets the read/write line to "READ MODE". In response, the target byte is extracted from the mask buffer 310, and is fed to the aforementioned bit-addressable register 380 that is controlled by the second address component 372. The full output of the register 380 (i.e., the target byte) is fed back to mask buffer control logic block 348, which then modifies only the target bit based on the information encoded in the second address component, leaving the other bits of the target byte intact. Meanwhile, the first address component 370 continues to be provided to the mask buffer 310. At this stage, mask buffer control logic block 348 sets the read/write line to "WRITE MODE" and provides the modified target byte (i.e., with the modified target bit) along a set of data lines 390. In response, the modified target byte is written to the mask buffer 310.

Those skilled in the art should appreciate however that there is no specific requirement that the granularity of access to the mask buffer 310, 1110 be finer, the same or coarser than the granularity of access to the virtual page buffer 300, 1100.

It should also be appreciated that in some embodiments, all or part of the bridge device 16 and/or the managed memory modules 32₁-32₄ can be manufactured based on a low-level hardware description obtained using a logic synthesis tool that is run on a computing device. The logic synthesis tool is configured to read source code containing a functional description of the bridge device 16 and/or the managed memory modules 32₁-32₄ (e.g., in a language such as HDL, VHDL or Verilog, to name a few non-limiting possibilities) and to output a definition of the physical implementation of a circuit suitable for implementing corresponding functionality.

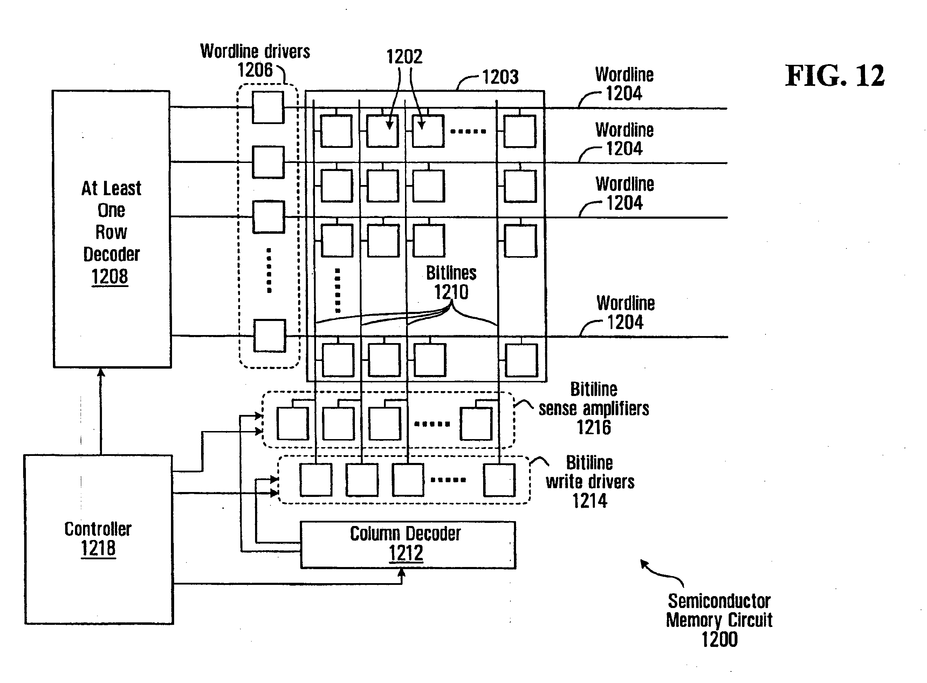

Reference is now made to Fig. 12, which shows a semiconductor memory circuit 1200 in accordance with a specific non-limiting embodiment of the present invention, comprising memory cells 1202 arranged into a memory array 1203 (of rows and columns), a plurality of wordlines 1204 each connected to a respective one of the rows, a plurality of wordline drivers 1206 each for driving a respective one of the wordlines 1204, at least one row decoder 1208 (to be described later), a plurality of bitlines 1210 each connected to a respective one of the columns, a column decoder 1212 for selecting one or more of the bitlines 1210 based on a column address, a plurality of bitline write drivers 1214 each for driving a respective one of the bitlines 1210 (in the case of a write), a plurality of bitline sense amplifiers 1216 each for amplifying and detecting a voltage level on a respective one of the bitlines 1210 (in the case of a read), and a controller 1218 for controlling the at least one row decoder 1208, the column decoder 1212, the bitline write drivers 1214 and the bitline sense amplifiers 1216.

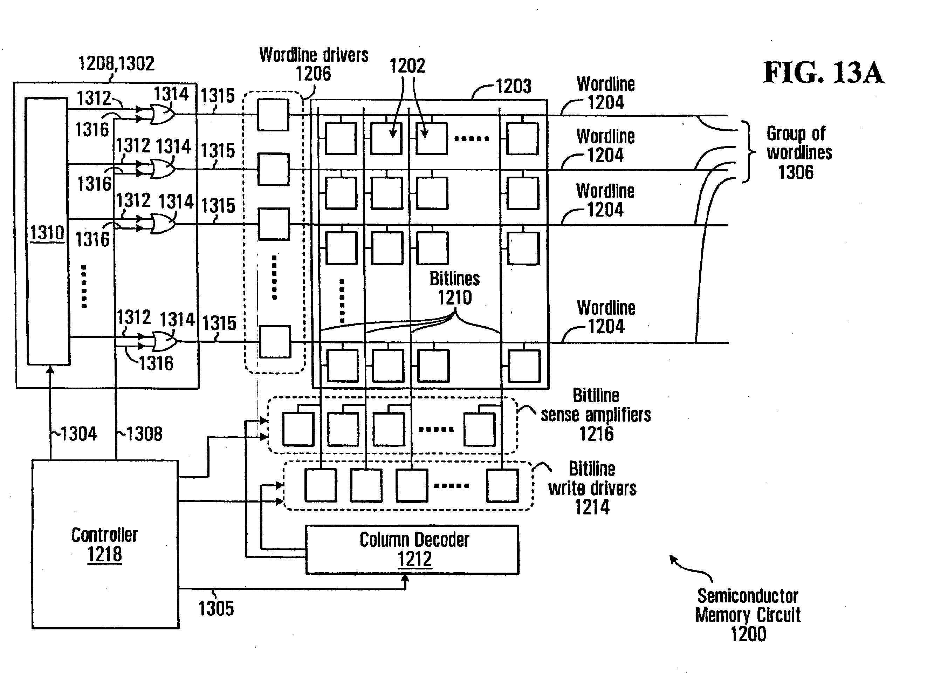

Reference is now made to Fig. 13A, which shows an example of the at least one row decoder 1208, in accordance with a first specific non-limiting embodiment of the present invention. In this embodiment, the at least one row decoder 1208 comprises a single row decoder 1302.

The row decoder 1302 is capable of selecting an individual one of the wordlines 1204, based on a row signal 1304 issued by the controller 1218 (or by an intervening pre-decoder, not shown, which separates an address signal into its components, namely the row signal 1304 and a column signal 1305). Selection of a wordline can be carried out by activating the particular one of the wordline drivers 1206 connected to the selected wordline. To this end, the at least one row decoder is connected to each of the wordline drivers 1206 by a respective wordline selection signal 1315, which can be asserted or not asserted in order to indicate whether the corresponding wordline driver is activated or not activated. An activated wordline driver corresponding to a selected wordline drives the row of cells connected to the selected wordline.

Additionally, the row decoder 1302 is capable of selecting a group of wordlines 1306 by activating those of the wordline drivers 1206 that are connected to the wordlines in the group. The activated wordline drivers then drive the rows of cells connected to the group of wordlines 1306. In the present specification, reference to a "group" of wordlines is meant indicate two or more wordlines. It should also be appreciated that the wordlines in a "group" of wordlines need not, although are permitted to, be associated with contiguous rows of cells in the memory array 1203.

Selection of the group of wordlines 1306 by the row decoder 1302 is controlled by a preset control signal 1308, which can be issued by the controller 1218. The preset control signal 1308 effectively overrides the aforementioned row signal 1304. A possible way to implement this functionality, as shown in Fig. 13A, is to feed each of the outputs of a row decoding circuit 1310 (among which a single output is asserted to indicate selection of the corresponding one of the wordlines 1204) to a respective first input 1312 of a respective logic "OR" gate 1314, with a respective second input 1316 being fed by the preset control signal 1308. This will cause multiple wordlines to be selected (i.e., those in the group of wordlines 1306) when the preset control signal 1308 is asserted. Alternatively, the preset control signal 1308 may be considered as an additional element of the row signal 1304 which, if present, causes selection of the group of wordlines 1306 as opposed to a single one of the wordlines 1204. Still other ways of implementing the desired functionality will occur to those of skill in the art.

In operation, and with continued reference to Fig. 13A, in response to assertion of the preset control signal 1308, the row decoder 1302 selects the group of wordlines 1306. Once the group of wordlines 1306 is selected by the row decoder 1302, the cells in the rows connected to the group of wordlines 1306 can be written to by driving the corresponding ones of the bitlines 1210. Specifically, the bitline write drivers 1214 are controlled so as to set the corresponding bitlines to the appropriate levels needed to set the memory cells to the desired logic state, which can be logic "0" or logic "1", for example. Since multiple rows are selected, control of a given one of the bitlines 1210 causes simultaneous writing of a cell in each of the selected rows, which can have the effect of reducing overall time required to preset the memory array 1203. Of course, it should be understood that the bitlines 1210 themselves need not all be driven together simultaneously. In various embodiments, the bitlines 1210 can be driven one at a time, in pairs, etc., while a particular group of wordlines remains selected.

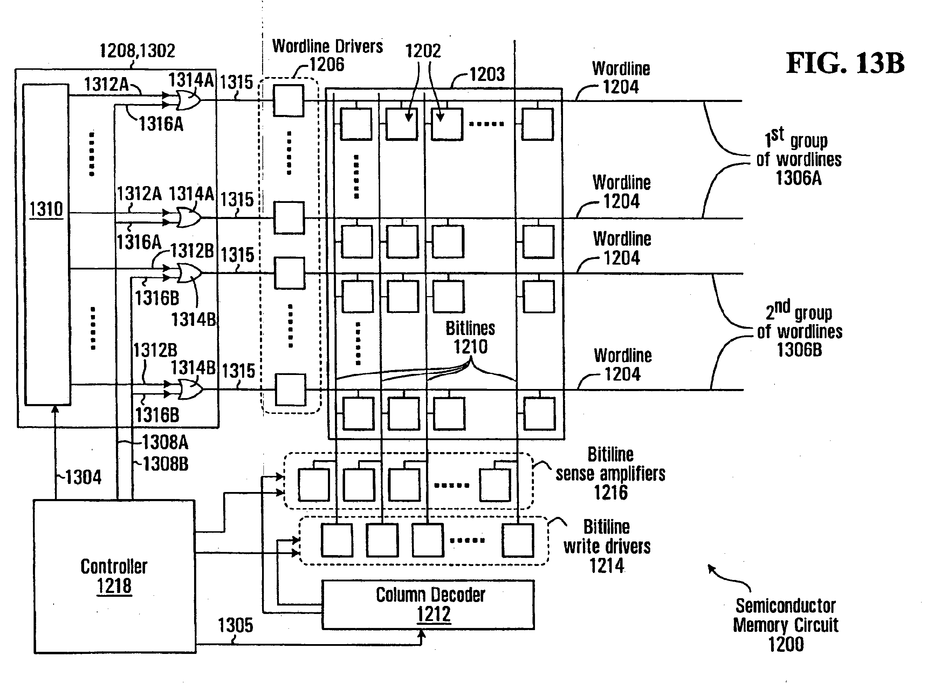

Reference is now made to Fig. 13B, which shows an example of the at least one row decoder 1208, in accordance with a second specific non-limiting embodiment of the present invention. This embodiment is identical to Fig. 13A, except that there are two preset control signals 1308A, 1308B provided by the controller 1218. Assertion of each of the preset control signals 1308A, 1308B causes selection of a respective group of wordlines, referred to herein as a first group of wordlines 1306A and a second group of wordlines 1306B. Although two row preset control signals 1308A, 1308B are illustrated, it should be appreciated that the number of preset control signals (and correspondingly the number of groups of wordlines) may be greater than two. Also, although the groups of wordlines 1306A, 1306B need not be associated with contiguous rows of the memory array 1203, assuming that they are will facilitate the reader's understanding.

A possible way to implement this functionality, as shown in Fig. 13B, is to feed each of the outputs of the row decoding circuit 1310 belonging to the first group of wordlines 1306A to a respective first input 1312A of a respective logic "OR" gate 1314A, with a respective second input 1316A being fed by the preset control signal 1308A. This will cause multiple wordlines to be selected (i.e., those in the first group of wordlines 1306A) when the preset control signal 1308A is asserted. Similarly, each of the outputs of the row decoding circuit 1310 belonging to the second group of wordlines 1306B to a respective first input 1312B of a respective logic "OR" gate 1314B, with a respective second input 1316B being fed by the preset control signal 1308B. This will cause multiple wordlines to be selected (i.e., those in the second group of wordlines 1306B) when the preset control signal 1308B is asserted.

Alternatively, the preset control signal 1308A and the preset control signal 1308B may be considered as additional elements of the row signal 1304 which, if present, cause, respectively, selection of the group of wordlines 1306A or selection of the group of wordlines 1306B. Of course, it is contemplated that asserting both the preset control signal 1308A and the preset control signal 1308B results in selection of all of the wordlines in the first and second groups of wordlines 1306A, 1306B. Still other ways of implementing the desired functionality will occur to those of skill in the art.

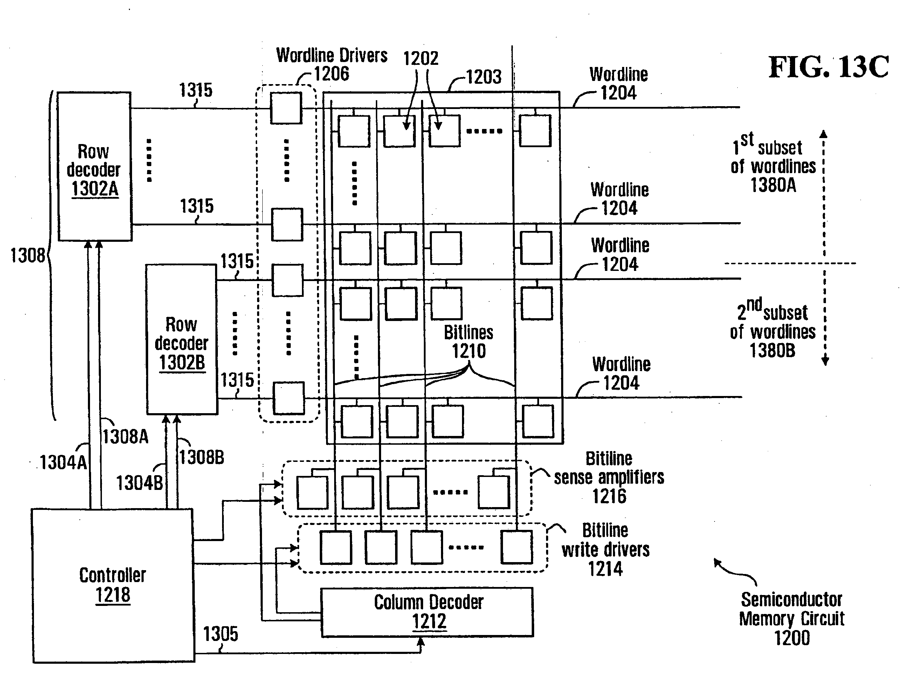

Reference is now made to Fig. 13C, which shows an example of the at least one row decoder 1208, in accordance with a third specific non-limiting embodiment of the present invention. In this embodiment, the at least one row decoder 1208 comprises a plurality of row decoders, namely a first row decoder 1302A and a second row decoder 1302B. Although two row decoders 1302A, 1302B are illustrated, it should be appreciated that the number of row decoders may be greater than two, and generally "*N*". It should thus be appreciated that the present embodiment applies to instances where the memory array 1203 is divided into *N* physically separate SRAM sub-arrays sharing the same bitlines but having their own individual sets of wordlines.

The first row decoder 1302A is capable of selecting an individual one of the wordlines 1204 in a first subset of wordlines 1380A, based on a row signal 1304A issued by the controller 1218 (or by an intervening pre-decoder, not shown, which separates an address signal into its components, namely the row signal 1304A and a column signal 1305). Similarly, the second row decoder 1302B is capable of selecting an individual one of the wordlines 1204 in a second subset of wordlines 1380B, based on a row signal 1304B issued by the controller 1218 (or by an intervening pre-decoder, not shown, which separates an address signal into its components, namely the row signal 1304B and a column signal). The first and second subsets of wordlines may be contiguous or they may interleave.

Additionally, the first row decoder 1302A is capable of selecting a first group of wordlines within the first subset of wordlines 1380A by activating those of the wordline drivers 1206 that are connected to the wordlines in the first group of wordlines. The activated wordline drivers then drive the rows of cells connected to the first group of wordlines. Also, the second row decoder 1302B is also capable of selecting a second group of wordlines in the second subset of wordlines 1380B by activating those of the wordline drivers 1206 that are connected to the wordlines in the second group of wordlines. The activated wordline drivers then drive the rows of cells connected to the second group of wordlines.

Selection of the first group of wordlines by the first row decoder 1302A is controlled by a preset control signal 1308A, which can be issued by the controller 1218. Similarly, selection of the second group of wordlines by the second row decoder 1302B is controlled by a preset control signal 1308B, which can be issued by the controller 1218.

In operation, the controller 1218 controls assertion of the preset control signals 1308A, 1308B, which has the effect of controlling the order in which the first and second groups of wordlines are selected. In response to assertion of a given one of the preset control signals (i.e., 1308A, 1308B), the corresponding row decoder (i.e., 1302A, 1302B) selects its own specific group of wordlines within its own subset of wordlines (i.e., 1380A, 1380B). Once a particular group of wordlines is selected, the cells in the rows connected to the group of wordlines can be written to by driving the corresponding bitlines. Specifically, as already described, the bitline write drivers are controlled so as to set the bitlines to the appropriate levels needed to set the memory cells to the desired logic state, which can be logic "0" or logic "1", for example.

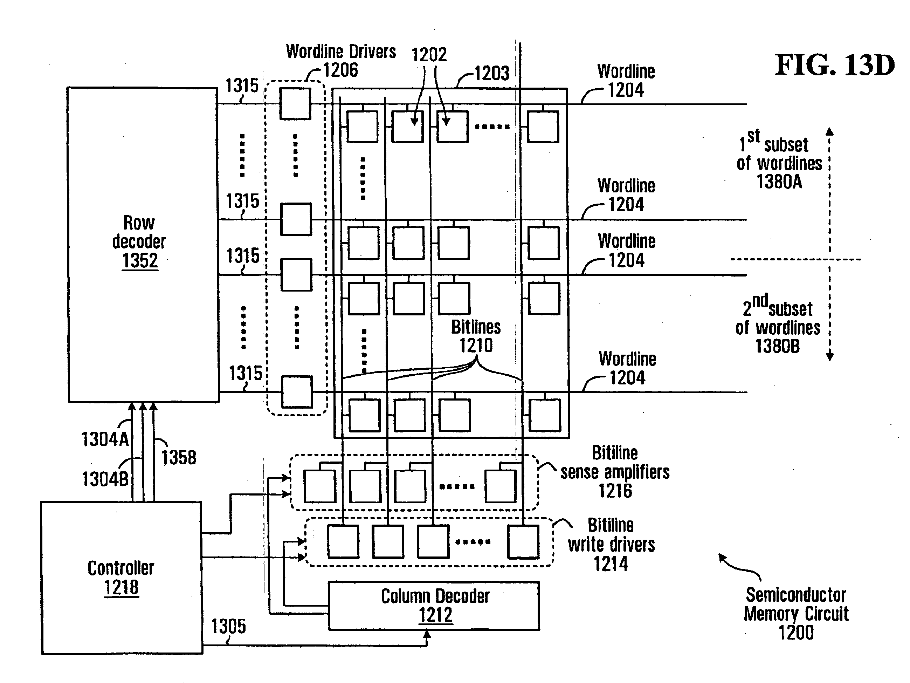

Reference is now made to Fig. 13D, which is an embodiment identical to that of Fig. 13C, except that the plural row decoders are combined into a single, larger row decoder 1352, and a single, master preset control signal 1358 is provided. However, the two row signals 1304A, 1304B continue to be provided in order to allow selection of an individual wordline in each of the first and second subsets of wordlines 1380A, 1380B. Thus, while the embodiment of Fig. 13C required added intelligence in the controller 1218 to assert the preset control signals 1308A, 1308B for control of the first and second row decoders 1302A, 1302B, the embodiment of Fig. 13D places this intelligence with the row decoder 1352 itself by providing control logic for processing the master preset control signal 1358. As a result, when the master preset control signal 1358 is asserted, the row decoder 1352 determines which group of wordlines to select (i.e., the first group of wordlines within the first subset of wordlines 1380A or the second group of wordlines within the second subset of wordlines 1380B), and in which order.

Those skilled in the art will appreciate that in the above embodiments, assertion of the preset control signal (e.g., 1308, 1308A, 1308B) may occur when the controller 1218 determines that it is time to preset the memory array 1203. This "preset operation" may be desired or required during power-up operation of the semiconductor memory circuit 1200, when the content of individual ones of the memory cells 1202 is unknown and is to be set to a predetermined logic state. Alternatively or in addition, the preset operation may be initiated by a soft reset generated by, for example, a watchdog circuit (not shown). Other instances where the preset operation may be desired or required will be apparent to those of skill in the art.

It should be appreciated that the present invention does not impose any particular limitation on the number of groups of wordlines, on the number of wordlines per group or on which wordlines may be part of a same group. Rather, it is expected that those skilled in art will be able to determine a suitable group size, number and membership based on various engineering criteria such as the trade off between peak current (which is inversely proportional to the number of groups) and background writing time (which is proportional to the number of groups).

Moreover, in embodiments that support multiple groups of wordlines, these groups may be selected simultaneously, or one after the other, or in an overlapping fashion, etc.

Furthermore, in embodiments that support multiple preset control signals, the present invention does not impose any particular limitation on the manner or order in which they are asserted by the controller.

Also, the present invention allows both single- and dual-port memory cells to be used. In a specific example employing single-port cells, the bitline write driver for a given column is associated with two of the bitlines 1210. In order to set the memory cells connected to the given column to a desired state, one of the two associated bitlines is set to a LOW state and the other one is used to set the memory cells in the given column to the desired state.

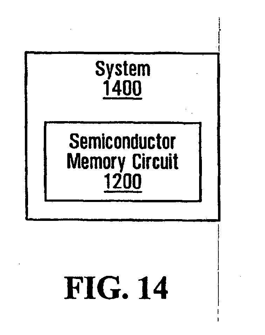

With reference to Fig. 14, in accordance with specific non-limiting embodiments of the present invention, the semiconductor memory circuit 1200 can be embedded in a system 1400. The system 1400 may be, for example, an ASIC (application-specific integrated circuit) or a SoC (system on chip), to name a few non-limiting possibilities.

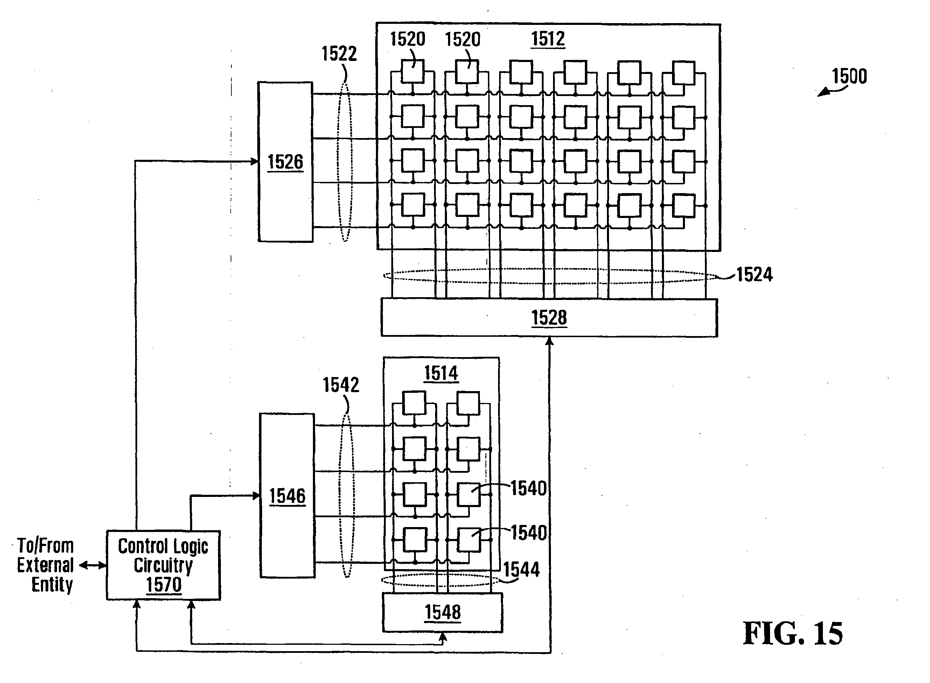

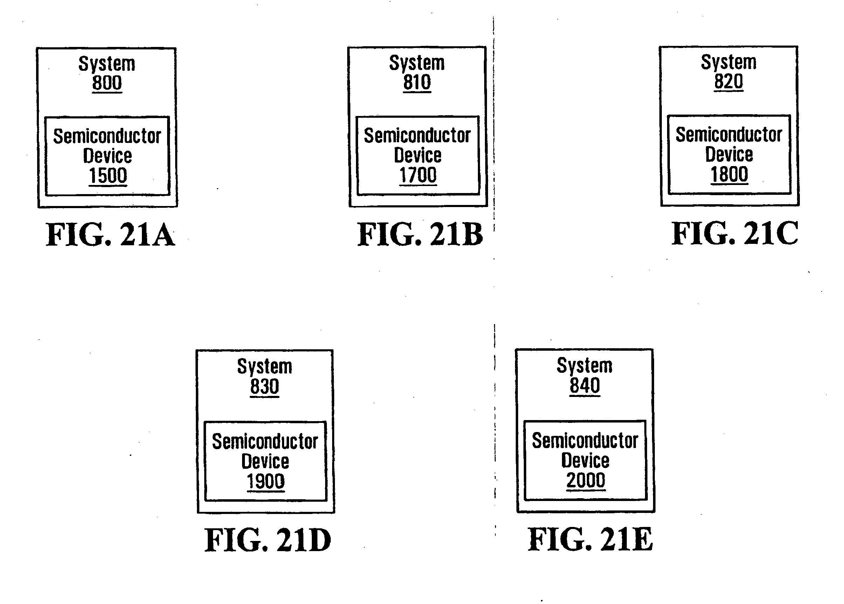

Reference is now made to Fig. 15, which shows a semiconductor device 1500 comprising a main memory unit 1512 and an auxiliary memory unit 1514, in accordance with a specific non-limiting embodiment. The semiconductor device 1500 may also comprise other components that are not illustrated. With reference to Fig. 21A, in accordance with specific non-limiting embodiments of the present invention, the semiconductor device 1500 can be embedded in a system 800. The system 800 may be, for example, an ASIC (application- specific integrated circuit) or a SoC (system on chip), to name a few non-limiting possibilities.

The main memory unit 1512 comprises a plurality of cells 1520. The auxiliary memory unit 1514 comprises a plurality of cells 1540 in the form of an array of rows and columns. The cells 1520 in the main memory unit 1512 can similarly be arranged in the form of an array. The cells 1540 in the auxiliary memory unit 1514 are each associated with a set of one or more cells 1520 in the main memory unit 1512. In the illustrated embodiment, which is provided for illustrative purposes only, the main memory unit 1512 has four (4) rows of six (6) columns of cells 1520, the auxiliary memory unit 1514 has four (4) rows of two (2) columns of cells 1540, and each cell in the auxiliary memory unit 1514 is associated with a set of three (3) cells in the main memory unit 1512. In other examples, one bit's worth of information in the auxiliary memory unit 1514 represents status information (such as, for example, validity, freshness, mask-worthiness, etc.) for one byte's worth of information in the main memory unit 1512. However, it is to be understood that there is no particular limitation on the number of rows or columns in the auxiliary memory unit 1514 or on the number of main memory unit cells in a set that is associated with an auxiliary unit cell.

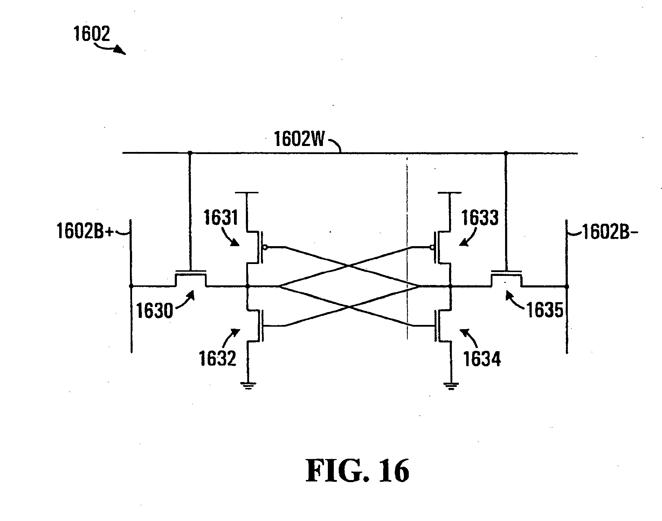

In a specific non-limiting embodiment, the cells 1540 of the auxiliary memory unit 1514 may comprise metal oxide semiconductor (MOS) static random access memory (SRAM) cells. Specifically, Fig. 16 shows a single-port SRAM cell 1602 having six (6) MOS transistors 1630, 1631, 1632, 1633, 1634, 1635, a wordline 1602W and two bitlines 1602B+, 1602B-. The cell 1602 can be read from or written to by controlling the wordline 1602W and the bitlines 1602B+, 1602B-. The wordline 1602W is set to high (i.e., "selected" or "asserted") for both read and write operations. For a read operation, both bitlines 1602B+ and 1602B- are sensed after they have been precharged to a high level. A high value on one of the bitlines 1602B+, 1602B- does not change the value in the cell 1602, instead the cell 1602 will pull one of the bitlines 1602B+, 1602B- low. Depending on which of the bitlines 1602B+, 1602B- is pulled low, this will be interpreted as either a logic "0" or a logic "1". For a write operation, one of the bitlines 1602B+, 1602B- is forced low, and the other is forced high. The low value overpowers the PMOS transistor (either 1631 or 1633) connected to the bitline that was forced low, which results in the cell 1602 being written to. Depending on which of the bitlines 1602B+, 1602B- was forced low, this will write either a logic "0" or a logic "1" to the cell 1602.

The cells 1520 of the main memory unit may similarly be SRAM cells. It is to be understood that other types of memory cells with a wordline and bitline structure can be employed in the main memory unit 1512 and the auxiliary memory unit 1514 without departing from the scope of certain embodiments the present invention. Examples of such other types of memory cells include dynamic random access memory (DRAM).

Returning now to Fig. 15, the semiconductor device 1500 comprises a plurality of wordlines 1542, each connected to a respective row of the cells 1540 of the auxiliary memory unit 1514. Row decoder circuitry 1546 its provided for control of the wordlines 1542. Specifcally, when a particular auxiliary memory unit cell (i.e., a particular one of the cells 1540 of the auxiliary memory unit 1514) is to be read from or written to, the wordline connected to the row in which that particular auxiliary memory unit cell is located is selected by row decoder circuitry 1546. Row decoder circuitry 1546 is operable in a normal mode of operation and in a preset mode of operation. In the normal mode of operation, row decoder circuitry 1546 selects an individual wordline among the plurality of wordlines 1542. In the preset mode of operation, row decoder circuitry 1546 jointly selects a group of two or more wordlines within the plurality of wordlines 1542. For more information regarding the selection of multiple wordlines, the reader is referred United States Provisional Patent Application Serial No. 61/213,990, filed August 5, 2009 and United States Patent Application Serial No. 12/564,492, filed on September 22, 2009, hereby incorporated by reference herein. The particular mode in which row decoder circuitry 1546 operates, as well as the identity of the row or rows containing cells to be read from or written to, is provided by control logic circuitry 1570.

The semiconductor device 1500 further comprises a plurality of bitlines 1544 each connected to a respective column of the cells 1540 of the auxiliary memory unit 1514. It is remarked that when single-port cells of the type shown in Fig. 16 are used in the auxiliary memory unit 1514, each of the auxiliary memory unit cells is connected to a pair of the bitlines 1544. Bitline control circuitry 1548 (e.g., including a driver and a sense amplifier) is provided for control of the bitlines 1544. Operation of bitline control circuitry 1548 differs depending on whether a read or write operation is being performed. For a write operation, bitline control circuitry 1548 is configured to drive the bitlines 1544 connected to a selected column of the auxiliary memory unit 1514 so that each cell in that column which is connected to a wordline that has been selected can be written to, i.e., set to a desired logic state (e.g., logic "0" or logic "1"). It should be appreciated that plural columns of the auxiliary memory unit 1514 may be selected either simultaneously or in sequence. The identity of the selected column or columns, as well as the value of the data to be written, is provided by the control logic circuitry 1570. A column or columns of the auxiliary memory unit 1514 are similarly identified by the control logic circuitry 1570 during a read operation.

The semiconductor device 1500 also comprises a plurality of wordlines 1522, each connected to a respective row of the cells 1520 of the main memory unit 1512. Row decoder circuitry 1526 is provided for control of the wordlines 1522. Specifically, when a particular main memory unit cell (i.e., a particular one of the cells 1520 of the main memory unit 1512) is to be read from or written to, the wordline connected to the row in which that particular main memory unit cell is located is selected by row decoder circuitry 1526. The identity of the row containing cells to be read from or written to is provided by the control logic circuitry 1570.

The semiconductor device 1500 further comprises a plurality of circuitry 1524 each connected to a respective column of the cells 1520 of the main memory unit 1512. It is remarked that when single-port cells of the type shown in Fig. 16 are used in the main memory unit 1512, each of the main memory unit cells is connected to a pair of the circuitry 1524. Bitline control circuitry 1528 is provided for control of the circuitry 1524. Operation of bitline control circuitry 1528 differs depending on whether a read or write operation is being performed. For a write operation, bitline control circuitry 1528 is configured to drive the circuitry 1524 connected to a selected column of the main memory unit 1512 so that each cell in that column which is connected to a wordline that has been selected can be written to, i.e., set to a desired logic state (e.g., logic "0" or logic "1"). It should be appreciated that plural columns of the main memory unit 1512 may be selected either simultaneously or in sequence. The identity of the selected column or columns, as well as the value of the data to be written, is provided by the control logic circuitry 1570. A column or columns of the main memory unit 1512 are similarly identified by the control logic circuitry 1570 during a read operation.

In operation, control logic circuitry 1570 processes commands received from an external entity, such as an off-chip controller (not shown). These commands can include a preset command, a write command and a read command, among others. In a non-limiting example, a preset command received from the external entity can indicate that the data in the main memory unit 1512 should be considered as being "stale", "mask-worthy" (i.e., requiring application of a mask), "not valid", etc.. Thereafter, a write command may be received from the external entity with the intention of writing data to a particular cell or group of cells in the main memory unit 1512, starting at a start address. In order to track the status (for example, valid or not valid, fresh or stale, mask-worthy or not mask-worthy, etc.) of the main memory unit cells (i.e., the cells 1520 in the main memory unit 1512), a set of one or more main memory unit cells is associated with a corresponding cell in the auxiliary memory unit 1514. The auxiliary memory unit cells can then each represent a single bit of information indicative of the particular status (e.g., valid or not valid, fresh or stale, mask-worthy or not mask-worthy, etc.) of a corresponding set of, say, three (3) main memory unit cells. Thus, it will be appreciated that at a given point in time, the external entity can establish the status of different cells in the main memory unit 1512 by reading from the auxiliary memory unit 1514. It is to be understood that the number of main memory unit 1512 cells in each set represented by a given one of the auxiliary memory unit cells is not limited to three (3) or any other specific value.

In response to receipt of the preset command, control logic circuitry 1570 performs a preset operation on the auxiliary memory unit 1514. The aim of the preset operation is to cause each of the cells 1540 in the auxiliary memory unit 1514 to acquire a particular logic state (e.g., logic "1") that is indicative of the corresponding set of cells in the main memory unit 1512 having a first particular status (for example, "not valid", "stale", "mask-worthy", etc.). To this end, the control logic circuitry 1570 identifies a group of two or more rows of the auxiliary memory unit 1514 to row decoder circuitry 1546 and places row decoder circuitry 1546 in the aforementioned preset mode of operation, thereby resulting in the selection of a group of wordlines corresponding to the two or more identified rows. If row decoder circuitry 1546 is configured to automatically select all of the wordlines 1542 when placed in the preset mode of operation, then there is no need to explicitly identify the group of two or more rows to row decoder circuitry 1546, since their identification will be implicit by the act of placing row decoder circuitry 1546 in the preset mode of operation.

Having placed row decoder circuitry 1546 in the preset mode of operation, the control logic circuitry 1570 controls bitline control circuitry 1548 so as to ultimately set each of the auxiliary cells 1540 to the particular logic state (in this case, logic "1"). In an example, assuming that a number of wordlines 1542 has been jointly selected through action of row decoder circuitry 1546, the bitlines 1544 for a single column can be controlled by the control logic circuitry 1570 so as to simultaneously set all cells in that column, which are connected to a wordline that has been selected, to logic "1". The process can then be repeated for a next column, and so on. In another example, the bitlines 1544 for plural columns can be controlled so as to simultaneously set all cells in each of those columns, which are connected to a wordline that has been selected, to logic "1".

If the number of jointly selected wordlines is less than all of the wordlines 1542, then the aforementioned bitline control process is repeated for a new set of wordlines. Ultimately, all the cells 1540 in the auxiliary memory unit 1514 will have acquired the particular logic state (in this case, logic "1") indicative of the cells 1520 in the main memory unit 1512 having the first particular status (e.g., "not valid", "stale", "mask-worthy", etc.), and the preset operation is said to be complete.

At this stage, the writing of input data to the main memory unit 1512 can proceed. To this end, the control logic circuitry 1570 processes a write command which can identify a start address in the main memory unit 1512 and can contain data to be written, starting at the start address. The start address is represented by a particular cell located at a particular row and a particular column in the main memory unit 1512, and is thus associated with a particular wordline and a particular pair of bitlines. The control logic circuitry 1570 identifies the particular row to row decoder circuitry 1526. The control logic circuitry 1570 then controls bitline control circuitry 1528 so that the particular pair of bitlines will set the particular main memory unit cell to a logic state that corresponds to the value of the input data being written to the start address. Additional control of the circuitry 1524 and the wordlines 1522 is carried out for other ones of the cells 1520 being subsequently written to. This will result in a certain number of main memory unit cells having been written to with data having a second particular status (e.g., "valid", "fresh", "not mask-worthy", etc.).

In order to record the change in status of these main memory unit cells, the control logic circuitry 1570 ensures that the contents of the auxiliary memory unit cells that correspond to the main memory unit cells that were written to are toggled to a logic state (e.g., logic "0") that is indicative of data having the second particular status (rather than the first particular status acquired previously). To this end, the control logic circuitry 1570 determines the specific row and specific column of the auxiliary memory unit cell whose corresponding set of main memory unit cells includes the particular cell at the start address mentioned above. The control logic circuitry 1570 identifies the specific row to row decoder circuitry 1546 and places row decoder circuitry 1546 in the normal mode of operation, resulting in selection of a specific one of the wordlines 1542 in the auxiliary memory unit 1514. The control logic circuitry 1570 then controls bitline control circuitry 1548 so that a specific pair of bitlines corresponding to the specific column will set to logic "0" the auxiliary memory unit cell whose corresponding set of main memory unit cells includes the particular cell at the start address. The change in status of this corresponding set of main memory unit cells is thus recorded, and the process is repeated for other auxiliary memory unit cells for which the corresponding sets of cells in the main memory unit were also written to.

It should be appreciated that the control logic circuitry 1570 can combine the cells 1540 in the auxiliary memory unit 1514 with the cells 1520 in the main memory unit 1512 in any desired way. For example, a masking operation may be performed so as to individually logically combine (e.g., in an AND operation, an OR operation, an XOR operation, etc.) the logic value of each of the cells 1540 in the auxiliary memory unit 1514 with the logic value of each of the cells 1520 in the associated set of cells in the main memory unit 1512, resulting in a new set of logic values. In such a way, the cells 1540 in the auxiliary memory unit 1514 can be used as a mask for sets of cells 1520 in the main memory unit 1512. Such a masking operation may be useful when transferring information to a virtual page buffer in a non-volatile memory device, so as to prevent unwanted writing of memory elements in the non-volatile memory device.

Subsequent write operations will similarly impact other sets of main memory unit cells and their corresponding cells 1540 in the auxiliary memory unit 1514. In the case where a given cell in the main memory unit 1512 is deemed to be "valid", "fresh" or "not mask-worthy" (by virtue of the logic value of the corresponding cell in the auxiliary memory unit 1514), it may continue to be deemed "valid", "fresh" or "not mask-worthy" even as it is rewritten with other data, until the next preset operation occurs. Alternatively, the status may change back to the first particular status (for example, "not valid", "stale", "mask-worthy", etc.) as soon as it is rewritten.

It should be appreciated that the main and auxiliary memory units 1512, 1514 can be implemented as independent entities that are under control of the control logic circuitry 1570. Thus, for example, separate compiler routines can be written to custom define the main memory unit 1512 and the auxiliary memory unit 1514. This allows the dimensionality of the main memory unit 1512 and the auxiliary memory unit 1514 to be chosen independently, irrespective of parameters such as the number of main memory unit cells in each set corresponding to an auxiliary unit cell.

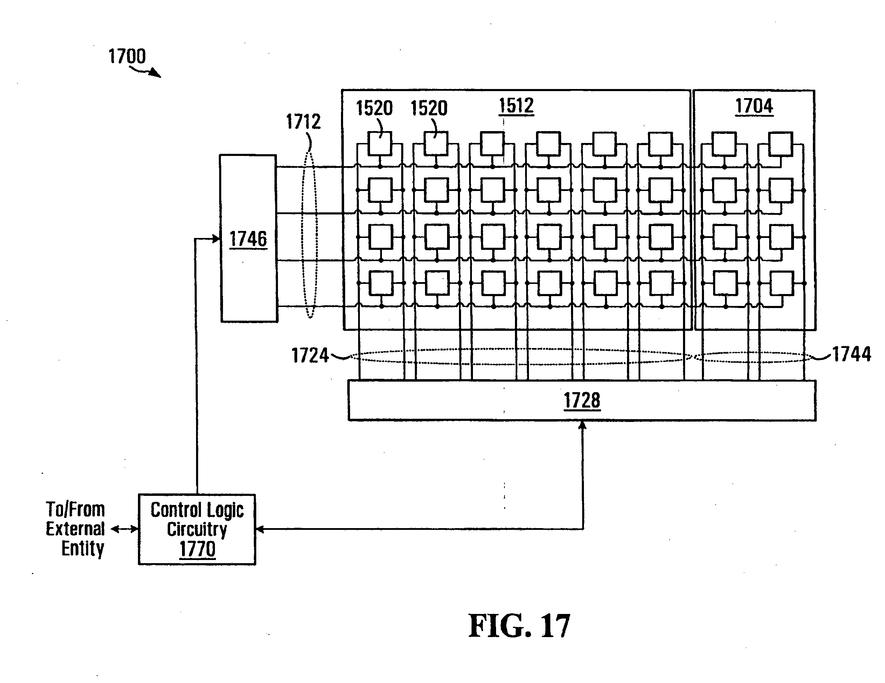

In another embodiment, it is possible to define a single memory structure that includes the main memory unit and the auxiliary memory unit as closely interconnected components, which can lead to economies of semiconductor chip real estate. To this end, reference is made to Fig. 17, which shows a semiconductor device 1700 with the aforementioned main memory unit 1512 and an auxiliary memory unit 1704 each having the same number of rows and a number of columns that may differ. With reference to Fig. 21B, in accordance with specific non-limiting embodiments of the present invention, the semiconductor device 1700 can be embedded in a system 810. The system 810 may be, for example, an ASIC (application-specific integrated circuit) or a SoC (system on chip), to name a few non-limiting possibilities.

In the illustrated embodiment, which is provided for illustrative purposes only, the main memory unit 1512 has four (4) rows of six (6) columns of cells, the auxiliary memory unit 1704 has four (4) rows of two (2) columns of cells, and each cell in the auxiliary memory unit 1704 is associated with a set of three (3) cells in the main memory unit 1512. In other examples, one bit's worth of information in the auxiliary memory unit 1704 represents status information (such as, for example, validity, freshness, mask-worthiness, etc.) for one byte's worth of information in the main memory unit 1512. However, it is to be understood that there is no particular limitation on the number of rows or columns or on the number of main memory unit cells in a set that is associated with an auxiliary unit cell.

Due to the fact that the number of rows is the same, a plurality of shared wordlines 1712 is provided, the wordlines 1712 being shared between the main memory unit 1512 and the auxiliary memory unit 1704. That is to say, if a given one of the wordlines 1712 is connected to a given row of auxiliary memory unit cells containing a particular auxiliary memory unit cell, it is also connected to the row of main memory unit cells that includes the set of main memory unit cells corresponding to that particular auxiliary memory unit cell.

In the embodiment of Fig. 17, row decoder circuitry 1746 is provided for control of only one set of wordlines, namely wordlines 1712 which are shared between the main memory unit 1512 and the auxiliary memory unit 1704. Specifically, when a particular cell of the main memory unit 1512 or the auxiliary memory unit 1704 is to be read from or written to, the wordline connected to the row in which that particular cell is located is selected by row decoder circuitry 1746. Row decoder circuitry 1746 is operable in a normal mode of operation and in a preset mode of operation. In the normal mode of operation, row decoder circuitry 1746 selects an individual wordline among the plurality of wordlines 1712. In the preset mode of operation, row decoder circuitry 1746 jointly selects a group of two or more wordlines within the plurality of wordlines 1712. The particular mode in which row decoder circuitry 1746 operates, as well as the identity of the row or rows containing the cell to be read from or written to, is controlled by control logic circuitry 1770.

The semiconductor device 1700 also comprises a plurality of main bitlines 1724 each connected to a respective column of the cells of the main memory unit 1512 and a plurality of auxiliary bitlines 1744 each connected to a respective column of the cells of the auxiliary memory unit 1704. It is remarked that when single-port cells of the type shown in Fig. 16 are used in the main memory unit 1512 (or the auxiliary memory unit 1704), each of the main memory unit cells (or auxiliary memory unit cells) is connected to a pair of the main bitlines 1724 (or the auxiliary bitlines 1744). Bitline control circuitry 1728 is provided for control of the main bitlines 1724 and the auxiliary bitlines 1744. Operation of bitline control circuitry 1728 differs depending on whether a read or write operation is being performed. For a write operation, bitline control circuitry 1728 is configured to drive the main bitlines 1724 (or the auxiliary bitlines 1744) connected to a selected column of the main memory unit 1512 (or the auxiliary memory unit 1704) so that each cell in that column which is connected to a wordline that has been selected can be written to, i.e., set to a desired logic state (e.g., logic "0" or logic "1"). It should be appreciated that plural columns, from one or both of the main memory unit 1512 and the auxiliary memory unit 1704, may be selected either simultaneously or in sequence. The identity of the selected column or columns, as well as the value of the data to be written, is provided by the control logic circuitry 1770. A column or columns of the auxiliary memory unit 1704 are similarly identified by the control logic circuitry 1770 during a read operation.

In operation, control logic circuitry 1770 processes commands received from an external entity, such as an off-chip controller (not shown). These commands can include a preset command, a write command and a read command, among others. In a non-limiting example, a preset command received from the external entity can indicate that the data in the main memory unit 1512 should be considered as being "stale", "mask-worthy" (i.e., requiring application of a mask), "not valid", etc.. Thereafter, a write command may be received from the external entity with the intention of writing data to a particular cell or group of cells in the main memory unit 1512, starting at a start address. In order to track the status (for example, valid or not valid, fresh or stale, mask-worthy or not mask-worthy, etc.) of the main memory unit cells (i.e., the cells in the main memory unit 1512), a set of one or more main memory unit cells is associated with a corresponding cell in the auxiliary memory unit 1704. The auxiliary memory unit cells can each represent a single bit of information indicative of the particular status (e.g., valid or not valid, fresh or stale, mask-worthy or not mask-worthy, etc.) of a corresponding set of, say, three (3) main memory unit cells. Thus, it will be appreciated that at a given point in time, the external entity can establish the status of different cells in the main memory unit 1512 by reading from the auxiliary memory unit 1704. It is to be understood that the number of cells of the main memory unit 1512 represented by each of the cells in the auxiliary memory unit 1704 is not limited to three (3) or any other specific value.

In response to receipt of the preset command, control logic circuitry 1770 performs a preset operation on the auxiliary memory unit 1704. The aim of the preset operation is to cause each of the cells in the auxiliary memory unit 1704 to acquire a particular logic state (e.g., logic "1") that is indicative of the corresponding set of cells in the main memory unit 1512 having a first particular status (for example, "not valid", "stale", "mask-worthy", etc.). To this end, the control logic circuitry 1770 identifies a group of two or more rows of the auxiliary memory unit 1704 to row decoder circuitry 1746 and places row decoder circuitry 1746 in the aforementioned preset mode of operation, thereby resulting in the selection of a group of wordlines corresponding to the two or more identified rows. If row decoder circuitry 1546 is configured to automatically seled all of the wordlines 1712 when placed in the preset mode of operation, there is no need to explicitly identify the group of two or more rows to row decoder circuitry 1746, since their identification will be implicit by the act of placing row decoder circuitry 1746 in the preset mode of operation.

Having placed row decoder circuitry 1746 in the preset mode of operation, the control logic circuitry 1770 controls bitline control circuitry 1728 so as to ultimately set each of the auxiliary cells to the particular logic state (in this case, logic "1"). In an example, assuming that a number of wordlines 1712 has been jointly selected through action of row decoder circuitry 1746, the auxiliary bitlines 1744 for a single column can be controlled by the control logic circuitry 1770 so as to simultaneously set all cells in that column, which are connected to a wordline that has been selected, to logic "1". The process can then be repeated for a next column, and so on. In another example, the auxiliary bitlines 1744 for plural columns can be controlled so as to simultaneously set all cells in each of those columns, which are connected to a wordline that has been selected, to logic "1".

If the number of jointly selected wordlines is less than all of the wordlines 1712, then the aforementioned bitline control process is repeated for a new set of wordlines. Ultimately, all the cells in the auxiliary memory unit 1704 will have acquired the particular logic state (in this case, logic "1") indicative of the cells in the main memory unit 1512 having the first particular status (for example, "not valid", "stale", "mask-worthy", etc.), and the preset operation is said to be complete.

At this stage, the writing of input data to the main memory unit 1512 can proceed. To this end, the control logic circuitry 1770 processes a write command which can identify a start address in the main memory unit 1512 and can contain data to be written, starting at the start address. The start address is represented by a particular main memory unit cell located at a particular row and a particular column in the main memory unit 1512, and is thus associated with a particular wordline and a particular pair of main bitlines. The control logic circuitry 1770 identifies the particular row to row decoder circuitry 1746. The control logic circuitry 1770 places row decoder circuitry 1746 in the normal mode of operation, thereby resulting in the selection of the particular wordline mentioned above. The control logic circuitry 1770 then controls bitline control circuitry 1728 so that the particular pair of main bitlines 1724 will set the particular cell to a logic state that corresponds to the value of the input data being written to the start address. In addition, the control logic circuitry 1770 ensures that the contents of the auxiliary memory unit cell that corresponds to the particular main memory unit cell that was written to is toggled to a different logic state (e.g., logic "0") that is indicative of data having a second particular status (e.g., "valid", "fresh", "not mask-worthy", etc.). This is done by determining the pair of auxiliary bitlines corresponding to the particular column of the particular main memory unit cell, while the same wordline remains selected. The control logic circuitry 1770 then controls bitline control circuitry 1728 so as to set to logic "0" the auxiliary memory unit cell whose corresponding set of main memory unit cells includes the particular main memory unit cell. It should be appreciated that because the same wordline remains selected, it is possible, although not essential, that the bitline control circuitry 1728 simultaneously (or substantially simultaneously) controls a pair of main bitlines 1724 and an associated pair of auxiliary bitlines 1744, thereby writing to the main memory unit 1512 and the auxiliary memory unit 1704 at the same time.

The above-mentioned process is then repeated for other cells in the main memory unit 1512 subsequently being written to, as well as for their corresponding cells in the auxiliary memory unit 1704.

It should be appreciated that the control logic circuitry 1770 can combine the cells in the auxiliary memory unit 1704 with the cells 1520 in the main memory unit 1512 in any desired way. For example, a masking operation may be performed so as to individually logically combine (e.g., in an AND operation, an OR operation, an XOR operation, etc.) the logic value of each of the cells in the auxiliary memory unit 1704 with the logic value of each of the cells 1520 in the associated set of cells in the main memory unit 1512, resulting in a new set of logic values. In such a way, the cells in the auxiliary memory unit 1704 can be used as a mask for sets of cells 1520 in the main memory unit 1512. Such a masking operation may be useful when transferring information to a virtual page buffer in a non-volatile memory device, so as to prevent unwanted writing of memory elements in the non-volatile memory device.

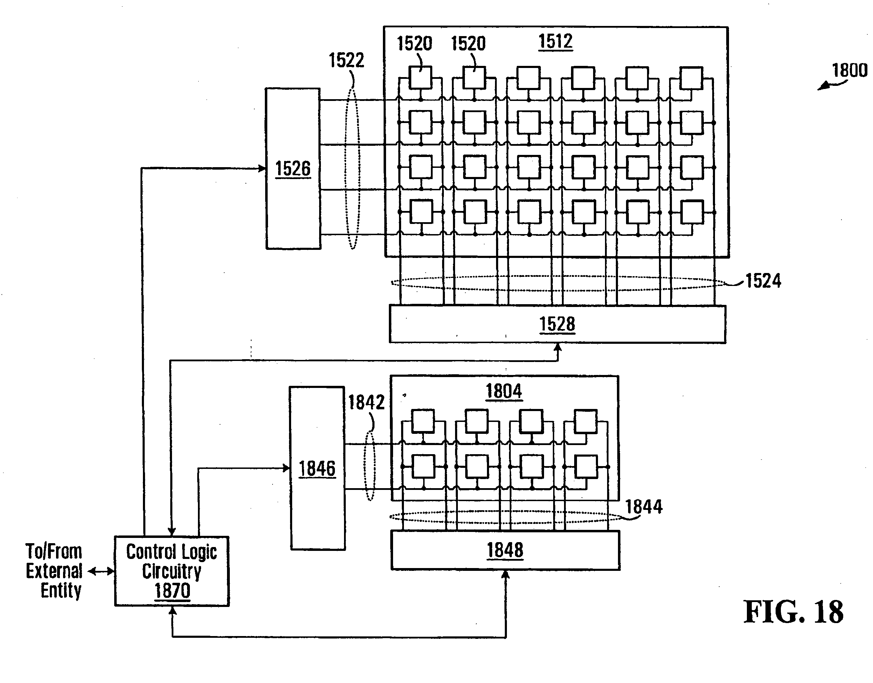

In accordance with another specific non-limiting embodiment, the auxiliary memory unit has fewer wordlines than the main memory unit. In particular, with reference to Fig. 18, there is shown a semiconductor device 1800 with the aforementioned main memory unit 1512 and an auxiliary memory unit 1804. With reference to Fig. 21C, in accordance with specific non-limiting embodiments of the present invention, the semiconductor device 1800 can be embedded in a system 820. The system 820 may be, for example, an ASIC (application-specific integrated circuit) or a SoC (system on chip), to name a few non-limiting possibilities.

The main memory unit 1512 has four (4) rows of six (6) columns of cells, the auxiliary memory unit 1804 has two (2) rows of four (4) columns of cells, and each cell in the auxiliary memory unit 1804 is associated with a set of three (3) cells in the main memory unit 1512. In other examples, one bit's worth of information in the auxiliary memory unit 1804 represents status information (such as, for example, validity, freshness, mask-worthiness, etc.) for one byte's worth of information in the main memory unit 1512. Generally speaking, in this embodiment, the main memory unit 1512 has N1 rows of M1 columns of cells, the auxiliary memory unit 1804 has N2 rows of M2 columns of cells and each cell in the auxiliary memory unit 1804 is associated with a set of Z cells in the main memory unit 1512, where Z is greater than or equal to 1. A feature of this specific non-limiting embodiment is that N2 is less than N1, i.e., the auxiliary memory unit 1804 has fewer rows than the main memory unit 1512, while the number of columns M2 in the auxiliary memory unit 1804 is greater than M1/Z. Otherwise, there is no particular limitation on the values of M1, N1, M2, N2 or Z.

The semiconductor device 1800 further comprises the aforementioned plurality of wordlines 1522, each connected to a respective row of the cells of the main memory unit 1512. Row decoder circuitry 1526 is provided for control of the wordlines 1522. Specifically, when a particular main memory unit cell is to be read from or written to, the wordline connected to the row in which that particular main memory unit cell is located is selected by row decoder circuitry 1526. The identity of the row containing cells to be read from or written to is provided by control logic circuitry 1870.

The semiconductor device 1800 also comprises the aforementioned plurality of circuitry 1524 each connected to a respective column of the cells of the main memory unit 1512. It is remarked that when single-port cells of the type shown in Fig. 16 are used in the main memory unit 1512, each of the main memory unit cells is connected to a pair of the circuitry 1524. Bitline control circuitry 1528 is provided for control of the circuitry 1524. Operation of bitline control circuitry 1528 differs depending on whether a read or write operation is being performed. For a write operation, bitline control circuitry 1528 is configured to drive the circuitry 1524 connected to a selected column of the main memory unit 1512 so that each cell in that column which is connected to a wordline that has been selected can be written to, i.e., set to a desired logic state (e.g., logic "0" or logic "1"). It should be appreciated that plural columns of the main memory unit 1512 may be selected either simultaneously or in sequence. The identity of the selected column or columns, as well as the value of the data to be written, is provided by the control logic circuitry 1870. A column or columns of the main memory unit 1512 are similarly identified by the control logic circuitry 1870 during a read operation.

The semiconductor device 1800 further comprises a plurality of wordlines 1842, each connected to a respective row of the cells of the auxiliary memory unit 1804. Row decoder circuitry 1846 is provided for control of the wordlines 1842. Specifically, when a particular auxiliary memory unit cell is to be read from or written to, the wordline connected to the row in which that particular auxiliary memory unit cell is located is selected by row decoder circuitry 1846. Row decoder circuitry 1846 is operable to select an individual wordline among the plurality of wordlines 1842.

The semiconductor device 1800 further comprises a plurality of bitlines 1844 each connected to a respective column of the cells of the auxiliary memory unit 1804. It is remarked that when single-port cells of the type shown in Fig. 16 are used in the auxiliary memory unit 1804, two of the bitlines 1844 are connected to each column. Bitline control circuitry 1848 is provided for control of the bitlines 1844. Operation of bitline control circuitry 1848 differs depending on whether a read or write operation is being performed. For a write operation, bitline control circuitry 1848 is configured to drive the bitlines 1844 connected to a selected column of the auxiliary memory unit 1804 so that each cell in that column which is connected to a wordline that has been selected can be written to, i.e., set to a desired logic state (e.g., logic "0" or logic "1"). It should be appreciated that plural columns of the auxiliary memory unit 1804 may be selected either simultaneously or in sequence. The identity of the selected column or columns, as well as the value of the data to be written, is provided by the control logic circuitry 1870. A column or columns of the auxiliary memory unit 1804 are similarly identified by the control logic circuitry 1870 during a read operation.

In operation, control logic circuitry 1870 processes commands received from an external entity, such as an off-chip controller (not shown). These commands can include a preset command, a write command and a read command, among others. In a non-limiting example, a preset command received from the external entity can indicate that the data in the main memory unit 1512 should be considered as being "stale", "mask-worthy" (i.e., requiring application of a mask), "not valid", etc.. Thereafter, a write command may be received from the external entity with the intention of writing data to a particular cell or group of cells in the main memory unit 1512, starting at a start address. In order to track the status (for example, valid or not valid, fresh or stale, mask-worthy or not mask-worthy, etc.) of the main memory unit cells, a set of one or more main memory unit cells is associated with a corresponding cell in the auxiliary memory unit 1804. The auxiliary memory unit cells can then each represent a single bit of information indicative of the particular status (e.g., valid or not valid, fresh or stale, mask-worthy or not mask-worthy, etc.) of a corresponding set of, say, three (3) main memory unit cells. Thus, it will be appreciated that at a given point in time, the external entity can establish the status of different cells in the main memory unit 1512 by reading from the auxiliary memory unit 1804. It is to be understood that the number of main memory unit 1512 cells in each set represented by a given one of the auxiliary memory unit cells is not limited to three (3) or any other specific value.

In response to receipt of the preset command, control logic circuitry 1870 performs a preset operation on the auxiliary memory unit 1804. The aim of the preset operation is to cause each of the cells in the auxiliary memory unit 1804 to acquire a particular logic state (e.g., logic "1") that is indicative of the corresponding set of cells in the main memory unit 1512 having a first particular status (for example, "not valid", "stale", "mask-worthy", etc.). To this end, the control logic circuitry 1870 identifies a first row of the auxiliary memory unit 1804 to row decoder circuitry 1846, thereby resulting in the selection of a particular one of the wordlines 1842 corresponding to the identified row. The control logic circuitry 1870 then controls bitline control circuitry 1848 so as to set each auxiliary memory unit cell connected to the particular wordline to the particular logic state (in this case, logic "1"). In an example, the bitlines 1844 can be controlled by the control logic circuitry 1870 in a column-by-column fashion, or several columns at a time, or all simultaneously. This is then repeated for all the rows of the auxiliary memory unit 1804 until all the cells in the auxiliary memory unit 1804 have acquired the particular logic state (in this case, logic "1") indicative of the cells in the main memory unit 1512 having the first particular status (e.g., "not valid", "stale", "mask-worthy", etc.). At this point, the preset operation is said to be complete. It is noted that because N2 < N1 and M2 > M1/Z, there are fewer rows of the auxiliary memory unit 1804 to go through during the preset operation, which can accelerate the preset operation.

At this stage, the writing of input data to the main memory unit 1512 can proceed. To this end, the control logic circuitry 1870 processes a write command which can identify a start address in the main memory unit 1512 and can contain data to be written, starting at the start address. The start address is represented by a particular cell located at a particular row and a particular column in the main memory unit 1512, and is thus associated with a particular wordline and a particular pair of bitlines. The control logic circuitry 1870 identifies the particular row to row decoder circuitry 1526. The control logic circuitry 1870 then controls bitline control circuitry 1528 so that the particular pair of bitlines will set the particular main memory unit cell to a logic state that corresponds to the value of the input data being written to the start address. Additional control of the circuitry 1524 and the wordlines 1522 is carried out for other main memory unit cells being subsequently written to.

In order to record the change in status of these main memory unit cells, the control logic circuitry 1870 ensures that the contents of the auxiliary memory unit cells that correspond to the main memory unit cells that were written to are toggled to a logic state (e.g., logic "0") that is indicative of data having the second particular status (rather than the first particular status acquired previously). To this end, the control logic circuitry 1870 determines the specific row and specific column of the auxiliary memory unit cell whose corresponding set of main memory unit cells includes the particular cell at the start address mentioned above. The control logic circuitry 1870 identifies the specific row to row decoder circuitry 1846, resulting in selection of a specific one of the wordlines 1842 in the auxiliary memory unit 1804. The control logic circuitry 1870 then controls bitline control circuitry 1848 so that a specific pair of bitlines corresponding to the specific column will set to logic "0" the auxiliary memory unit cell whose corresponding set of main memory unit cells includes the particular cell at the start address. The change in status of this corresponding set of main memory unit cells is thus recorded, and the process is repeated for other auxiliary memory unit cells for which the corresponding sets of cells in the main memory unit were also written to.

It should be appreciated that the control logic circuitry 1870 can combine the cells in the auxiliary memory unit 1804 with the cells 1520 in the main memory unit 1512 in any desired way. For example, a masking operation may be performed so as to individually logically combine (e.g., in an AND operation, an OR operation, an XOR operation, etc.) the logic value of each of the cells in the auxiliary memory unit 1804 with the logic value of each of the cells 1520 in the associated set of cells in the main memory unit 1512, resulting in a new set of logic values. In such a way, the cells 1804 in the auxiliary memory unit 1804 can be used as a mask for sets of cells 1520 in the main memory unit 1512. Such a masking operation may be useful when transferring information to a virtual page buffer in a non-volatile memory device, so as to prevent unwanted writing of memory elements in the non-volatile memory device.

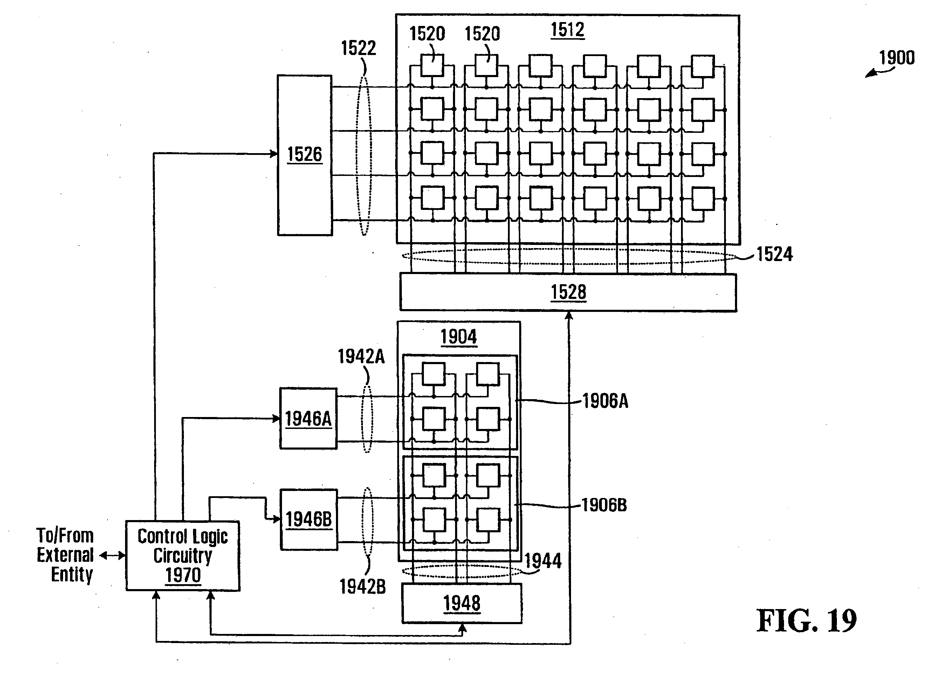

In accordance with another specific non-limiting embodiment, the auxiliary memory unit includes plural sub-units that can be independently controlled. In particular, with reference to Fig. 19, there is shown a semiconductor device 1900 with the aforementioned main memory unit 1512 and an auxiliary memory unit 1904. With reference to Fig. 21D, in accordance with specific non-limiting embodiments of the present invention, the semiconductor device 1900 can be embedded in a system 830. The system 830 may be, for example, an ASIC (application-specific integrated circuit) or a SoC (system on chip), to name a few non-limiting possibilities.

The main memory unit 1512 has four (4) rows of six (6) columns of cells, while the auxiliary memory unit 1904 includes two sub-units 1906A, 1906B, each with two (2) rows of two (2) columns of cells. It is to be understood, however, that there may be a greater number of sub-units and they need not all have the same dimensions. Also for illustrative purposes, each cell in each of the sub-units 1906A, 1906B is associated with a set of three (3) cells in the main memory unit 1512. In other examples, one bit's worth of information in the auxiliary memory unit 1904 represents status information (such as, for example, validity, freshness, mask-worthiness, etc.) for one byte's worth of information in the main memory unit 1512. However, it is to be understood that there is no particular limitation on the number of rows or columns or on the number of main memory unit cells in a set that is associated with individual cells of the sub-units 1906A, 1906B.

The semiconductor device 1900 further comprises the aforementioned plurality of wordlines 1522, each connected to a respective row of the cells of the main memory unit 1512. Row decoder circuitry 1526 is provided for control of the wordlines 1522. Specifically, when a particular main memory unit cell is to be read from or written to, the wordline connected to the row in which that particular main memory unit cell is located is selected by row decoder circuitry 1526. The identity of the row containing cells to be read from or written to is provided by control logic circuitry 1970.

The semiconductor device 1900 also comprises the aforementioned plurality of circuitry 1524 each connected to a respective column of the cells of the main memory unit 1512. It is remarked that when single-port cells of the type shown in Fig. 16 are used in the main memory unit 1512, two of the circuitry 1524 are connected to each column. Bitline control circuitry 1528 is provided for control of the circuitry 1524. Operation of bitline control circuitry 1528 differs depending on whether a read or write operation is being performed. For a write operation, bitline control circuitry 1528 is configured to drive the circuitry 1524 connected to a selected column of the main memory unit 1512 so that each cell in that column which is connected to a wordline that has been selected can be written to, i.e., set to a desired logic state (e.g., logic "0" or logic "1"). It should be appreciated that plural columns of the main memory unit 1512 may be selected either simultaneously or in sequence. The identity of the selected column or columns, as well as the value of the data to be written, is provided by the control logic circuitry 1970. A column or columns of the main memory unit 1512 are similarly identified by the control logic circuitry 1970 during a read operation.

The semiconductor device 1900 further comprises a plurality of wordlines 1942A, each connected to respective row of the cells of sub-unit 1906A. Row decoder circuitry 1946A is provided for control of the wordlines 1942A. Specifically, when a particular auxiliary memory unit cell in sub-unit 1906A is to be read from or written to, the wordline connected to the row in which that particular auxiliary memory unit cell is located is selected by row decoder circuitry 1946A. Row decoder circuitry 1946A is operable to select an individual wordline among the plurality of wordlines 1942A.

Analogously, the semiconductor device 1900 further comprises a plurality of wordlines 1942B, each connected to a respective row of the cells of sub-unit 1906B. Row decoder circuitry 1946B is provided for control of the wordlines 1942B. Specifically, when a particular auxiliary memory unit cell in sub-unit 1906B is to be read from or written to, the wordline connected to the row in which that particular auxiliary memory unit cell is located is selected by row decoder circuitry 1946B. Row decoder circuitry 1946B is operable to select an individual wordline among the plurality of wordlines 1942B.

The semiconductor device 1900 further comprises a plurality of bitlines 1944 each connected to a respective column of the cells of sub-unit 1906A. In accordance with this non-limiting embodiment, each of the bitlines 1944 is also connected to a respective column of the cells of sub-unit 1906A. It is remarked that when single-port cells of the type shown in Fig. 16 are used in the auxiliary memory unit 1904, two of the bitlines 1944 are connected to each of two columns of cells, one in sub-unit 1906A and its counterpart in sub-unit 1906B. Thus, it can be said that the bitlines 1944 span plural sub-units. Bitline control circuitry 1948 is provided for control of the bitlines 1944. Operation of bitline control circuitry 1948 differs depending on whether a read or write operation is being performed. For a write operation, bitline control circuitry 1948 is configured to drive the bitlines 1944 connected to a selected column of the sub-unit 1906A (and its counterpart column in sub-unit 1906B) so that each cell in those columns which is connected to a wordline that has been selected can be written to, i.e., set to a desired logic state (e.g., logic "0" or logic "1"). It should be appreciated that plural columns of sub-unit 1906A may be selected either simultaneously or in sequence, while their counterpart columns in sub-unit 1906B are also jointly selected. The identity of the selected column or columns in sub-unit 1906A (and its counterpart column or columns in sub-unit 1906B), as well as the value of the data to be written, is provided by the control logic circuitry 1970. A column or columns of sub-unit 1906A (and its counterpart column or columns in sub-unit 1906B) are similarly identified by the control logic circuitry 1970 during a read operation.

In operation, control logic circuitry 1970 processes commands received from an external entity, such as an off-chip controller (not shown). These commands can include a preset command, a write command and a read command, among others. In a non-limiting example, a preset command received from the external entity can indicate that the data in the main memory unit 1512 should be considered as being "stale", "mask-worthy" (i.e., requiring application of a mask), "not valid", etc.. Thereafter, a write command may be received from the external entity with the intention of writing data to a particular cell or group of cells in the main memory unit 1512, starting at a start address. In order to track the status (for example, valid or not valid, fresh or stale, mask-worthy or not mask-worthy, etc.) of the main memory unit cells, a set of one or more main memory unit cells is associated with a corresponding cell in one of the sub-units 1906A, 1906B of the auxiliary memory unit 1904. The auxiliary memory unit cells can then each represent a single bit of information indicative of the particular status (e.g., valid or not valid, fresh or stale, mask-worthy or not mask-worthy, etc.) of a corresponding set of, say, three (3) main memory unit cells. Thus, it will be appreciated that at a given point in time, the external entity can establish the status of different cells in the main memory unit 1512 by reading from the auxiliary memory unit 1904. It is to be understood that the number of main memory unit 1512 cells in each set represented by a given one of the auxiliary memory unit cells is not limited to three (3) or any other specific value.

In response to receipt of the preset command, control logic circuitry 1970 performs a preset operation on the auxiliary memory unit 1904. The aim of the preset operation is to cause each of the cells in the sub-units 1906A, 1906B to acquire a particular logic state (e.g., logic "1") that is indicative of the corresponding set of cells in the main memory unit 1512 having a first particular status (for example, "not valid", "stale", "mask-worthy", etc.). To this end, the control logic circuitry 1970 identifies a first row of sub-unit 1906A to row decoder circuitry 1946A and a first row of sub-unit 1906B to row decoder circuitry 1946B, thereby resulting in the selection of a pair of wordlines, one each among the wordlines 1942A and the wordlines 1942B. The control logic circuitry 1970 then controls bitline control circuitry 1948 so as to simultaneously set each auxiliary memory unit cell connected to the particular pair of wordlines to the particular logic state (in this case, logic "1"). In an example, the bitlines 1944 can be controlled by the control logic circuitry 1970 in a column-by-column fashion, or several columns at a time, or all simultaneously. This is then repeated for another pair of rows in the sub-units 1906A, 1906B, and so on, until all the cells in the auxiliary memory unit 1904 have acquired the particular logic state (in this case, logic "1") indicative of the cells in the main memory unit 1512 having the first particular status (e.g., "not valid", "stale", "mask-worthy", etc.). At this point, the preset operation is said to be complete.

At this stage, the writing of input data to the main memory unit 1512 can proceed. To this end, the control logic circuitry 1970 processes a write command which can identify a start address in the main memory unit 1512 and can contain data to be written, starting at the start address. The start address is represented by a particular cell located at a particular row and a particular column in the main memory unit 1512, and is thus associated with a particular wordline and a particular pair of bitlines. The control logic circuitry 1970 identifies the particular row to row decoder circuitry 1526. The control logic circuitry 1970 then controls bitline control circuitry 1528 so that the particular pair of bitlines will set the particular main memory unit cell to a logic state that corresponds to the value of the input data being written to the start address. Additional control of the circuitry 1524 and the wordlines 1522 is carried out for other main memory unit cells being subsequently written to.

In order to record the change in status of these main memory unit cells, the control logic circuitry 1970 ensures that the contents of the auxiliary memory unit cells that correspond to the main memory unit cells that were written to are toggled to a logic state (e.g., logic "0") that is indicative of data having a second particular status (rather than the first particular status acquired previously). To this end, the control logic circuitry 1970 determines the specific sub-unit, the specific row and the specific column of the auxiliary memory unit cell whose corresponding set of main memory unit cells includes the particular cell at the start address mentioned above. If the specific sub-unit is sub-unit 1906A, the control logic circuitry 1970 identifies the specific row to row decoder circuitry 1946A, resulting in selection of a specific one of the wordlines 1942A in sub-unit 1906A. Analogously, if the specific sub-unit is sub-unit 1906B, the control logic circuitry 1970 identifies the specific row to row decoder circuitry 1946B, resulting in selection of a specific one of the wordlines 1942B in sub-unit 1906B. The control logic circuitry 1970 then controls bitline control circuitry 1948 so that a specific pair of bitlines corresponding to the specific column will set to logic "0" the auxiliary memory unit cell whose corresponding set of main memory unit cells includes the particular cell at the start address. The change in status of this corresponding set of main memory unit cells is thus recorded, and the process is repeated for other auxiliary memory unit cells for which the corresponding sets of cells in the main memory unit were also written to with valid data.

It should be appreciated that the control logic circuitry 1970 can combine the cells in the auxiliary memory unit 1904 with the cells 1520 in the main memory unit 1512 in any desired way. For example, a masking operation may be performed so as to individually logically combine (e.g., in an AND operation, an OR operation, an XOR operation, etc.) the logic value of each of the cells in the auxiliary memory unit 1904 with the logic value of each of the cells 1520 in the associated set of cells in the main memory unit 1512, resulting in a new set of logic values. In such a way, the cells in the auxiliary memory unit 1904 can be used as a mask for sets of cells 1520 in the main memory unit 1512. Such a masking operation may be useful when transferring information to a virtual page buffer in a non-volatile memory device, so as to prevent unwanted writing of memory elements in the non-volatile memory device.

In accordance with another specific non-limiting embodiment, the auxiliary memory unit utilizes dual-port SRAM cells while the main memory unit utilizes single-port SRAM cells. With reference to Fig. 11, there is shown a dual-port SRAM cell, which bears some similarity to the single-port SRAM cell of Fig. 16 but includes two transistors in lieu of transistor 1630 in Fig. 16 and two other transistors in lieu of transistor 1635 in Fig. 16. Also, the dual-port SRAM cell includes two wordlines, namely an A-wordline WL1 and a B-wordline WL2. Further, the dual-port SRAM cell includes two pairs of bitlines, namely an A-pair of bitlines BL1 -, BL1 + and a B-pair of bitlines BL2-, BL2+.

The dual-port SRAM cell can be read from or written to by controlling the A-wordline WL1 and the A-pair of bitlines BL1-, BL1+, or by controlling the B-wordline WL2 and the B-pair of bitlines BL2-, BL2+. The A-wordline WL1 is set to high (i.e., "selected" or "asserted") for both read and write operations. For a read operation, both A-pair bitlines BL1+, BL1- are sensed after they have been precharged to a high level. A high value on one of the A-pair of bitlines BL1+, BL1- does not change the value in the cell, instead the cell will pull one of the A-pair of bitlines BL1+, BL1- low. Depending on which of the A-pair of bitlines BL1+, BL1- is pulled low, this will be interpreted as either a logic "0" or a logic "1". For a write operation, one of the A-pair of bitlines BL1+, BL1- is forced low, and the other is forced high. The low value overpowers the PMOS transistor connected to the bitline that was forced low, which results in the cell being written to. Depending on which of the A-pair of bitlines BL1+, BL1- was forced low, this will write either a logic "0" or a logic "1" to the cell.

Similarly, the B-wordline WL2 is set to high (i.e., "selected" or "asserted") for both read and write operations. For a read operation, both B-pair bitlines BL2+, BL2- are sensed after they have been precharged to a high level. A high value on one of the B-pair of bitlines BL2+, BL2- does not change the value in the cell, instead the cell will pull one of the B-pair of bitlines BL2+, BL2- low. Depending on which of the B-pair of bitlines BL2+, BL2- is pulled low, this will be interpreted as either a logic "0" or a logic "1". For a write operation, one of the B-pair of bitlines BL2+, BL2- is forced low, and the other is forced high. The low value overpowers the PMOS transistor connected to the bitline that was forced low, which results in the cell being written to. Depending on which of the B-pair of bitlines BL2+, BL2- was forced low, this will write either a logic "0" or a logic "1" to the cell.

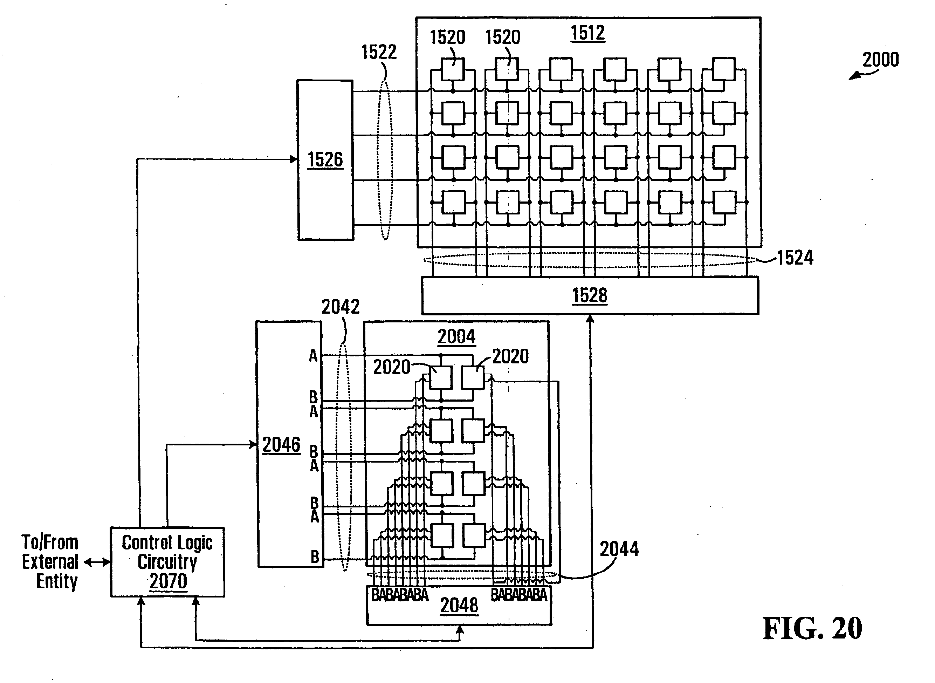

Turning now to Fig. 20, there is shown a semiconductor device 2000 with the aforementioned main memory unit 1512 and an auxiliary memory unit 2004 that uses dual-port SRAM cells. With reference to Fig. 21E, in accordance with specific non-limiting embodiments of the present invention, the semiconductor device 2000 can be embedded in a system 840. The system 840 may be, for example, an ASIC (application-specific integrated circuit) or a SoC (system on chip), to name a few non-limiting possibilities.

The main memory unit 1512 has four (4) rows of six (6) columns of cells, the auxiliary memory unit 2004 includes two four (4) rows of two (2) columns of cells and each cell in the auxiliary memory unit 2004 is associated with a set of three (3) cells in the main memory unit 1512. In other examples, one bit's worth of information in the auxiliary memory unit 2004 represents status information (such as, for example, validity, freshness, mask-worthiness, etc.) for one byte's worth of information in the main memory unit 1512. However, it is to be understood that there is no particular limitation on the number of rows or columns or on the number of main memory unit cells in a set that is associated with individual cells of the auxiliary memory unit 2004.

The semiconductor device 2000 further comprises the aforementioned plurality of wordlines 1522, each connected to a respective row of the cells of the main memory unit 1512. Row decoder circuitry 1526 is provided for control of the wordlines 1522. Specifically, when a particular main memory unit cell is to be read from or written to, the wordline connected to the row in which that particular main memory unit cell is located is selected by row decoder circuitry 1526. The identity of the row containing cells to be read from or written to is provided by control logic circuitry 2070.

The semiconductor device 2000 also comprises the aforementioned plurality of circuitry 1524 each connected to a respective column of the cells of the main memory unit 1512. It is remarked that when single-port cells of the type shown in Fig. 16 are used in the main memory unit 1512, two of the circuitry 1524 are connected to each column. Bitline control circuitry 1528 is provided for control of the circuitry 1524. Operation of bitline control circuitry 1528 differs depending on whether a read or write operation is being performed. For a write operation, bitline control circuitry 1528 is configured to drive the circuitry 1524 connected to a selected column of the main memory unit 1512 so that each cell in that column which is connected to a wordline that has been selected can be written to, i.e., set to a desired logic state (e.g., logic "0" or logic "1"). It should be appreciated that plural columns of the main memory unit 1512 may be selected either simultaneously or in sequence. The identity of the selected column or columns, as well as the value of the data to be written, is provided by the control logic circuitry 2070. A column or columns of the main memory unit 1512 are similarly identified by the control logic circuitry 2070 during a read operation.

The semiconductor device 2000 further comprises a plurality of wordlines 2042. It is remarked that when dual-port cells of the type shown in Fig. 11 are used in the auxiliary memory unit 2004, the wordlines 2042 are connected in pairs to respective rows of the cells of the auxiliary memory unit 2004. Thus, a first pair of wordlines 2042 is connected to a first row of cells of the auxiliary memory unit 2004, a second pair of wordlines 2042 is connected to a second row, and so on. Within each pair of wordlines, one can identify an A-wordline and a B-wordline. Row decoder circuitry 2046 is provided for control of the wordlines 2042, including the A-wordline and the B-wordline for each row. Specifically, when a particular auxiliary memory unit cell is to be read from or written to, the A-wordline or the B-wordline for the row in which that particular auxiliary memory unit cell is located is selected by row decoder circuitry 2046. Row decoder circuitry 2046 is operable to select one A-wordline and one B-wordline, which may, but need not, both be in the same row. Thus, the row decoder circuitry 2046 can effectively select two different rows, which allows cells on two separate rows to be read from or written to, or allows cells on one row to be read from while cells on another row are written to.

The semiconductor device 2000 further comprises a plurality of bitlines 2044 each connected to a respective column of the cells of the auxiliary memory unit 2004. It is remarked that when dual-port cells of the type shown in Fig. 11 are used in the auxiliary memory unit 2004, each of the auxiliary memory unit cells is connected to two pairs of the bitlines 2044, including an A-pair of bitlines and a B-pair of bitlines. Bitline control circuitry 2048 is provided for control of the bitlines 2044, including the A-pairs of bitlines and the B-pairs of bitlines. The A-pair of bitlines connected to a given cell is associated with the A-wordline for the row in which the given cell is located. Analogously, the B-pair of bitlines connected to a given cell is associated with the B-wordline for the row in which the given cell is located. Control by the bitline control circuitry 2048 of the A-pair of bitlines for a given cell while the A-wordline is selected allows reading or writing to the given cell. Analogously, control by the bitline control circuitry 2048 of the B-pair of bitlines for a given cell while the B-wordline is selected allows reading or writing to the given cell.

Thus, two rows can be selected, one via the A-wordline and one via the B-wordline, and the cells in those rows can be independently read from or written to using the A-pair of bitlines and the B-pair of bitlines, respectively. Specifically, given two selected cells in different rows, the first selected cell can be read from or written to without impacting the other cells in that same row and that happen to be in the same column as the second selected cell, which is in a different row. This allows the cells in different rows to be written to independently, e.g., the cells in one row can be written to from left to right, while at the same time the cells in the other row can be written to from right to left. While this example has assumed that only one cell in each row is to be written to simultaneously, it should be understood that control of the bitlines 2048 allows multiple cells in each row to be written to simultaneously. Thus, for example, groups of cells in one row can be written to from left to right, while at the same time groups of cells in another row can be written to from right to left.

The identity of the columns containing the cells to be written to, as well as the value of the actual data to be written, is provided to the bitline control circuitry 2048 by the control logic circuitry 2070. During a read operation involving one or more columns of the auxiliary memory unit 2004, these are similarly identified by the control logic circuitry 2070.

In operation, control logic circuitry 2070 processes commands received from an external entity, such as an off-chip controller (not shown). These commands can include a preset command, a write command and a read command, among others. In a non-limiting example, a preset command received from the external entity can indicate that the data in the main memory unit 1512 should be considered as being "stale", "mask-worthy" (i.e., requiring application of a mask), "not valid", etc.. Thereafter, a write command may be received from the external entity with the intention of writing data to a particular cell or group of cells in the main memory unit 1512, starting at a start address. In order to track the status (for example, valid or not valid, fresh or stale, mask-worthy or not mask-worthy, etc.) of the main memory unit cells, a set of one or more main memory unit cells is associated with a corresponding cell in the auxiliary memory unit 2004. The auxiliary memory unit cells can then each represent a single bit of information indicative of the particular status (e.g., valid or not valid, fresh or stale, mask-worthy or not mask-worthy, etc.) of a corresponding set of, say, three (3) main memory unit cells. Thus, it will be appreciated that at a given point in time, the external entity can establish the status of different cells in the main memory unit 1512 by reading from the auxiliary memory unit 2004. It is to be understood that the number of main memory unit 1512 cells in each set represented by a given one of the auxiliary memory unit cells is not limited to three (3) or any other specific value.

In response to receipt of the preset command, control logic circuitry 2070 performs a preset operation on the auxiliary memory unit 2004. The aim of the preset operation is to cause each of the cells in the auxiliary memory unit 2004 to acquire a particular logic state (e.g., logic "1") that is indicative of the corresponding set of cells in the main memory unit 1512 having a first particular status (for example, "not valid", "stale", "mask-worthy", etc.). To this end, the control logic circuitry 2070 identifies a first row and a second row of the auxiliary memory unit 2004 to row decoder circuitry 2046, thereby resulting in the selection of the first row's A-wordline and the second row's B-wordline. The control logic circuitry 2070 then controls bitline control circuitry 2048 so as to set the auxiliary memory unit cells connected to the selected A-wordline and the selected B-wordline to the particular logic state (in this case, logic "1"). Specifically, the bitline control circuitry 2048 controls the A-pairs of bitlines in order to write to the cells in the first row and also controls the B-pairs of bitlines in order to write to the cells in the second row. Once all the cells in the auxiliary memory unit 2004 have acquired the particular logic state (in this case, logic "1") indicative of the cells in the main memory unit 1512 having the first particular status (e.g., "not valid", "stale", "mask-worthy", etc.), the preset operation is said to be complete.

At this stage, the writing of input data to the main memory unit 1512 can proceed. To this end, the control logic circuitry 2070 processes a write command which can identify a start address in the main memory unit 1512 and can contain data to be written, starting at the start address. The start address is represented by a particular cell located at a particular row and a particular column in the main memory unit 1512, and is thus associated with a particular wordline and a particular pair of bitlines. The control logic circuitry 2070 identifies the particular row to row decoder circuitry 1526. The control logic circuitry 2070 then controls bitline control circuitry 1528 so that the particular pair of bitlines will set the particular main memory unit cell to a logic state that corresponds to the value of the input data being written to the start address. Additional control of the circuitry 1524 and the wordlines 1522 is carried out for other main memory unit cells being subsequently written to.

In order to record the change in status of these main memory unit cells, the control logic circuitry 2070 ensures that the contents of the auxiliary memory unit cells that correspond to the main memory unit cells that were written to are toggled to a logic state (e.g., logic "0") that is indicative of data having a second particular status (rather than the first particular status acquired previously). To this end, the control logic circuitry 2070 determines the specific row and the specific column of the auxiliary memory unit cell whose corresponding set of main memory unit cells includes the particular cell at the start address mentioned above. The control logic circuitry 2070 then identifies the specific row to row decoder circuitry 2046, resulting in selection of that row's A-wordline (or B-wordline). The control logic circuitry 2070 then controls bitline control circuitry 2048 so that the A-pair (or B-pair) of bitlines corresponding to the specific column will set to logic "0" the auxiliary memory unit cell whose corresponding set of main memory unit cells includes the particular cell at the start address. The change in status of this corresponding set of main memory unit cells is thus recorded, and the process is repeated for other auxiliary memory unit cells for which the corresponding sets of cells in the main memory unit were also written to.

It should be appreciated that the control logic circuitry 2070 can combine the cells in the auxiliary memory unit 2004 with the cells 1520 in the main memory unit 1512 in any desired way. For example, a masking operation may be performed so as to individually logically combine (e.g., in an AND operation, an OR operation, an XOR operation, etc.) the logic value of each of the cells in the auxiliary memory unit 2004 with the logic value of each of the cells 1520 in the associated set of cells in the main memory unit 1512, resulting in a new set of logic values. In such a way, the cells in the auxiliary memory unit 2004 can be used as a mask for sets of cells 1520 in the main memory unit 1512. Such a masking operation may be useful when transferring information to a virtual page buffer in a non-volatile memory device, so as to prevent unwanted writing of memory elements in the non-volatile memory device.

It should also be appreciated that in some embodiments, all or part of the main memory unit and/or the auxiliary memory unit in each embodiment can be manufactured based on a low-level hardware description obtained using a logic synthesis tool that is run on a computing device. The logic synthesis tool is configured to read source code containing a functional description of the main memory unit and/or the auxiliary memory unit (e.g., in a language such as HDL, VHDL, Verilog) and to output a definition of the physical implementation of a circuit suitable for implementing corresponding functionality.

In the examples described above, the device, elements and circuits are connected to each other as shown in the figures, for the sake of simplicity. In practical applications of the present invention, elements, circuits, etc. may be connected directly to each other. As well, elements, circuits etc. may be connected indirectly to each other through other elements, circuits, etc., necessary for operation of the devices or apparatus. Thus, in actual configuration, the devices, elements and circuits are directly or indirectly coupled with or connected to each other.

Certain adaptations and modifications of the described embodiments can be made. Therefore, the above discussed embodiments are to be considered illustrative and not restrictive.

## Claims

1. A semiconductor device (16) for transferring input data to a non-volatile memory device (14₁), the semiconductor device (16) comprising :
- a virtual page buffer (300) Including a plurality of data elements; and
- a mask buffer (310) including a plurality of data elements, each of the data elements of the mask buffer (310) corresponding to a respective one of the data elements of the virtual page buffer (300); **characterized by**:
- control logic circuitry (29) for (i) setting each of the data elements of the mask buffer (310) to a first logic state upon receipt of a trigger; (ii) causing input data to be written to selected ones of the data elements of the virtual page buffer (300); and (III) causing those data elements of the mask buffer (310) corresponding to the selected ones of the data elements of the virtual page buffer (300) to be set to a second logic state different from the first logic state;
- mask logic circuitry (340) configured to provide masked output data by combining, for each of the data elements of the virtual page buffer (300), data read therefrom together with the logic state of the corresponding one of the data elements of the mask buffer (310); and
- an output interface (30) configured to release the masked output data towards the non-volatile memory device (14₁).

2. The semiconductor device (16) defined in claim 1, further comprising power monitoring circuitry (212) configured to issue a signal when power is established or re-established to the semiconductor device (16), said signal resulting In said trigger.

3. The semiconductor device (16) defined in claim 1 or 2, wherein the output interface (30) is further configured to release the masked output data as part of a PAGE PROGRAM command released towards the non-volatile memory device (14₁).

4. The semiconductor device (16) defined in any one of claims 1 to 3, wherein a particular data element of the virtual page buffer (300) is addressable by a particular address, wherein the control logic circuitry (29) is capable of supplying an address signal encoding said particular address and a read signal, and wherein the virtual page buffer (300) is responsive to receipt of the address signal and the read signal to cause contents of the particular data element of the virtual page buffer (300) to be read and provided to the mask logic circuitry (340).

5. The semiconductor device (16) defined in any one of claims 1 to 4, wherein the selected ones of the data elements of the virtual page buffer (300) are addressable by particular addresses, wherein the control logic circuitry (29) is capable of supplying an address signal encoding said particular addresses and a write signal, wherein the virtual page buffer (300) is responsive to receipt of the address signal and the write signal to cause the input data to be written to the selected ones of the data elements of the virtual page buffer (300).

6. The semiconductor device (16) defined in any one of claims 1 to 5, wherein individual ones of the selected ones of the data elements of the virtual page buffer are (300) identifiable by respective addresses carried by a set of address lines.

7. The semiconductor device (16) defined in any one of claims 1 to 6, wherein the virtual page buffer (300) and the mask buffer (310) occupy respective portions of a common integrated memory structure.

8. The semiconductor device (16) defined in any one of claims 1 to 7, wherein the input data is received from a memory controller (12).

9. The semiconductor device (16) defined in any one of claims 1 to 8, wherein the data elements of the virtual page buffer (300) each include a first number of bits and wherein the data elements of the mask buffer (310) each include a second number of bits, wherein the first number of bits is the same as the second number of bits.

10. The semiconductor device (16) defined in any one of claims 1 to 9, wherein data read from each of the data elements of the virtual page buffer (300) is represented by a plurality of bits, wherein the mask logic circuitry (340) comprises a combiner for carrying out the combining, wherein the combiner includes a bank of two-input logic OR modules (402), each of the two-input logic OR modules (402) being supplied with (i) the logic state of the corresponding one of the data elements of the mask buffer (310) and (ii) a respective one of said bits.

11. A method for transferring input data to a non-volatile memory device (14₁), **characterized by**:
- maintaining a virtual page buffer (300) including a plurality of data elements,
- maintaining a mask buffer (310) including a plurality of data elements, each of the data elements of the mask buffer (310) corresponding to a respective one of the data elements of the virtual page buffer (300),
- setting each of the data elements of the mask buffer (310) to a first logic state upon receipt of a trigger;
- writing data to selected ones of the data elements of the virtual page buffer (300) and setting those data elements of the mask buffer (310) corresponding to the selected ones of the data elements of the virtual page buffer (300) to a second logic state different from the first logic state;
- providing masked output data by combining, for each of the data elements of the virtual page buffer (300), data read therefrom together with the logic state of the corresponding one of the data elements of the mask buffer (310); and
- releasing the masked output data towards the non-volatile memory device (14₁).

12. The method defined in claim 11, said method is implemented by a semiconductor device (16), the method further comprising providing the trigger when power Is established or re-established to the semiconductor device (16).

13. The method defined in claim 11 or 12, wherein said providing the trigger is performed in response to said releasing the masked output data towards the non-volatile memory device (14₁).

14. The method defined in any one of claims 11 to 13, wherein the data elements of the virtual page buffer (300) each include a first number of bits and wherein the data elements of the mask buffer (310) each include a second number of bits, wherein the first number of bits is the same as or different from the second number of bits.

15. A computer program comprising computer program instructions that, when processed, cause the method as claimed in any one of claims 11 to 14 to be performed.

## Patentansprüche

1. Halbleitergerät (16) für ein Übermitteln von Eingabedaten an ein nichtflüchtiges Speichergerät (14₁), wobei das Halbleitergerät (16) umfasst
einen Virtuelle-Seiten-Puffer (300) einschließlich einer Vielzahl von Datenelementen, und
einen Masken-Puffer (310) einschließlich einer Vielzahl von Datenelementen, wobei jedes der Datenelemente des Masken-Puffers (310) einem jeweiligen der Datenelemente des Virtuelle-Seiten-Puffers (300) entspricht,
**gekennzeichnet durch**
einen Steuerlogikschaltkreis (29), um (i) jedes der Datenelemente des Masken-Puffers (310) auf einen ersten logischen Zustand bei einem Empfang eines Auslösers einzustellen, (ii) zu verursachen, dass Eingabedaten in ausgewählte der Datenelemente des Virtuelle-Seiten-Puffers (300) geschrieben werden, und (iii) zu verursachen, dass diese Datenelemente des Masken-Puffers (310) entsprechend den ausgewählten der Datenelemente des Virtuelle-Seiten-Puffers (300) auf einen von dem ersten logischen Zustand verschiedenen zweiten logischen Zustand eingestellt werden,
einen Maskenlogikschaltkreis (340), der dazu eingerichtet ist, um maskierte Ausgabedaten bereitzustellen **durch** Kombinieren, für jedes der Datenelemente des Virtuelle-Seiten-Puffers (300), von daraus ausgelesenen Daten zusammen mit dem logischen Zustand des entsprechenden der Datenelemente des Masken-Puffers (310), und
eine Ausgabeschnittstelle (30), die dazu eingerichtet ist, um die maskierten Ausgabedaten in Richtung des nichtflüchtigen Speichergeräts (14₁) freizugeben.

2. Halbleitergerät (16) nach Anspruch 1, ferner mit einem Energieüberwachungsschaltkreis (212), der dazu eingerichtet ist, um ein Signal zu liefern, wenn Energie an das Halbleitergerät (16) angelegt oder wieder angelegt ist, wobei das Signal in dem Auslöser resultiert.

3. Halbleitergerät (16) nach Anspruch 1 oder 2, wobei die Ausgabeschnittstelle (30) ferner dazu eingerichtet ist, um die maskierten Ausgabedaten als Teil eines in Richtung des nichtflüchtigen Speichergeräts (14₁) freigegebenen PAGE-PROGRAM-Befehls freizugeben.

4. Halbleitergerät (16) nach einem der Ansprüche 1 bis 3, wobei ein bestimmtes Datenelement des Virtuelle-Seiten-Puffers (300) mittels einer bestimmten Adresse adressierbar ist, wobei der Steuerlogikschaltkreis (29) dazu in der Lage ist, ein Adresssignal, das die bestimmte Adresse codiert, und ein Lesesignal zuzuführen, und wobei der Virtuelle-Seiten-Puffer (300) auf einen Empfang des Adresssignals und Lesesignals reagiert, um zu verursachen, dass Inhalte des bestimmten Datenelements des Virtuelle-Seiten-Puffers (300) gelesen und dem Maskenlogikschaltkreis (340) bereitgestellt werden.

5. Halbleitergerät (16) nach einem der Ansprüche 1 bis 4, wobei die ausgewählten der Datenelemente des Virtuelle-Seiten-Puffers (300) mittels bestimmter Adressen adressierbar sind, wobei der Steuerlogikschaltkreis (29) in der Lage ist, ein Adresssignal, das die bestimmten Adressen codiert, und ein Schreibsignal zuzuführen, und wobei der Virtuelle-Seiten-Puffer (300) auf einen Empfang des Adresssignals und des Schreibsignals reagiert, um zu verursachen, dass die Eingabedaten in die ausgewählten der Datenelemente des Virtuelle-Seiten-Puffers (300) geschrieben werden.

6. Halbleitergerät (16) nach einem der Ansprüche 1 bis 5, wobei individuelle der ausgewählten der Datenelemente des Virtuelle-Seiten-Puffers (300) mittels jeweiliger durch einen Satz von Adressleitungen beförderter Adressen identifizierbar sind.

7. Halbleitergerät (16) nach einem der Ansprüche 1 bis 6, wobei der Virtuelle-Seiten-Puffer (300) und der Masken-Puffer (310) jeweilige Abschnitte einer gemeinsamen integrierten Speicherstruktur einnehmen.

8. Halbleitergerät (16) nach einem der Ansprüche 1 bis 7, wobei die Eingabedaten von einer Speichersteuereinrichtung (12) empfangen sind.

9. Halbleitergerät (16) nach einem der Ansprüche 1 bis 8, wobei die Datenelemente des Virtuelle-Seiten-Puffers (300) jeweils eine erste Anzahl von Bits enthalten und wobei die Datenelemente des Masken-Puffers (310) jeweils eine zweite Anzahl von Bits enthalten, wobei die erste Anzahl von Bits gleich der zweiten Anzahl von Bits ist.

10. Halbleitergerät (16) nach einem der Ansprüche 1 bis 9, wobei von jedem der Datenelemente des Virtuelle-Seiten-Puffers (300) gelesene Daten durch eine Vielzahl von Bits wiedergegeben sind, wobei der Maskenlogikschaltkreis (340) eine Kombiniereinrichtung zur Durchführung des Kombinierens aufweist, wobei die Kombiniereinrichtung eine Bank von logischen ODER-Modulen (402) mit zwei Eingängen umfasst, wobei jedes der logischen ODER-Module (402) mit zwei Eingängen mit (i) dem logischen Zustand des entsprechenden der Datenelemente des Masken-Puffers (310) und (ii) einem jeweiligen der Bits versorgt ist.

11. Verfahren für ein Übermitteln von Eingabedaten an ein nichtflüchtiges Speichergerät (14₁), **gekennzeichnet durch**
ein Unterhalten eines Virtuelle-Seiten-Puffers (300) einschließlich einer Vielzahl von Datenelementen,
ein Unterhalten eines Masken-Puffers (310) einschließlich einer Vielzahl von Datenelementen, wobei jedes der Datenelemente des Masken-Puffers (310) einem jeweiligen der Datenelemente des Virtuelle-Seiten-Puffers (300) entspricht,
ein Einstellen jedes der Datenelemente des Masken-Puffers (310) auf einen ersten logischen Zustand bei einem Empfang eines Auslösers,
ein Schreiben von Daten in ausgewählte der Datenelemente des Virtuelle-Seiten-Puffers (300) und ein Einstellen dieser Datenelemente des Masken-Puffers (310) entsprechend den ausgewählten der Datenelemente des Virtuelle-Seiten-Puffers (300) auf einen von dem ersten logischen Zustand verschiedenen zweiten logischen Zustand,
ein Bereitstellen von maskierten Ausgabedaten **durch** Kombinieren, für jedes der Datenelemente des Virtuelle-Seiten-Puffers (300), von daraus ausgelesenen Daten zusammen mit dem logischen Zustand des entsprechenden der Datenelemente des Masken-Puffers (310), und
ein Freigeben der maskierten Ausgabedaten in Richtung des nichtflüchtigen Speichergeräts (14₁).

12. Verfahren nach Anspruch 11, wobei das Verfahren mittels eines Halbleitergeräts (16) implementiert ist, wobei das Verfahren ferner ein Bereitstellen des Auslösers umfasst, wenn Energie an das Halbleitergerät (16) angelegt oder wieder angelegt wird.

13. Verfahren nach Anspruch 11 oder 12, wobei das Bereitstellen des Auslösers als Reaktion auf das Freigeben der maskierten Ausgabedaten in Richtung des nichtflüchtigen Speichergeräts (14₁) durchgeführt wird.

14. Verfahren nach einem der Ansprüche 11 bis 13, wobei die Datenelemente des Virtuelle-Seiten-Puffers (300) jeweils eine erste Anzahl von Bits enthalten und wobei die Datenelemente des Masken-Puffers (310) jeweils eine zweite Anzahl von Bits enthalten, wobei die erste Anzahl von Bits gleich oder verschieden von der zweiten Anzahl von Bits ist.

15. Computerprogramm mit Computerprogrammanweisungen, die, wenn sie verarbeitet werden, verursachen, dass das Verfahren nach einem der Ansprüche 11 bis 14 durchgeführt wird.

## Revendications

1. Dispositif à semi-conducteur (16) permettant de transférer des données d'entrée vers un dispositif de mémoire non volatile (14₁), le dispositif à semi-conducteur (16), comprenant :
- une mémoire tampon de page virtuelle (300) comprenant une pluralité d'éléments de données ; et
- une mémoire tampon de masque (310) comprenant une pluralité d'éléments de données, chacun des éléments de données de la mémoire tampon de masque (310) correspondant à l'un des éléments de données respectif de la mémoire tampon de page virtuelle (300) ; **caractérisé par** :
- un circuit logique de commande (29) pour (i) mettre chacun des éléments de données de la mémoire tampon de masque (310) dans un premier état logique lors de la réception d'un déclenchement ; (ii) amener des données d'entrée à être écrites vers des éléments de données sélectionnés parmi les éléments de données de la mémoire tampon de page virtuelle (300) ; et (iii) amener ces éléments de données de la mémoire tampon de masque (310) correspondant aux éléments de données sélectionnés parmi les éléments de données de la mémoire tampon de page virtuelle (300) à être mis dans un second état logique différent du premier état logique;
- un circuit logique de masque (340) configuré pour fournir des données de sortie masquées en combinant, pour chacun des éléments de données de la mémoire tampon de page virtuelle (300), des données lues à partir de celle-ci avec l'état logique de l'élément de données correspondant parmi les éléments de données de la mémoire tampon de masque (310) ; et
- une interface de sortie (30) configurée pour délivrer les données de sortie masquées à destination du dispositif de mémoire non volatile (14₁).

2. Dispositif à semi-conducteur (16) selon la revendication 1, comprenant en outre un circuit de surveillance de puissance (212) configuré pour émettre un signal lorsque l'alimentation est établie ou rétablie vers le dispositif à semi-conducteur (16), ledit signal entrainant ledit déclenchement.

3. Dispositif à semi-conducteur (16) selon la revendication 1 ou 2, dans lequel l'interface de sortie (30) est en outre configurée pour délivrer les données de sortie masquées en tant que partie d'une commande PAGE PROGRAM délivrée à destination du dispositif de mémoire non volatile (14₁).

4. Dispositif à semi-conducteur (16) selon l'une quelconque des revendications 1 à 3, dans lequel un élément de données particulier de la mémoire tampon de page virtuelle (300) est adressable au moyen d'une adresse particulière, dans lequel le circuit logique de commande (29) est capable de fournir un signal d'adresse codant ladite adresse particulière et un signal de lecture, et dans lequel la mémoire tampon de page virtuelle (300) est sensible à la réception du signal d'adresse et du signal de lecture pour amener les contenus de l'élément de données particulier de la mémoire tampon de page virtuelle (300) à être lus et fournis au circuit de logique de masque (340).

5. Dispositif à semi-conducteur (16) selon l'une quelconque des revendications 1 à 4, dans lequel les éléments de données sélectionnés parmi les éléments de données de la mémoire tampon de page virtuelle (300) sont adressables au moyen d'adresses particulières, dans lequel le circuit logique de commande (29) est capable de fournir un signal d'adresse codant lesdites adresses particulières et un signal d'écriture, dans lequel la mémoire tampon de page virtuelle (300) est sensible à la réception du signal d'adresse et du signal d'écriture pour amener les données d'entrée à être écrites dans les éléments de données sélectionnés parmi les éléments de données de la mémoire tampon de page virtuelle (300).

6. Dispositif à semi-conducteur (16) selon l'une quelconque des revendications 1 à 5, dans lequel des éléments de données individuels parmi les éléments de données sélectionnés parmi les éléments de données de la mémoire tampon de page virtuelle (300) sont identifiables par des adresses respectives portées par un ensemble de lignes d'adresse.

7. Dispositif à semi-conducteur (16) selon l'une quelconque des revendications 1 à 6, dans lequel la mémoire tampon de page virtuelle (300) et la mémoire tampon de masque (310) occupent des parties respectives d'une structure de mémoire intégrée commune.

8. Dispositif à semi-conducteur (16) selon l'une quelconque des revendications 1 à 7, dans lequel les données d'entrée sont reçues d'un contrôleur de mémoire (12).

9. Dispositif à semi-conducteur (16) selon l'une quelconque des revendications 1 à 8, dans lequel les éléments de données de la mémoire tampon de page virtuelle (300) comprennent chacun un premier nombre de bits et dans lequel les éléments de données de la mémoire tampon de masque (310) incluent chacun un second nombre de bits, dans lequel le premier nombre de bits est le même que le second nombre de bits.

10. Dispositif à semi-conducteur (16) selon l'une quelconque des revendications 1 à 9, dans lequel les données lues à partir de chacun des éléments de données de la mémoire tampon de page virtuelle (300) sont représentées par une pluralité de bits, dans lequel le circuit de logique de masque (340) comprend un dispositif de combinaison pour effectuer la combinaison, dans lequel le dispositif de combinaison comprend une banque de modules logiques OR à deux entrées (402), chacun des modules logiques OR à deux entrées (402) étant alimenté avec (i) l'état logique de l'élément de données correspondant parmi les éléments de données de la mémoire tampon de masque (310) et (ii) un bit respectif parmi lesdits bits.

11. Procédé permettant de transférer des données d'entrée vers un dispositif de mémoire non volatile (14₁), **caractérisé par** les étapes consistant à :
- maintenir une mémoire tampon de page virtuelle (300) comprenant une pluralité d'éléments de données ;
- maintenir une mémoire tampon de masque (310) comprenant une pluralité d'éléments de données, chacun des éléments de données de la mémoire tampon de masque (310) correspondant à un élément de données respectif parmi les éléments de données de la mémoire tampon de page virtuelle (300) ;
- mettre chacun des éléments de données de la mémoire tampon de masque (310) dans un premier état logique lors de la réception d'un déclenchement ;
- écrire des données vers des éléments de données sélectionnés parmi les éléments de données de la mémoire tampon de page virtuelle (300) et mettre ces éléments de données de la mémoire tampon de masque (310) correspondant aux éléments de données sélectionnés parmi les éléments de données de la mémoire tampon de page virtuelle (300) dans un second état logique différent du premier état logique ;
- fournir des données de sortie masquées en combinant, pour chacun des éléments de données de la mémoire tampon de page virtuelle (300), des données lues à partir de celle-ci avec l'état logique d'un élément de données correspondant parmi les éléments de données de la mémoire tampon de masque (310) ; et
- délivrer les données de sortie masquées à destination du dispositif de mémoire non volatile (14₁)

12. Procédé selon la revendication 11, ledit procédé étant mis en oeuvre par un dispositif à semi-conducteur (16), le procédé comprenant en outre l'étape consistant à fournir le déclenchement lorsque l'alimentation est établie ou rétablie vers le dispositif à semi-conducteur (16).

13. Procédé selon la revendication 11 ou 12, dans lequel ladite fourniture du déclenchement est effectuée en réponse à ladite délivrance des données de sortie masquées à destination du dispositif de mémoire non volatile (14₁).

14. Procédé selon l'une quelconque des revendications 11 à 13, dans lequel les éléments de données de la mémoire tampon de page virtuelle (300) comprennent chacun un premier nombre de bits et dans lequel les éléments de données de la mémoire tampon de masque (310) comprennent chacun un second nombre de bits, dans lequel le premier nombre de bits est le même que ou est différent du second nombre de bits.

15. Programme informatique comprenant des instructions de programme informatique qui, lorsque elles sont traitées, provoquent la mise en oeuvre du procédé tel que revendiqué dans l'une quelconque des revendications 11 à 14.
